# EUROPEAN PATENT APPLICATION

(11) **EP 4 243 589 A1**
(43) Date of publication of application: **13.09.2023**
(21) Application number: 23160736.7
(22) Date of filing: 08.03.2023
(51) Int. Cl.: H10K 50/11

(54) **ORGANIC ELECTROLUMINESCENT MATERIALS AND DEVICES**

(30) Priority: 09.03.2022 US 202263318269 P; 01.04.2022 US 202263326548 P; 11.04.2022 US 202263329688 P; 12.04.2022 US 202263329924 P; 16.05.2022 US 202263342198 P; 07.07.2022 US 202263367818 P; 04.08.2022 US 202263395173 P; 24.08.2022 US 202263400416 P; 29.08.2022 US 202263401800 P; 02.03.2023 US 202318177174
(71) Applicant: Universal Display Corporation, Ewing, NJ 08618 (US)
(72) Inventor: JRADI, Fadi M., Ewing, NJ, 08618 (US); THOMPSON, Nicholas J., Ewing, NJ, 08618 (US); FLEETHAM, Tyler, Ewing, NJ, 08618 (US)
(74) Representative: Maiwald GmbH

(57) **Abstract**

Provided are OLEDs whose EML has a figure of merit (FOM) value of equal to or larger than 2.50 that have enhanced efficiency and lifetimes. FOM can be determined according to the methods disclosed herein.

## Description

### CROSS-REFERENCE TO RELATED APPLICATIONS

This application claims priority under 35 U.S.C. § 119(e) to United States Provisional Application Nos. 63/326,548, filed on April 1, 2022; 63/318,269, filed on March 9, 2022; 63/400,416, filed on August 24, 2022; 63/329,688, filed on April 11, 2022; 63/395,173, filed on August 4, 2022; 63/329,924, filed on April 12, 2022; 63/401,800, filed on August 29, 2022, 63/342,198, filed May 16, 2022; and 63/367,818, filed July 7, 2022, the entire contents of all the above applications are incorporated herein by reference.

### FIELD

The present disclosure generally relates to organic light emitting devices with novel features and their uses in electronic devices including consumer products.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

### SUMMARY

In one aspect, the present disclosure provides an OLED comprising: an anode; a cathode; and an organic layer disposed between the anode and the cathode, where the organic layer comprises an emissive layer (EML) that has a figure of merit (FOM) value of equal to or larger than 2.50.

In another aspect, the present disclosure provides an OLED comprising: an anode; a cathode; and an organic layer disposed between the anode and the cathode, wherein the organic layer comprises an EML that includes an Emissive System, wherein the EML has a FOM value of equal to or larger than 2.50; wherein the EML has a minimum thickness of 350 Å; wherein the organic layer further comprises a first host; wherein the first host is a boron-containing compound. In yet another aspect, the first host is an electron transporting host comprising an electron transporting moiety, the second host is a hole transporting host comprising a hole transporting moiety; wherein the hole transporting moiety of the second host is selected from the group as defined herein; wherein the electron transporting moiety of the first host is selected from the group as defined herein.

In yet another aspect, the present disclosure provides a consumer product comprising an OLED as defined herein.

### BRIEF DESCRIPTION OF THE DRAWINGS

FIG. 1 shows an organic light emitting device.
FIG. 2 shows an inverted organic light emitting device that does not have a separate electron transport layer.
FIG. 3 is a 1931 CIE coordinate color space diagram.

### DETAILED DESCRIPTION

Unless otherwise specified, the below terms used herein are defined as follows:
As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical (C(O)-Rₛ).

The term "ester" refers to a substituted oxycarbonyl (-O-C(O)-Rₛ or -C(O)-O-Rₛ) radical.

The term "ether" refers to an -ORₛ radical.

The terms "sulfanyl" or "thio-ether" are used interchangeably and refer to a -SRₛ radical.

The term "selenyl" refers to a -SeRₛ radical.

The term "sulfinyl" refers to a -S(O)-Rₛ radical.

The term "sulfonyl" refers to a -SO₂-Rₛ radical.

The term "phosphino" refers to a -P(Rₛ)₃ radical, wherein each Rₛ can be same or different.

The term "silyl" refers to a -Si(Rₛ)₃ radical, wherein each Rₛ can be same or different.

The term "germyl" refers to a -Ge(Rₛ)₃ radical, wherein each Rₛ can be same or different.

The term "boryl" refers to a -B(Rₛ)₂ radical or its Lewis adduct -B(Rₛ)₃ radical, wherein Rₛ can be same or different.

In each of the above, Rₛ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. Preferred Rₛ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group may be optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more General Substituents.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, aryl, heteroaryl, sulfanyl, and combinations thereof.

In yet other instances, the Most Preferred General Substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

### A. The OLED Devices of the Present Disclosure

Disclosed are OLEDs according to the present disclosure whose EMLs have a figure of merit (FOM) value that exceeds a defined threshold which results in the OLEDs having enhanced stability (i.e. enhanced lifetime) while maintaining low operating voltage. Also disclosed are electronic apparatuses that include one or more such OLEDs.

The FOM value of an EML is utilized to fabricate OLEDs that have low operating voltage but have a thick EML (i.e., at least 350 Å thick). What is conventionally known is that the stability (i.e. the lifetime) of OLEDs can be increased by increasing the EML thickness. However, increasing the EML thickness has a negative impact on the power consumption of the OLEDs because as the EML thickness increases, the operating voltage of the device rises which, in turn, increases the power consumption of the OLED. Until now, the increase in the operating voltage of the device observed per incremental improvement in the device stability obtained per incremental increase in the EML thickness was too high to be beneficial.

Disclosed herein are novel material combinations in the EML that provide unexpectedly substantial amount of enhancement in OLED device stability per volt of increase in the operating voltage per incremental increase in the EML thickness. For the purposes of this disclosure, the material combination that make up a given EML, i.e., the emitter material and its associated host material(s), if any, will be collectively referred to as the "Emissive System." Using the novel Emissive System, the amount of enhancement achieved in the OLED device lifetime per volt incremental increase in the operating voltage resulting from the incremental increase in the thickness of the EML is substantially more than what was conventionally observed, and thus can provide OLED designers an attractive option to choose enhanced device lifetime while minimizing the increase in the power consumption, Improving the stability of OLED increase their lifetime, which can be measured as LT90. LT90 is a measure that represents an OLED's lifetime and refers to the length of time required for an OLED's luminescence to decay to 90% of the initial value at a given current density.

In one aspect, the present disclosure provides an inventive OLED comprising: an anode; a cathode; and an organic layer disposed between the anode and the cathode, where the organic layer comprises an EML; where the EML includes an Emissive System and the EML is characterized by a FOM value equal to or larger than 2.50.

### Determining FOM Value

In this disclosure, FOM value is used as a metric to define the desired composition of an EML in an OLED. For the purposes of this disclosure, the materials that make up a given EML, i.e., the emitter material and its associated host material(s), if any, will be collectively referred to as the "Emissive System." To determine the FOM value of a given EML that comprises a given Emissive System, two test OLEDs are fabricated (in a thin film form factor) whose EMLs have the same Emissive System but have two different thicknesses. Preferably, the difference between the thicknesses of the two test OLEDs is somewhere in the range of 50Å to 300Å. The thickness of each of the two test OLEDs can be any thickness that is practical to fabricate and conduct the test described herein to determine the FOM. The two test OLEDs will be referred to as "a first test OLED" and "a second test OLED."

FOM value is defined as FOM = **(t2/t1**)/(**V2-V1**). **t1** is the LT90 device lifetime measured at 20 mA/cm² for the first test OLED whose EML is formed of the given Emissive System and its EML has a thickness of 350 Å. **t2** is the LT90 device lifetime measured at 20 mA/cm² for the second test OLED whose EML is formed of the same given Emissive System but its EML has a thickness of 450 Å. **V1** is the device operating voltage value of the first test OLED measured at a current density of 10 mA/cm². **V2** is the device operating voltage value of the second test OLED measured at a current density of 10 mA/cm².

The device operating voltage (a.k.a. driving voltage) value for a given OLED is measured across the OLED's anode and cathode while the OLED is activated with a current and is emitting light.

Thus, FOM value represents a property of a given EML (having a particular Emissive System) that is measured by fabricating two test OLEDs using the given Emissive System. It should be understood that the **t1** and **t2** measurements are performed under exactly the same conditions for the two test OLEDs with the only difference being the thickness of the EMLs. Likewise, **V1** and **V2** measurements are performed under exactly the same conditions for the two test OLEDs with the only difference being the thickness of the EMLs. In other words, the first and the second test OLEDs have the same configuration except for the thickness of their EMLs. It should also be understood that all the components and their ratios are the same in the EMLs of the two test OLEDs.

In some embodiments, the Emissive System in the EML of the inventive OLED can have an FOM value that is equal to or larger than 2.55. In some embodiments, the Emissive System in the EML can have an FOM value that is equal to or larger than 2.60. In some embodiments, the Emissive System in the EML can have an FOM value that is equal to or larger than 2.65. In some embodiments, the Emissive System in the EML can have an FOM value that is equal to or larger than 2.70. In some embodiments, the Emissive System in the EML can have an FOM value that is equal to or larger than 2.75. In some embodiments, the Emissive System in the EML can have an FOM value that is equal to or larger than 2.80. In some embodiments, the Emissive System in the EML can have an FOM value that is equal to or larger than 2.85. In some embodiments, the Emissive System in the EML can have an FOM value that is equal to or larger than 2.90. In some embodiments, the Emissive System in the EML can have an FOM value that is equal to or larger than 2.95. In some embodiments, the Emissive System in the EML can have an FOM value that is equal to or larger than 3.00. In some embodiments, the Emissive System in the EML can have an FOM value that is equal to or larger than 15.00. In some embodiments, the Emissive System in the EML can have an FOM value that is up to 20.00.

In some embodiments, the Emissive System in the EML of the inventive OLED comprises at least one hole transporting host. In some embodiments, the Emissive System in the EML of the inventive OLED comprises at least one electron transporting host. In some embodiments, the Emissive System in the EML of the inventive OLED comprises at least one hole transporting host and at least one electron transporting host. In some embodiments of the inventive OLED, the Emissive System in the EML of the inventive OLED comprises a first host material, a second host material and an emitting material.

In some embodiments, the first host material comprises an electron transport moiety and a |LUMO energy| < 2.8 eV. In some embodiments, the first host material comprises an electron transport moiety and a |LUMO energy| < 2.7 eV. In some embodiments, the first host material comprises an electron transport moiety and a |LUMO energy| < 2.6 eV. In some embodiments, the first host material comprises an electron transport moiety and a |LUMO energy| < 2.4 eV.

In some embodiments, the second host material comprises a hole transport moiety and |HOMO energy| > 5.8 eV. In some embodiments, the second host material comprises a hole transport moiety and |HOMO energy| > 5.7 eV. In some embodiments, the second host material comprises a hole transport moiety and |HOMO energy| > 5.6 eV. In some embodiments, the second host material comprises a hole transport moiety and |HOMO energy| > 5.5 eV. In some embodiments, the second host material comprises a hole transport moiety and |HOMO energy| > 5.4 eV. In some embodiments, the second host material comprises a hole transport moiety and |HOMO energy| > 5.3 eV.

In some embodiments, the lowest triplet energy among all host materials in the EML of the inventive OLED is ≥ 2.75 eV. In some embodiments, the lowest triplet energy among all host materials in the EML of the inventive OLED is ≥ 2.50 eV. In some embodiments, the lowest triplet energy among all host materials in the EML of the inventive OLED is ≥ 2.10 eV.

It should be understood that the HOMO energy is estimated from the first oxidation potential derived from cyclic voltammetry. The LUMO energy is estimated from the first reduction potential derived from cyclic voltammetry. The triplet energy T₁ of the emitter compounds is measured using the peak wavelength from the photoluminescence at 77 °K. Solution cyclic voltammetry and differential pulsed voltammetry were performed using a CH Instruments model 6201B potentiostat using anhydrous dimethylformamide solvent and tetrabutylammonium hexafluorophosphate as the supporting electrolyte. Glassy carbon, and platinum and silver wires were used as the working, counter and reference electrodes, respectively. Electrochemical potentials were referenced to an internal ferrocene-ferroconium redox couple (Fc+/Fc) by measuring the peak potential differences from differential pulsed voltammetry. The E_{HOMO} = -[(Eₒₓ₁ vs Fc+/Fc) + 4.8], and the E_{LUMO} = -[(E_{red1} vs Fc+/Fc) + 4.8], wherein Eₒₓ₁ is the first oxidation potential and the E_{red1} is the first reduction potential.

In some embodiments, the hole transporting moiety of the second host material is selected from the group consisting of: 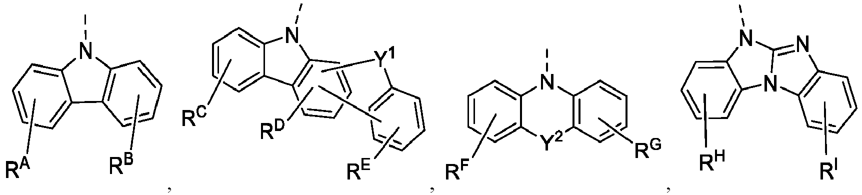 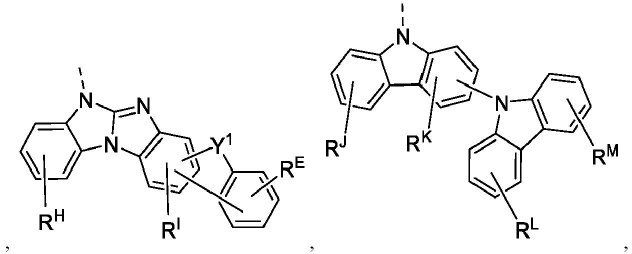 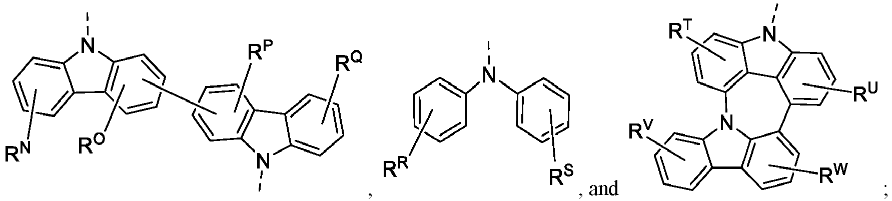 wherein:
each of Y¹ and Y² is independently selected from the group consisting of BR, BRR', NR, PR, P(O)R, O, S, Se, C=O, C=S, C=Se, C=NR, C=CRR', S=O, SO₂, CRR', SiRR', and GeRR';
each of R^{A} to R^{W} is independently monosubstituted to the maximum allowable substitution, or no substitution;
each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
two adjacent of R, R', or R^{A} to R^{W} are optionally joined or fused to form a ring.

In some embodiments, the electron transporting moiety of the first host is selected from the group consisting of: 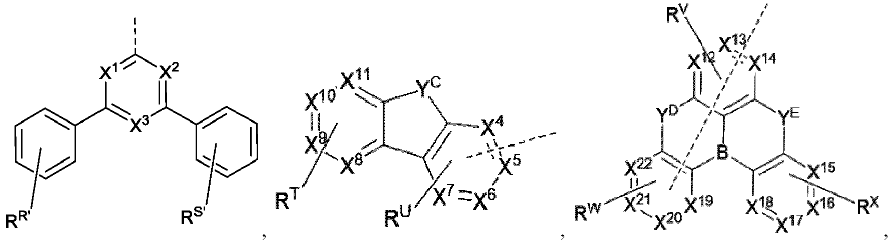 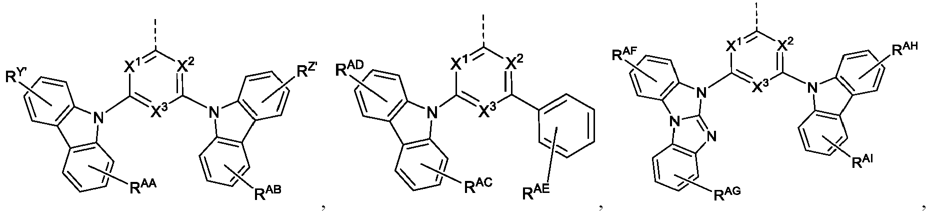 and 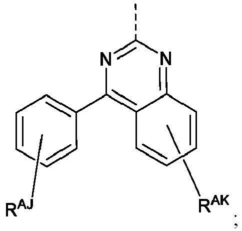 wherein:
each of X¹ to X²² is independently C or N;
at least one of X¹ to X³ is N;
at least one of X⁴ to X¹¹ is N;

each of Y^{C}, Y^{D}, and Y^{E} is independently selected from the group consisting of BR, BRR', NR, PR, P(O)R, O, S, Se, C=O, C=S, C=Se, C=NR, C=CRR', S=O, SO₂, CRR', SiRR', and GeRR';
each of R^{R'} to R^{Z'} and R^{AA} to R^{AK} is independently monosubstituted to the maximum allowable substitution, or no substitution;
each R, R', R^{R'} to R^{Z'}, and R^{AA} to R^{AK} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
two adjacent of R, R', R^{R'} to R^{Z'}, or R^{AA} to R^{AK} are optionally joined or fused to form a ring.

In some embodiments of the inventive OLED, the EML comprises an emitting material can be a phosphorescent or fluorescent emitter. Phosphorescence generally refers to emission of a photon with a change in electron spin, i.e., the initial and final states of the emission have different multiplicity, such as from T₁ to S₀ state. Ir and Pt complexes currently widely used in the OLED belong to phosphorescent emitters. In some embodiments, if an exciplex formation involves a triplet emitter, such exciplex can also emit phosphorescent light. On the other hand, fluorescent emitters generally refer to emission of a photon without a change in electron spin, such as from S₁ to S₀ state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap (ΔE_{S-T}) less than or equal to 300, 250, 200, 150, 100, or 50 meV. There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic ring. Donor-acceptor exciplex can be formed between a hole transporting compound and an electron transporting compound. The examples for MR-TADF include a highly conjugated boron-containing compounds. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments of the inventive OLED, the EML comprises an emitting material being capable of emitting light from a triplet excited state to a ground singlet state at room temperature. In some embodiments, the EML comprises an emitting material being a metal coordination complex having a metal-carbon bond. In some embodiments, the EML comprises an emitting material being a metal coordination complex having a metal-nitrogen bond. In some embodiments, the metal is selected from the group consisting of Ir, Rh, Re, Ru, Os, Pt, Au, and Cu. In some embodiments, the metal is Ir. In some embodiments, the metal is Pt.

In some embodiments, the EML of the inventive OLED has a FOM value equal to or larger than 2.50 and the EML can comprise an emitting material that has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of: 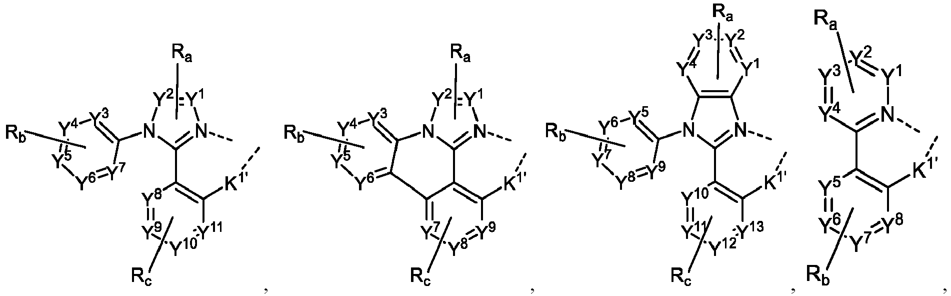 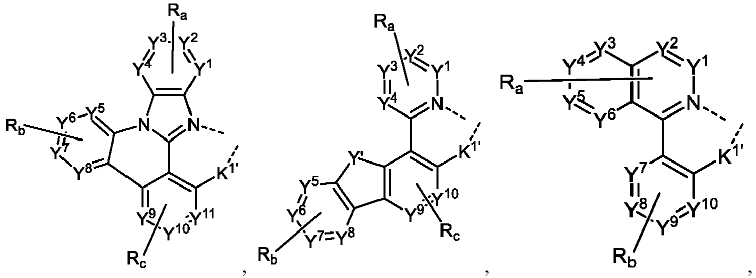 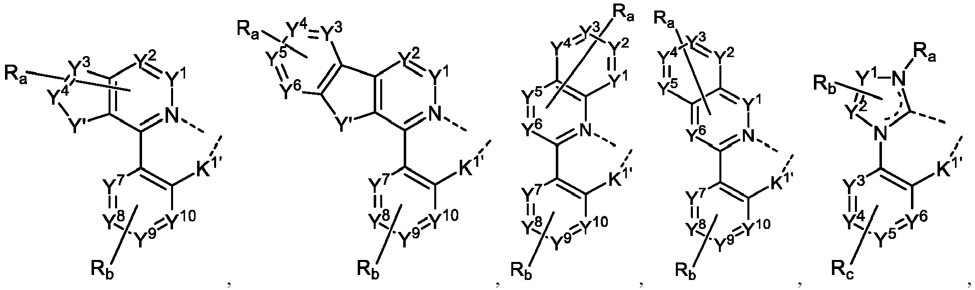 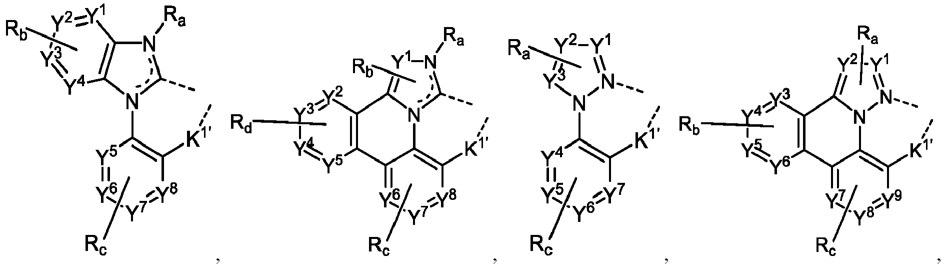 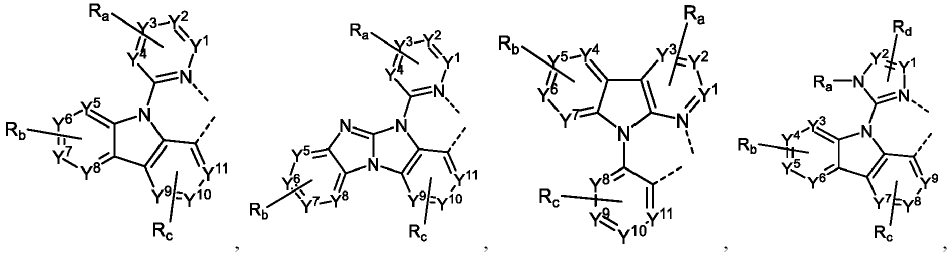 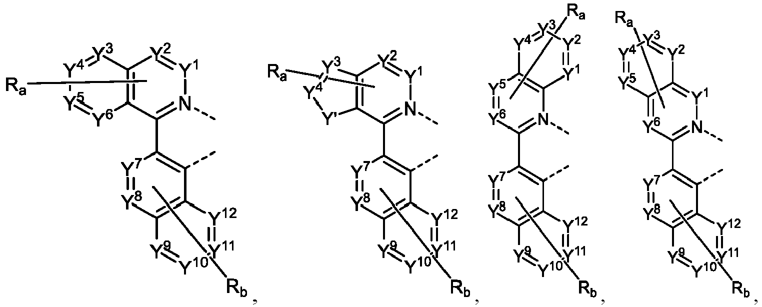 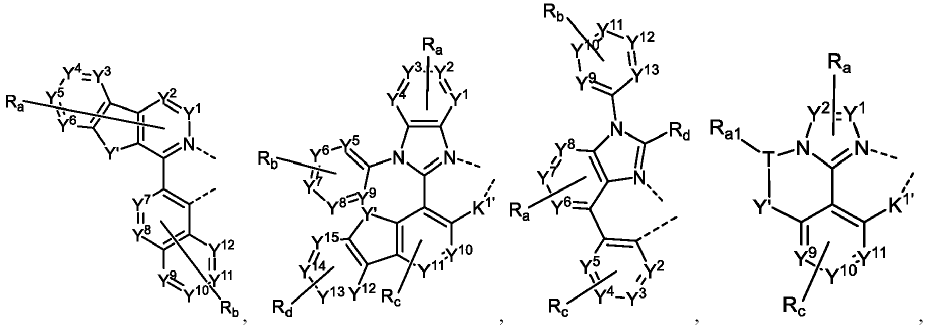 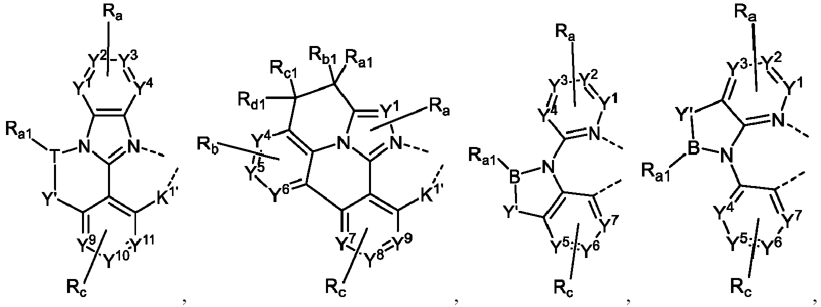 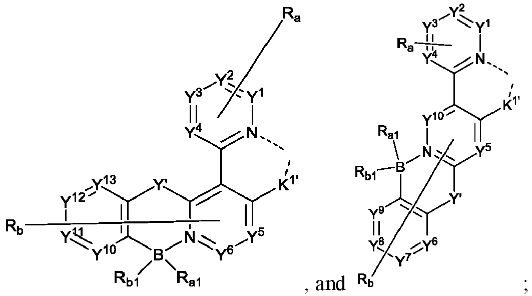
wherein L² and L³ are independently selected from the group consisting of 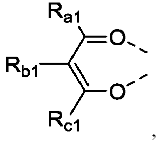 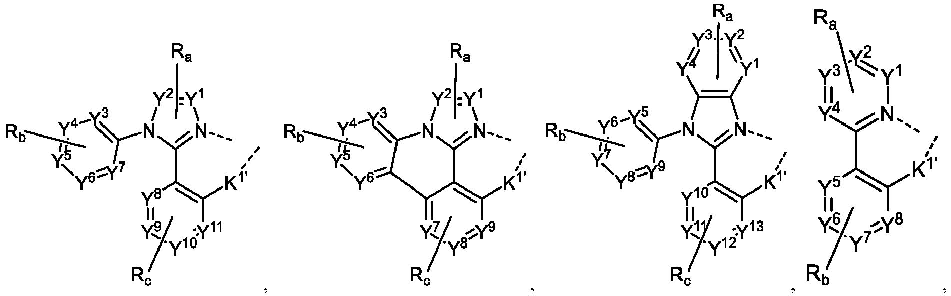 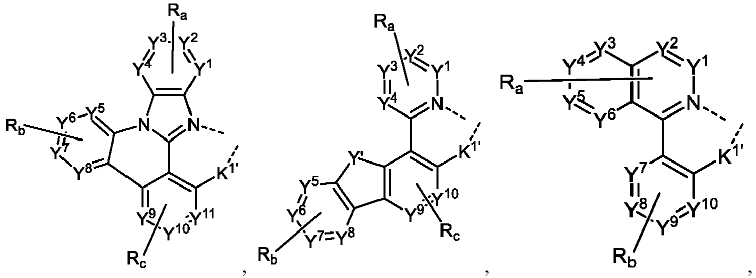 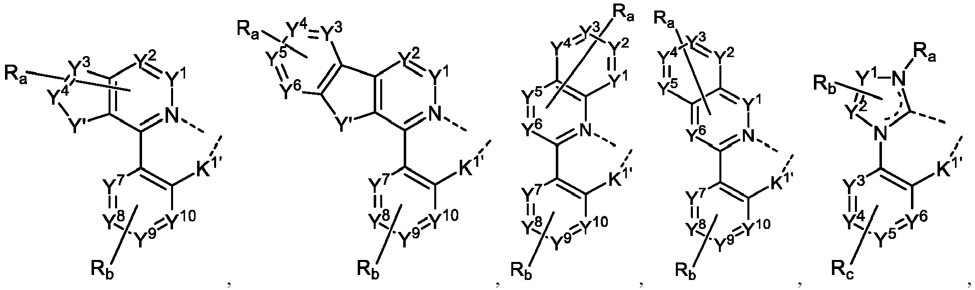 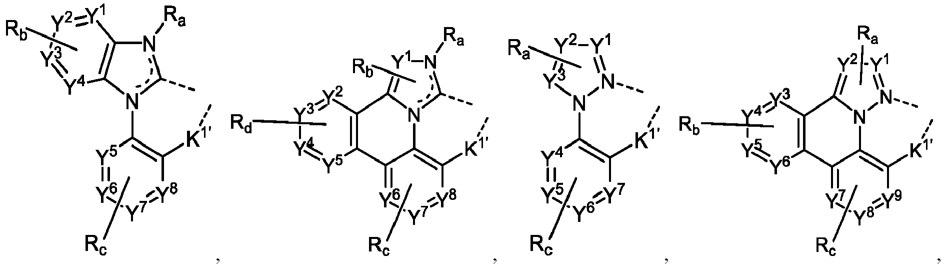 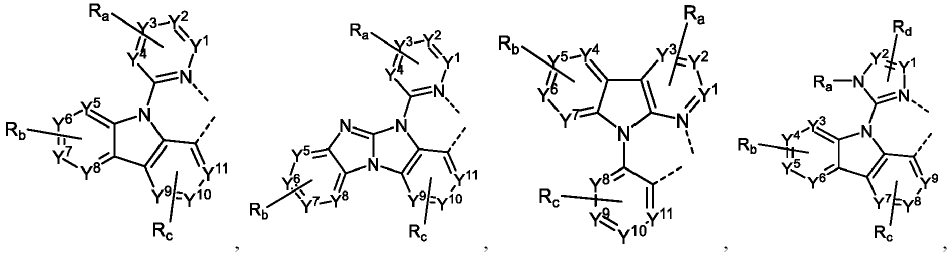 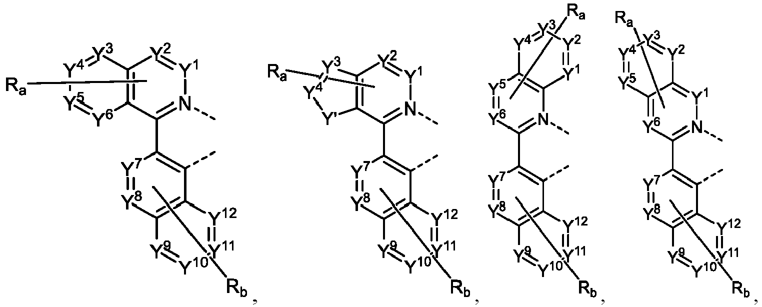 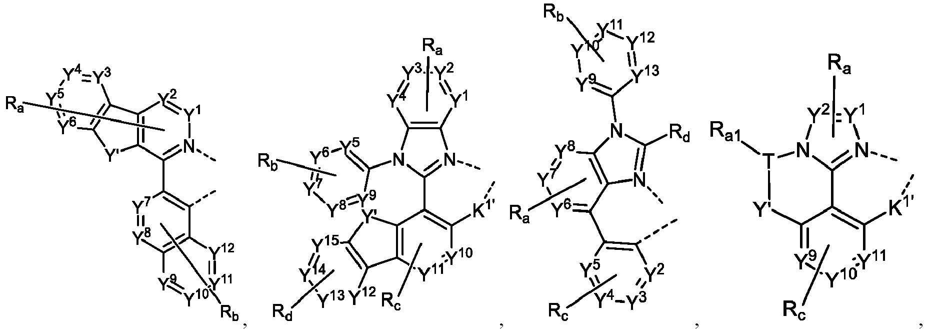 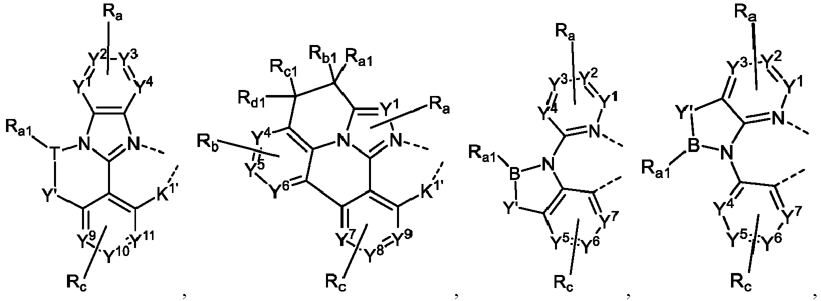 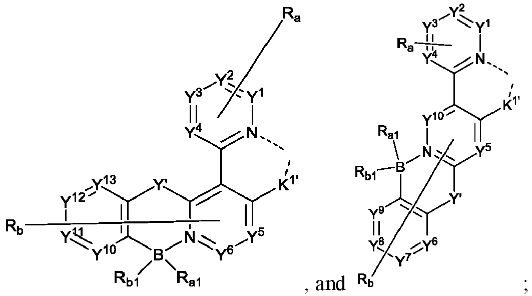 wherein:
   T is selected from the group consisting of B, Al, Ga, and In;
   K^{1'} is a direct bond or is selected from the group consisting of NRₑ, PRₑ, O, S, and Se;
   each Y¹ to Y¹³ are independently selected from the group consisting of carbon and nitrogen;
   Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
   Rₑ and R_{f} can be fused or joined to form a ring;
   each Rₐ, R_{b}, R_{c}, and R_{d} can independently represent from mono to the maximum possible number of substitutions, or no substitution;
   each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and
   wherein any two Rₐ₁, R_{b1}, R_{c1}, R_{d1}, Rₐ, R_{b}, R_{c}, and R_{d} can be fused or joined to form a ring or form a multidentate ligand.

In some embodiments, the emitting material used in an EML having a FOM value equal to or larger than 2.50 can have a formula selected from the group consisting of Ir(L_{A})₃, Ir(L_{A})(L_{B})₂, Ir(L_{A})₂(L_{B}), Ir(L_{A})₂(L_{C}), Ir(L_{A})(L_{B})(L_{C}), and Pt(L_{A})(L_{B});
wherein L_{A}, L_{B}, and L_{C} are different from each other in the Ir compounds;
wherein L_{A} and L_{B} can be the same or different in the Pt compounds; and
wherein L_{A} and L_{B} can be connected to form a tetradentate ligand in the Pt compounds.

In some embodiments, the emitting material used in an EML having a FOM value equal to or larger than 2.50 can have a formula selected from the group consisting of the structures in the following LIST 1: 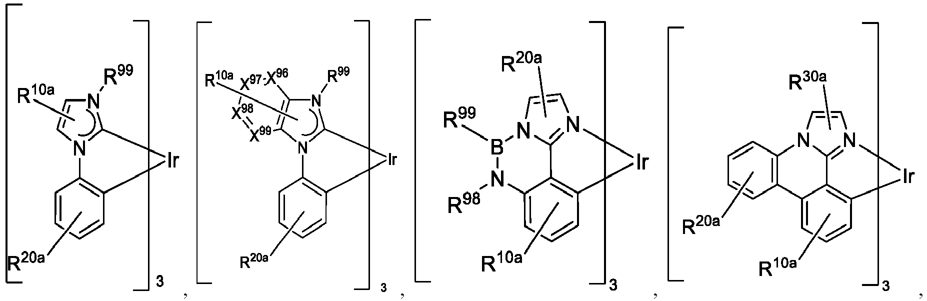 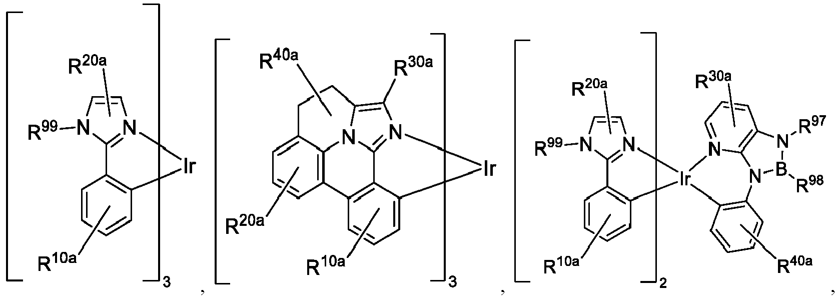 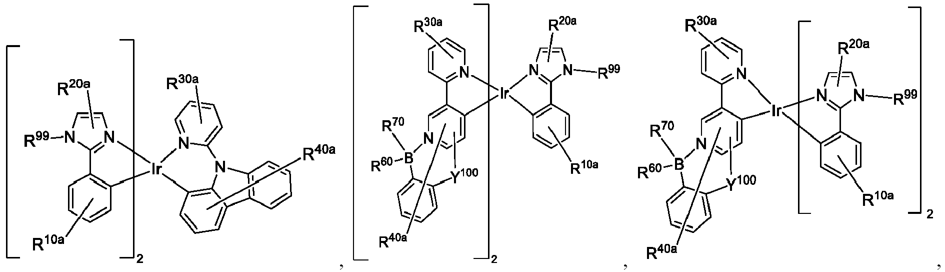 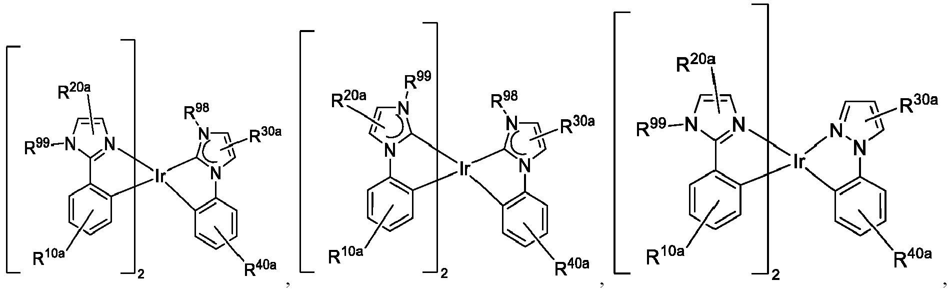 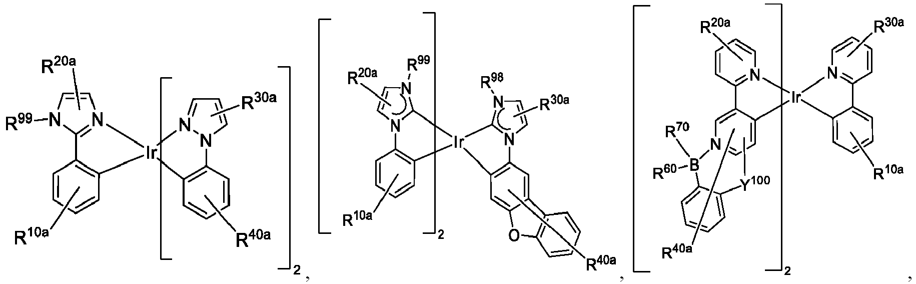 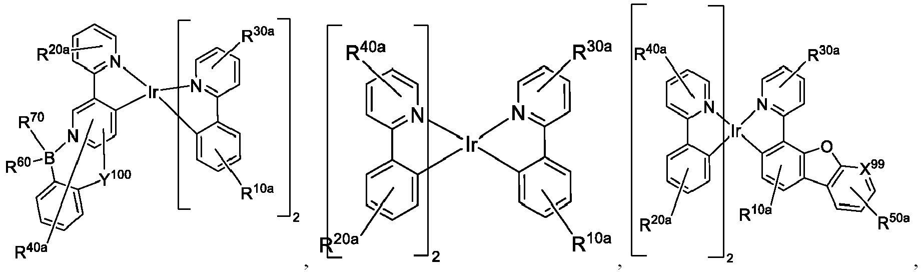 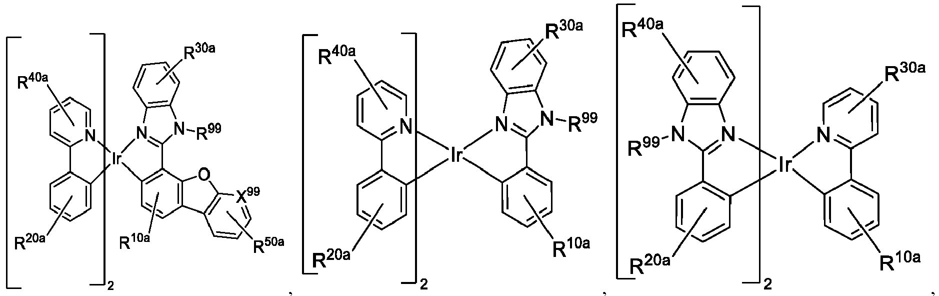 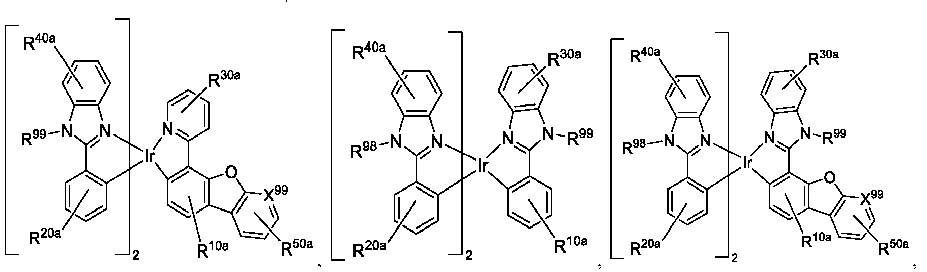 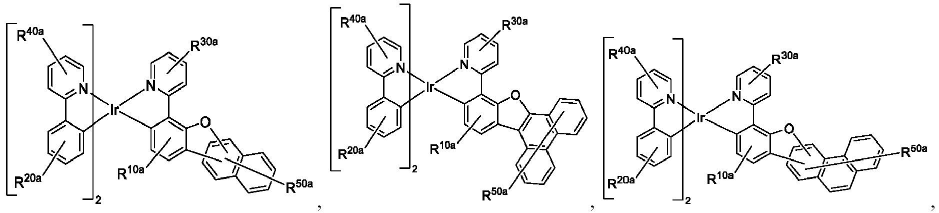 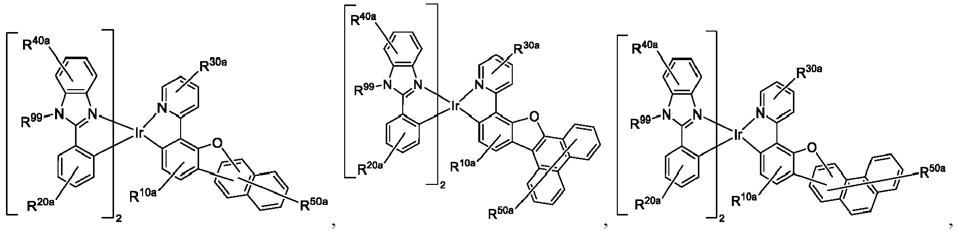 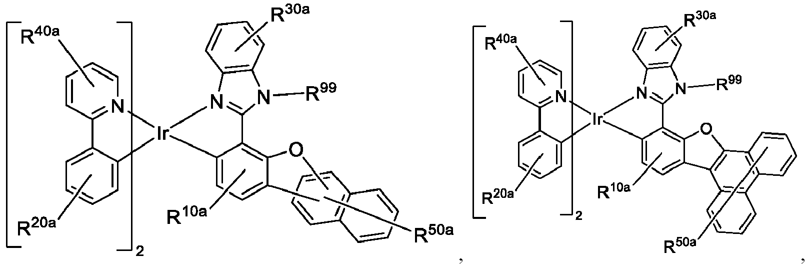 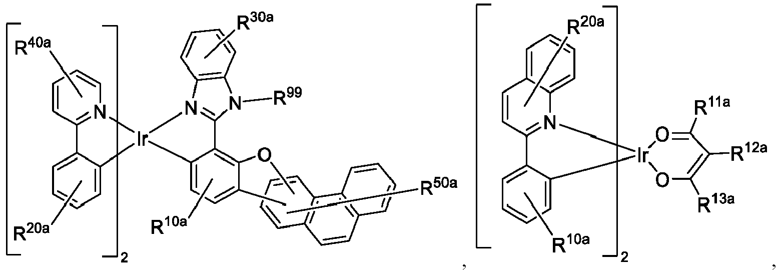 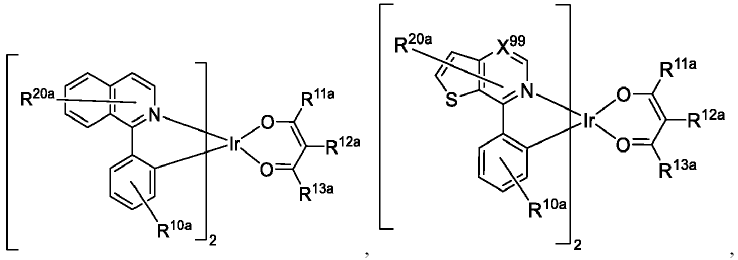 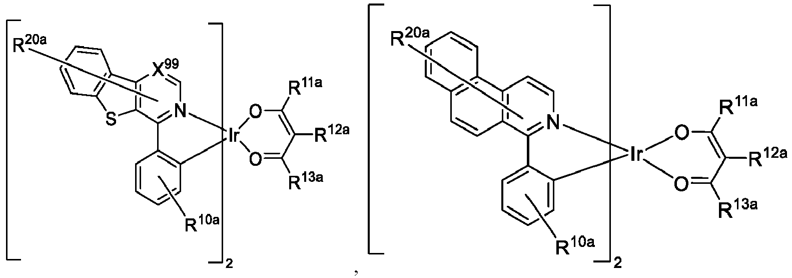 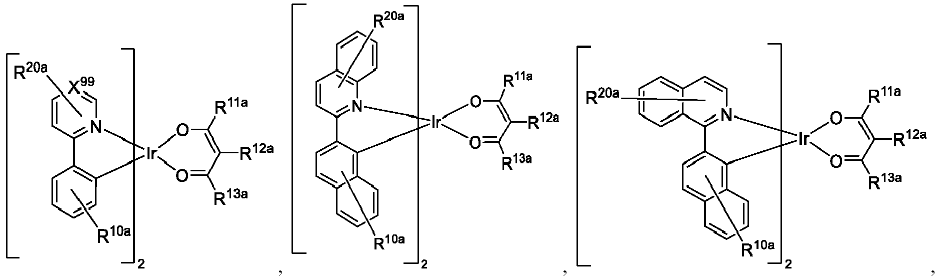 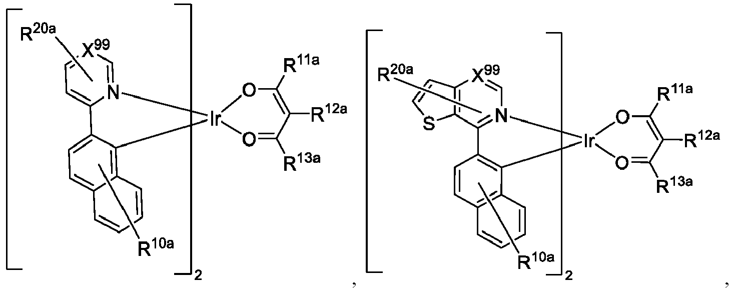 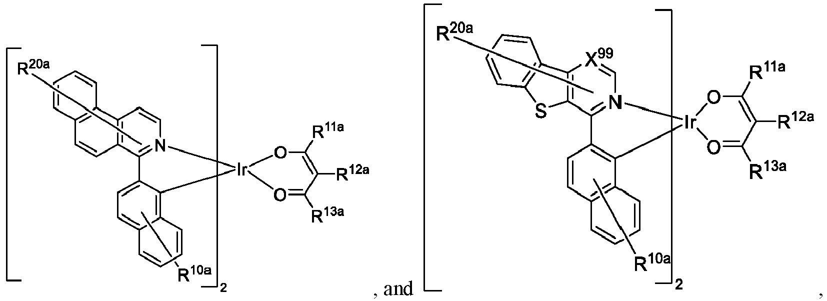 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof.

In some embodiments, the emitting material used in the EML having a FOM value equal to or larger than 2.50 can have a formula selected from the group consisting of the structures in the following LIST 2: 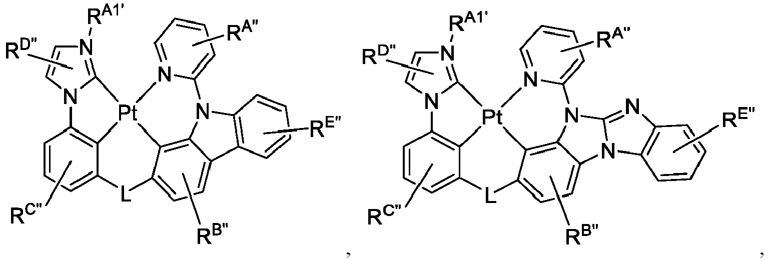 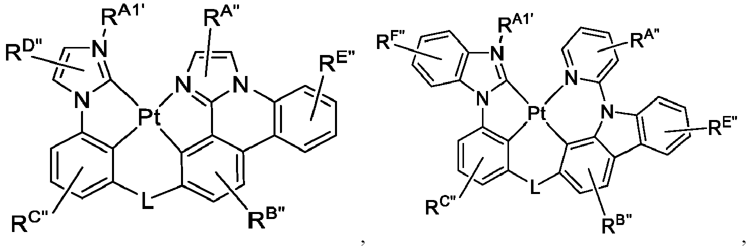 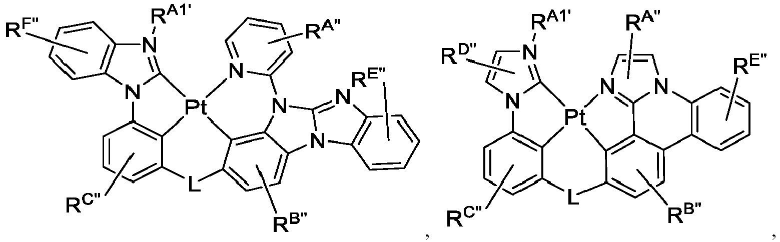 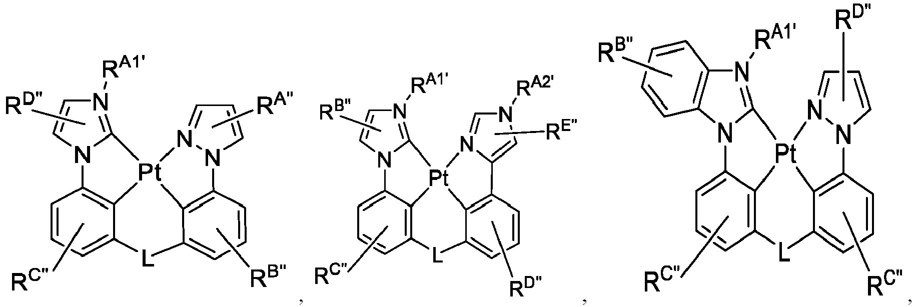 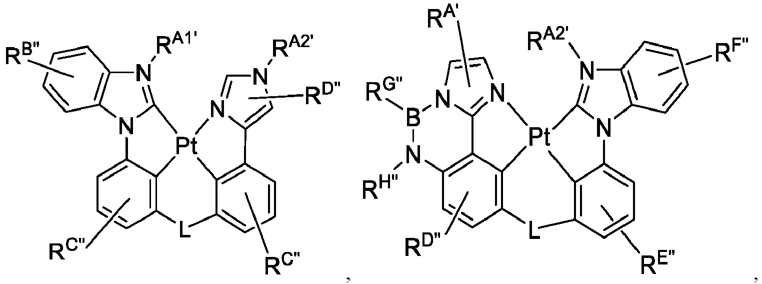 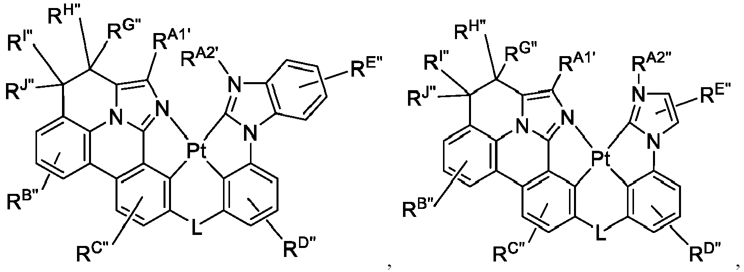 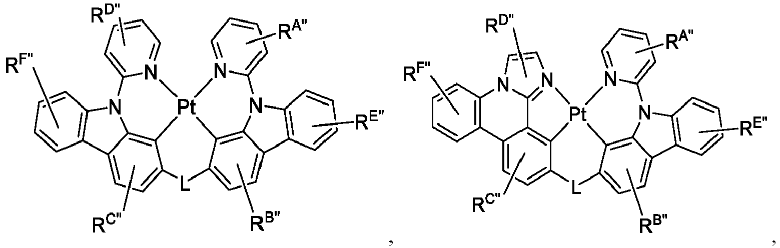 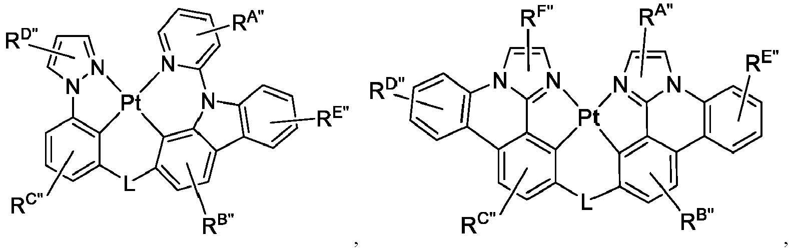 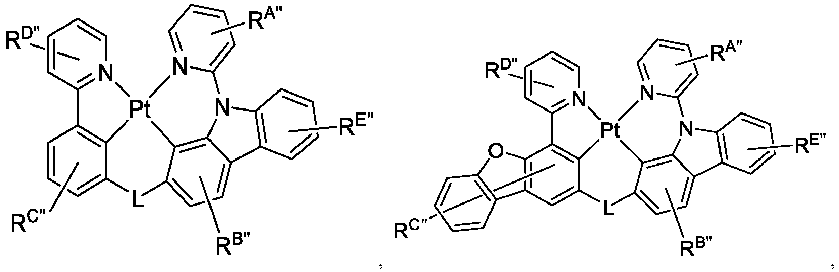 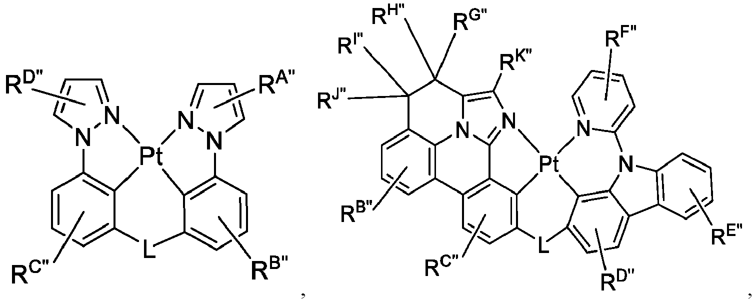 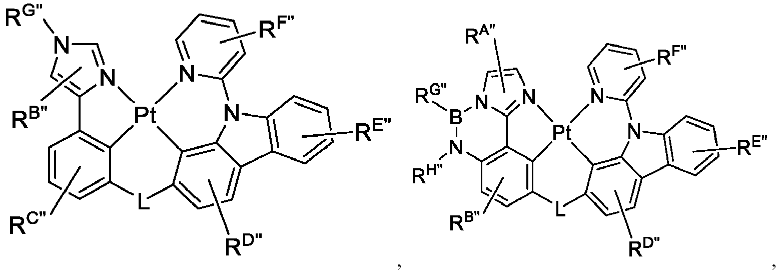 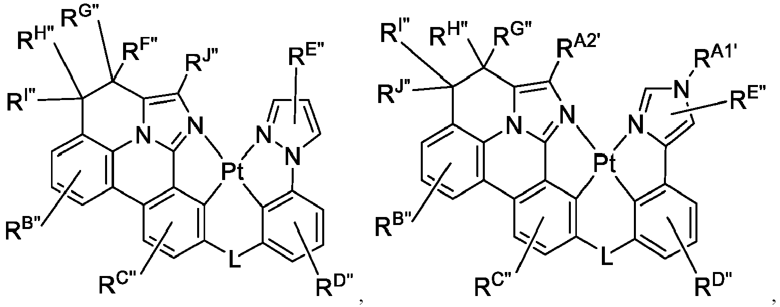 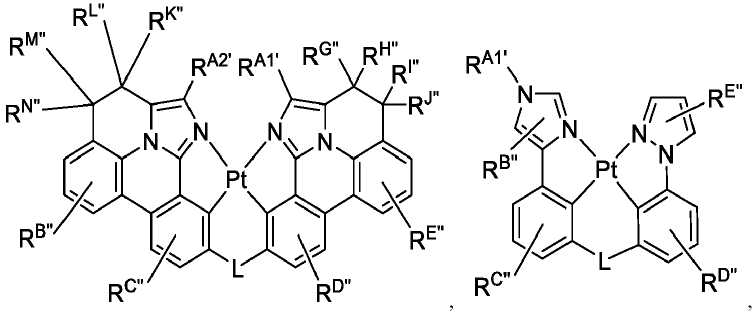 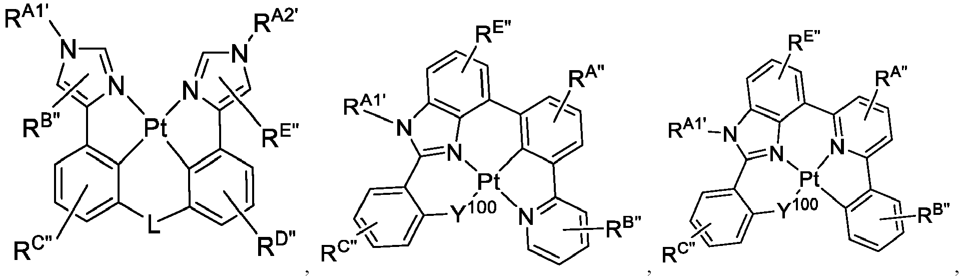 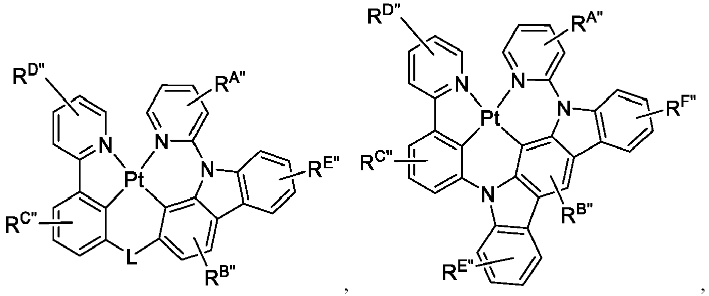 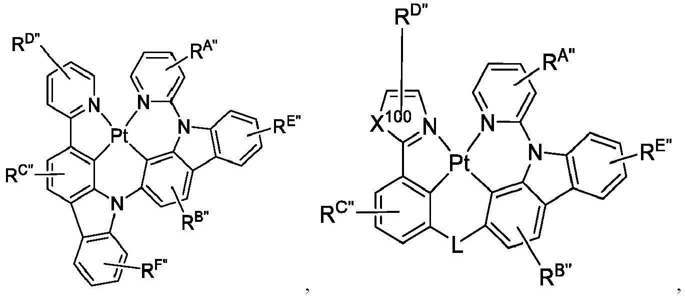 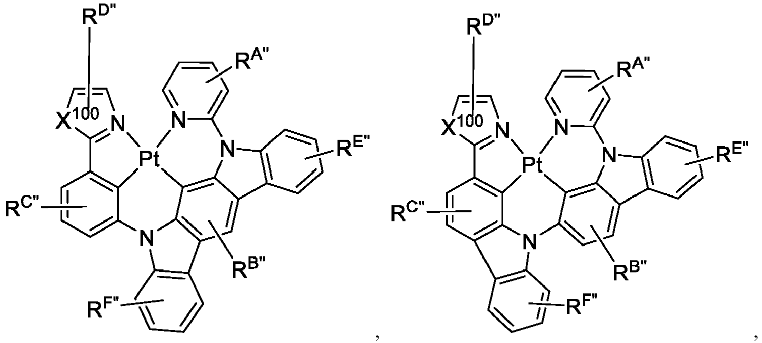 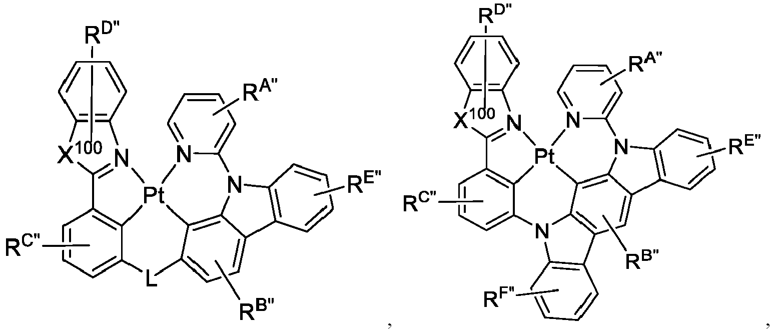 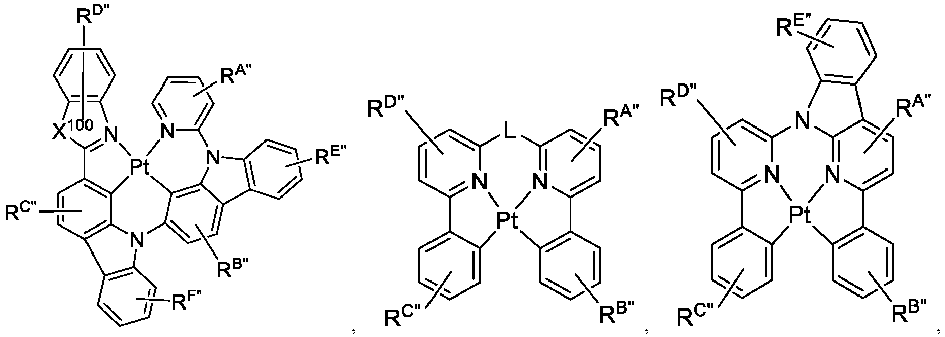 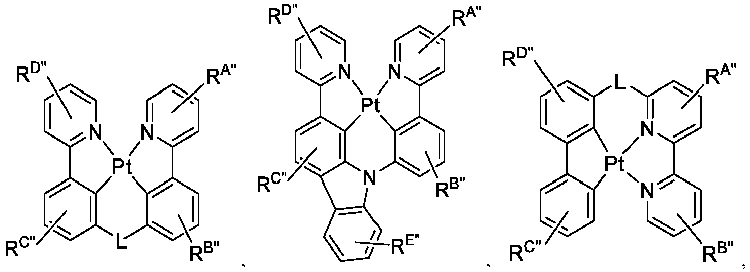 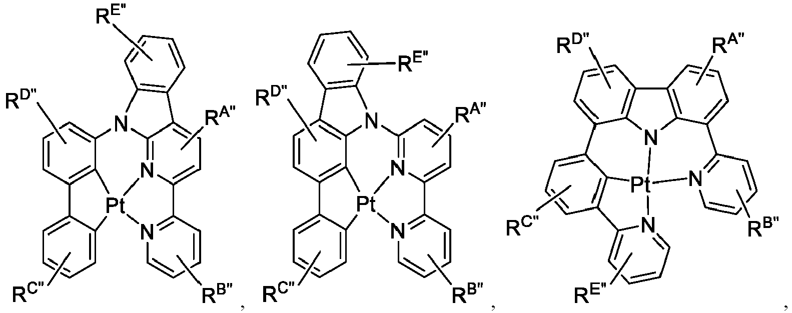 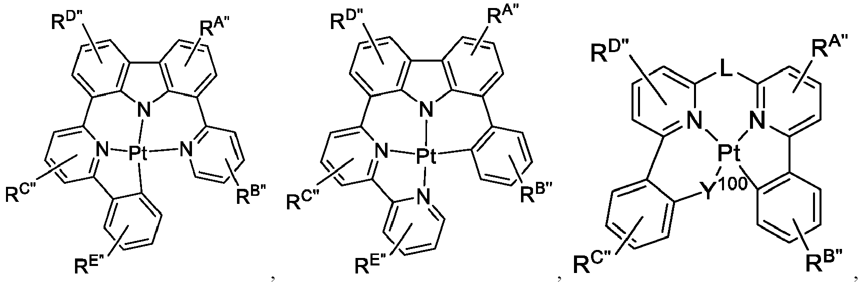 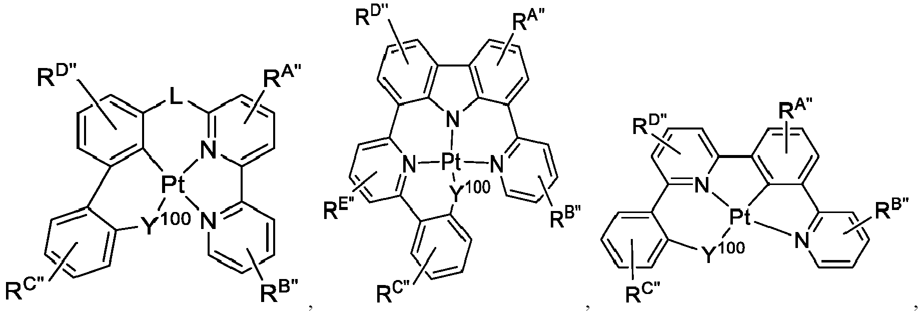 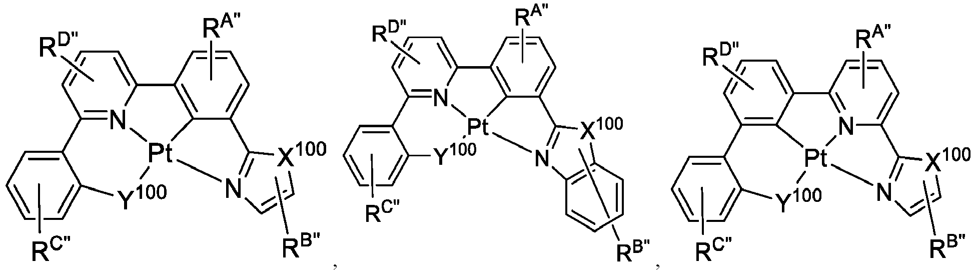 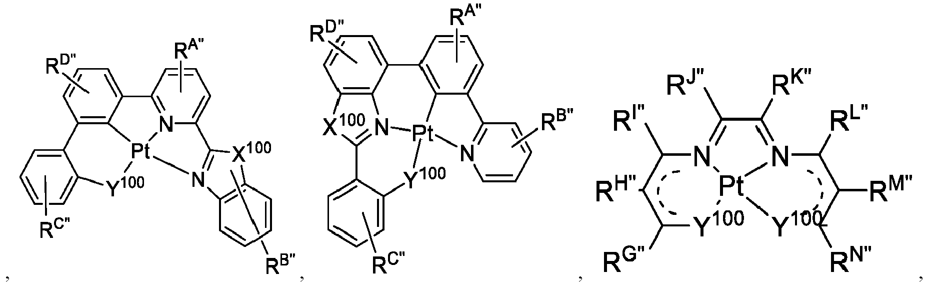 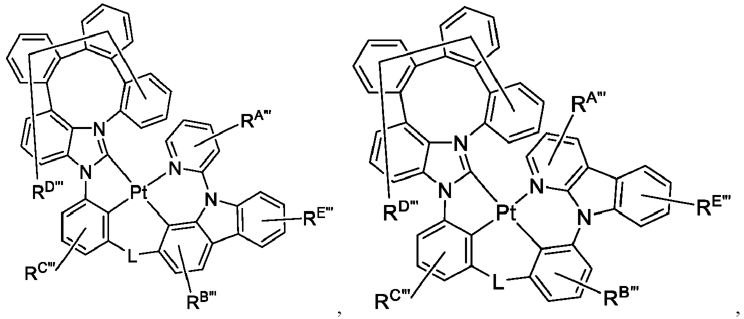 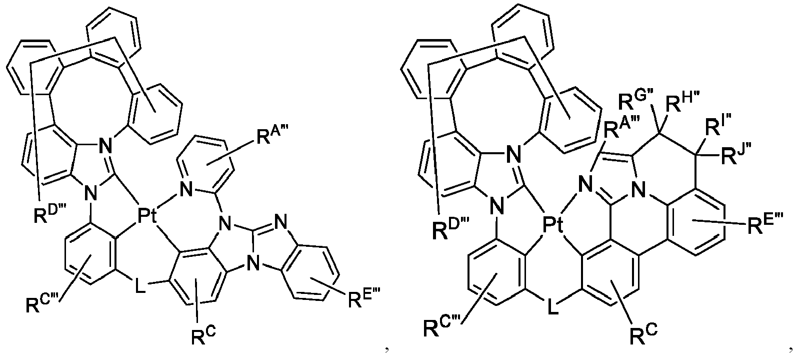 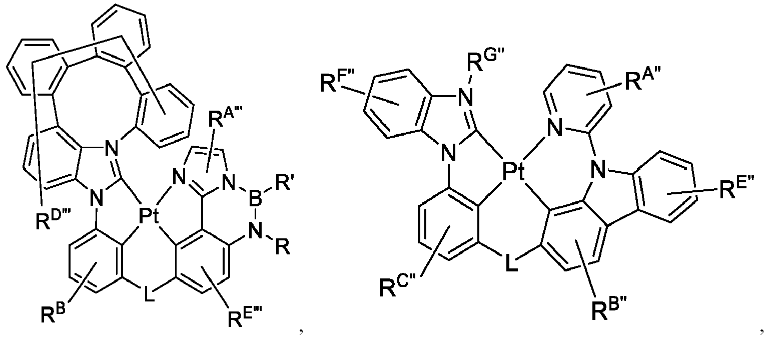 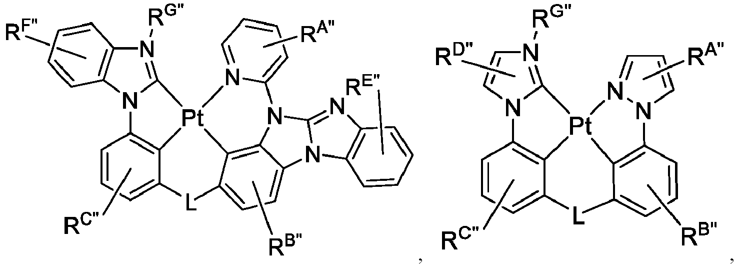 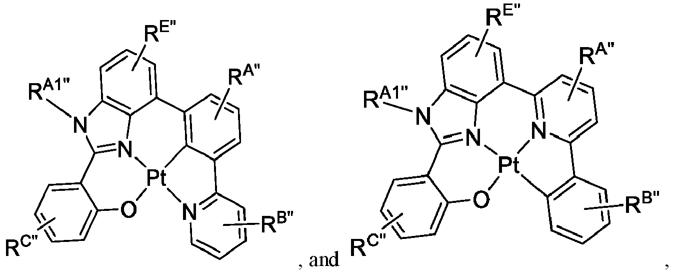 wherein:
each Y¹⁰⁰ is independently selected from the group consisting of a NR", O, S, and Se;
L is independently selected from the group consisting of a direct bond, BR", BR"R‴, NR", PR", P(O)R", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰ for each occurrence is selected from the group consisting of O, S, Se, NR", and CR"R‴;
each R^{A"}, R^{B"}, R^{C"}, R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.

In some embodiments, the emitting material used in an EML having a FOM value equal to or larger than 2.50 can comprise at least one donor group and at least one acceptor group. In some embodiments, such emitting material is a metal complex. In some embodiments, such emitting material is a non-metal complex. In some embodiments, such emitting material is a Cu, Ag, or Au complex.

In some embodiments, the EML having a FOM value equal to or greater than 2.50 comprises an emitter material that comprises at least one of the chemical moieties selected from the group consisting of: 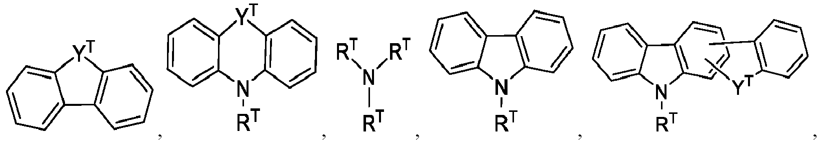 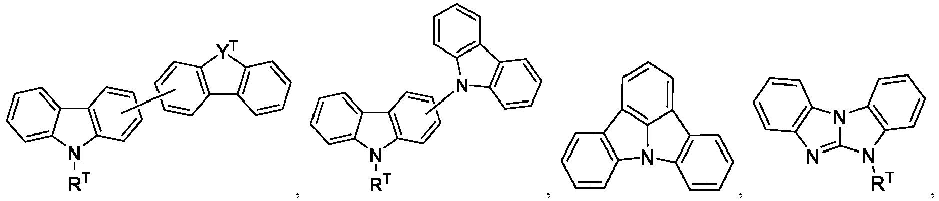 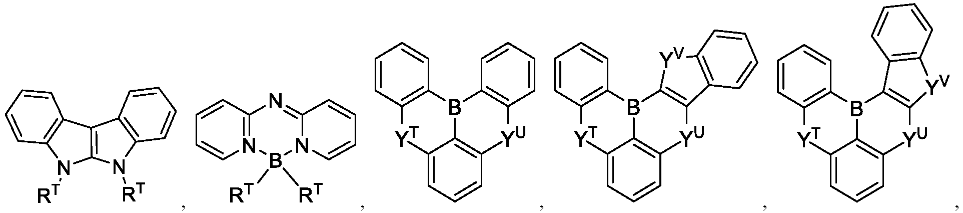 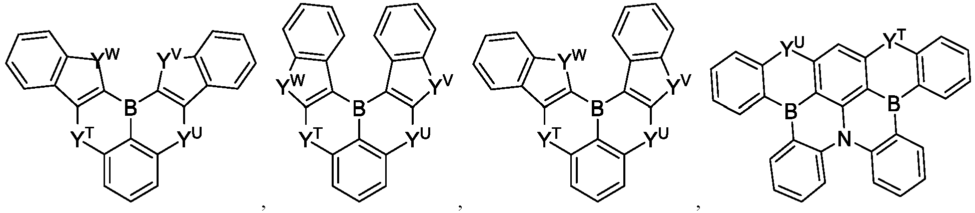 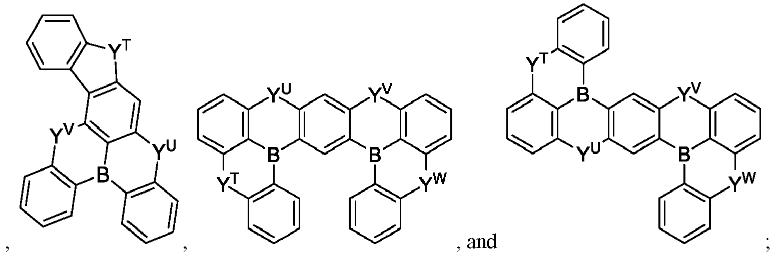
wherein Y^{T}, Y^{U}, Y^{V}, and Y^{W} are each independently selected from the group consisting of BR, NR, PR, O, S, Se, C=O, S=O, SO₂, BRR', CRR', SiRR', and GeRR';
wherein each R^{T} can be the same or different and each R^{T} is independently a donor, an acceptor group, an organic linker bonded to a donor, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and
R, and R' are each independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In some of the above embodiments, any carbon ring atoms up to maximum of a total number of three, together with their substituents, in each phenyl ring of any of above structures can be replaced with N.

In some embodiments, the EML having a FOM value equal to or greater than 2.50 comprises an emitter compound that comprises at least one of the chemical moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole.

In some embodiments, the EML of an inventive OLED comprises an emitter compound, where the EML has a FOM value equal to or greater than 2.50, and the emitter compound comprises at least one organic group selected from the group consisting of: 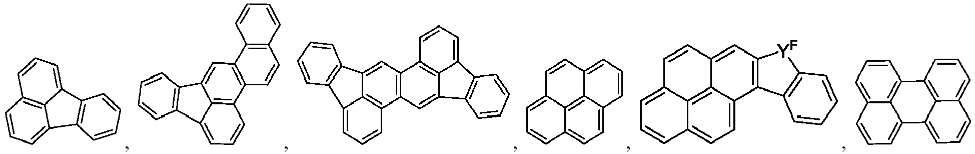 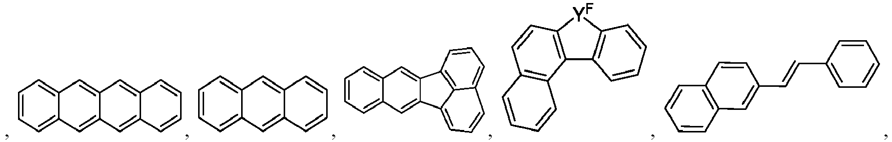 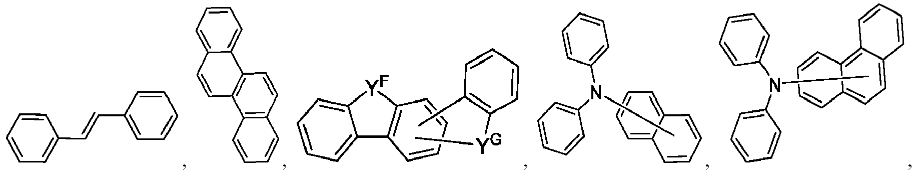 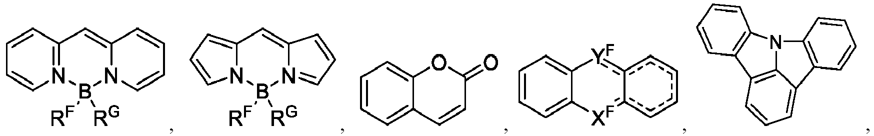 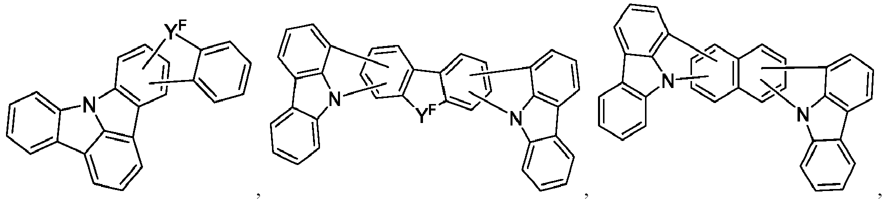 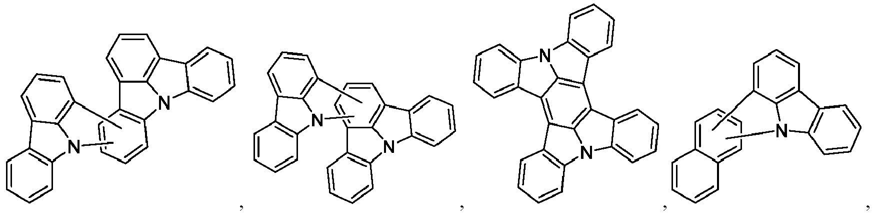 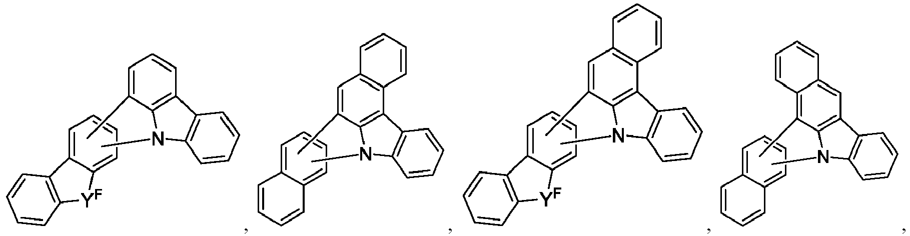 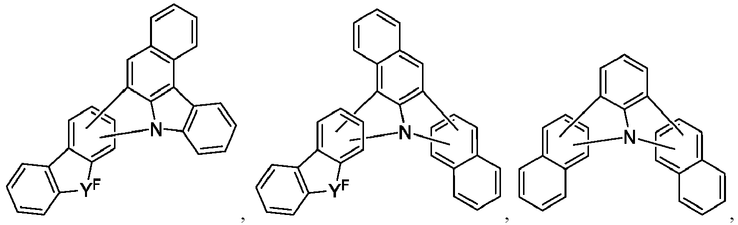 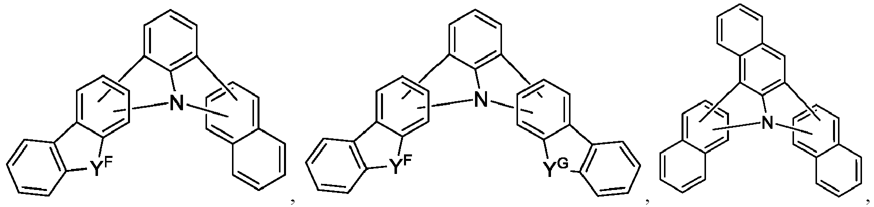 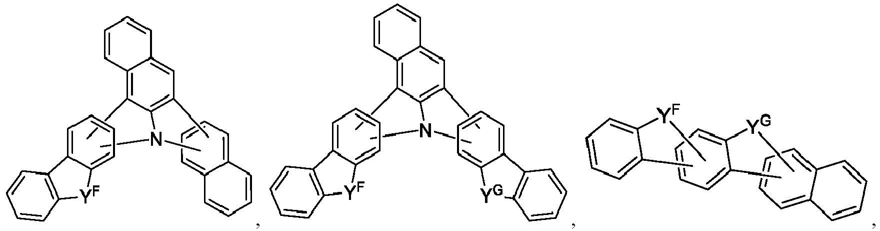 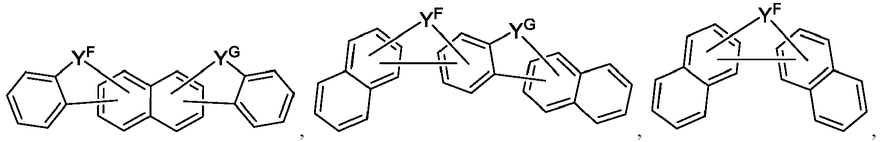 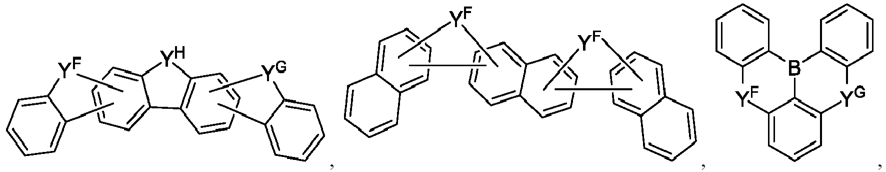 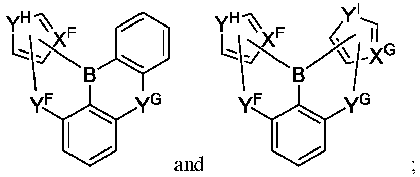
wherein Y^{F}, Y^{G}, Y^{H}, and Y^{I} are each independently selected from the group consisting of BR, NR, PR, O, S, Se, C=O, S=O, SO₂, BRR', CRR', SiRR', and GeRR';
wherein X^{F} and Y^{G} are each independently selected from the group consisting of C and N; and wherein R^{F}, R^{G}, R, and R' are each independently a hydrogen or a substituent selected from the group consisting of the General Substituents as defined herein.
In some of the above embodiments, any carbon ring atoms up to maximum of a total number of three, together with their substituents, in each phenyl ring of any of above structures can be replaced with N.

In some embodiments, the EML having a FOM value equal to or greater than 2.50 comprises an emitter compound selected from the group consisting of: 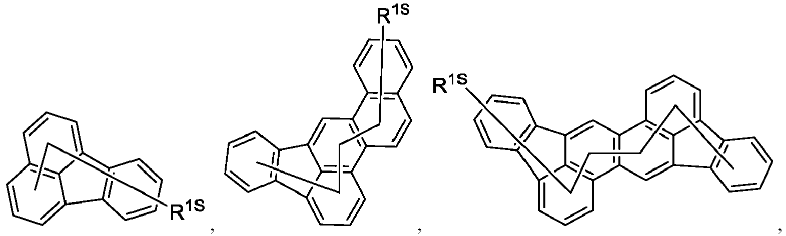 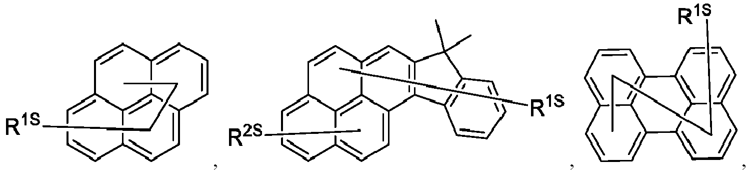 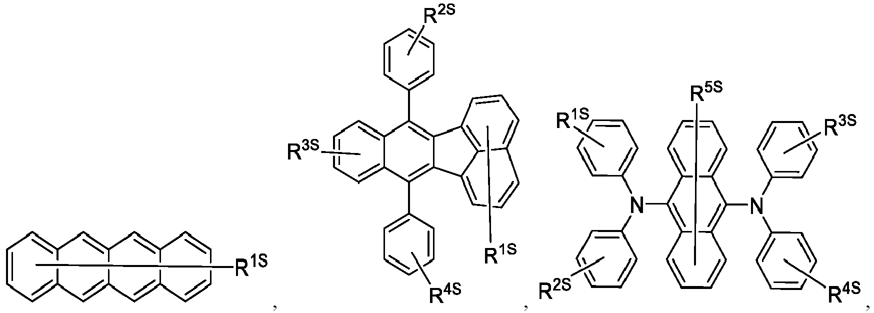 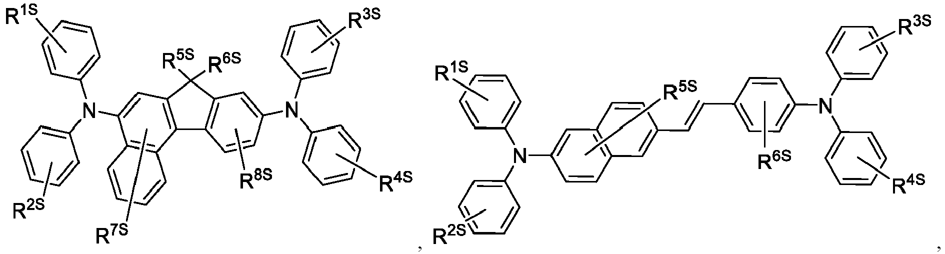 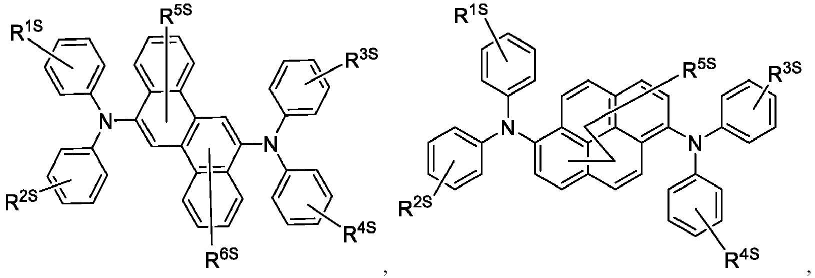 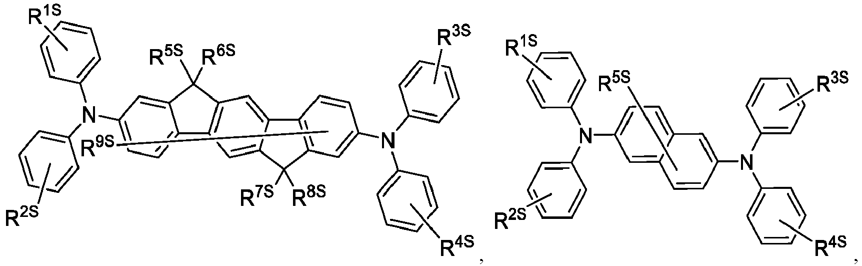 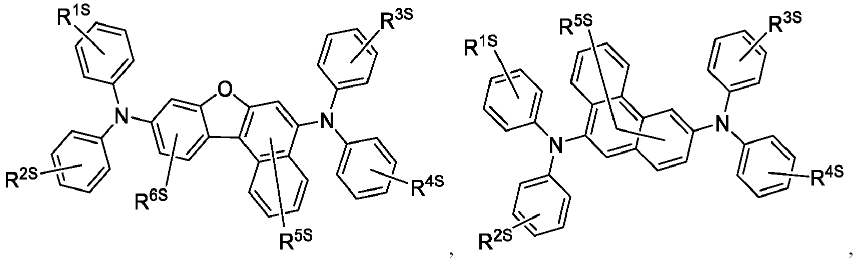 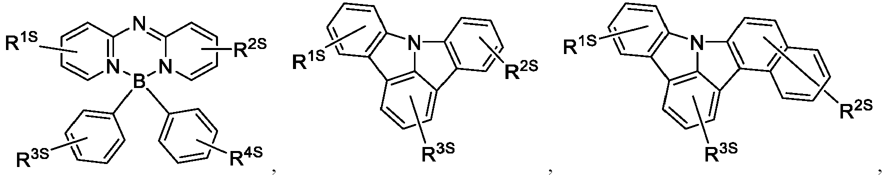 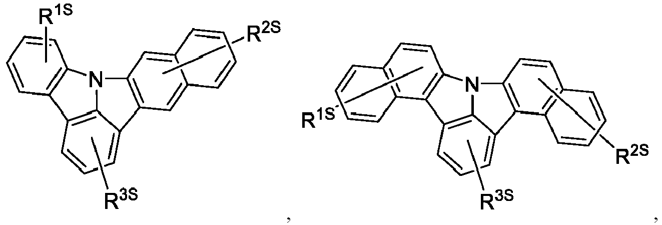 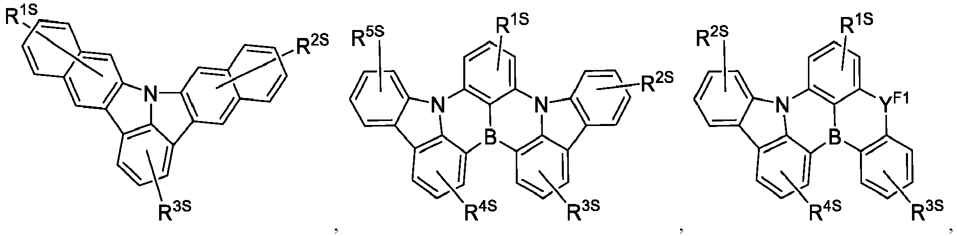 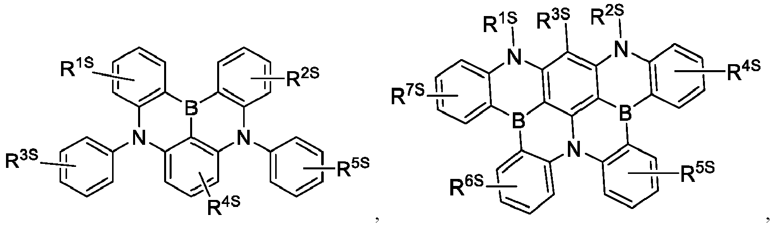 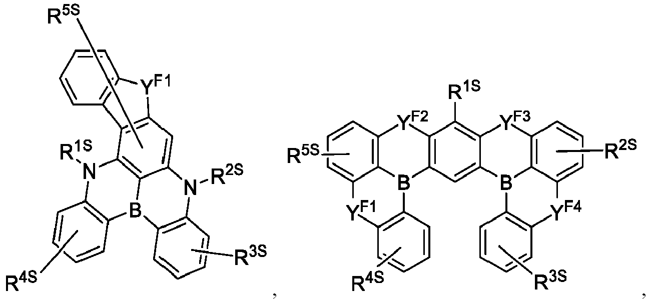 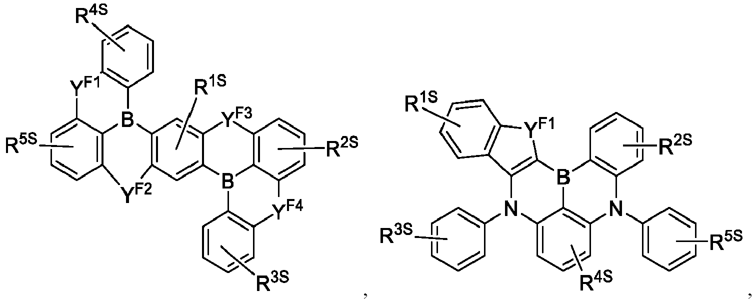 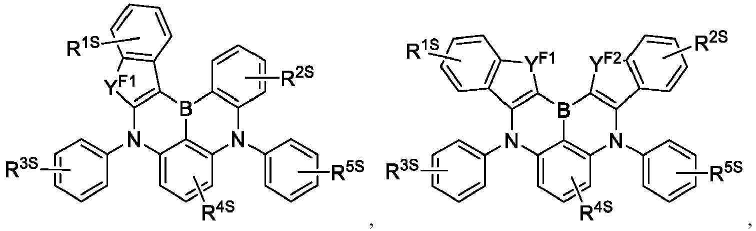 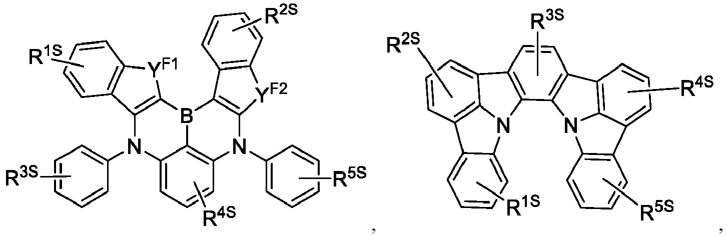 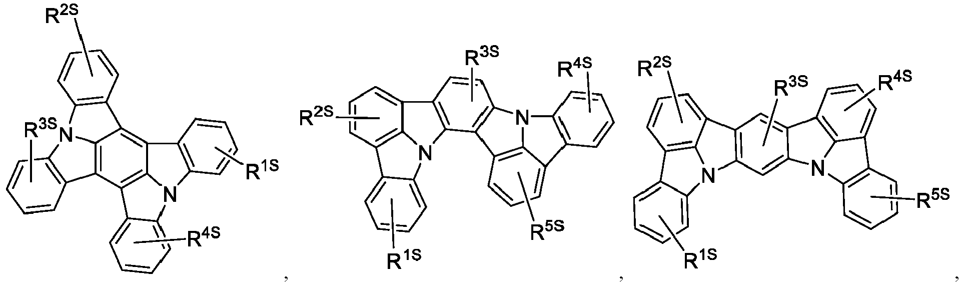 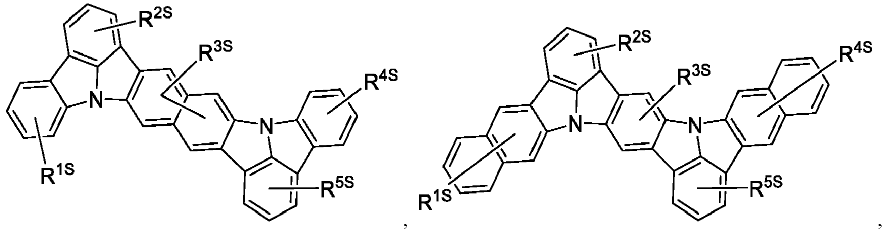 and 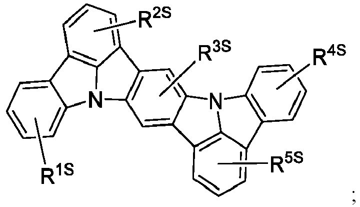
wherein Y^{F1} to Y^{F4} are each independently selected from O, S, and NR^{F1};
wherein R^{F1} and R^{1S} to R^{9S} each independently represents from mono to maximum possible number of substitutions, or no substitution; and
wherein R^{F1} and R^{1S} to R^{9S} are each independently a hydrogen or a substituent selected from the group consisting of the general substituents as defined herein.

In some embodiments of the OLED, the TADF emitter comprises at least one donor group and at least one acceptor group. In some embodiments, the TADF emitter is a metal complex. In some embodiments, the TADF emitter is a non-metal complex. In some embodiments, the TADF emitter is a Cu, Ag, or Au complex.

In some embodiments of the OLED, the TADF emitter has the formula of M(L⁵)(L⁶), wherein M is Cu, Ag, or Au, L⁵ and L⁶ are different, and L⁵ and L⁶ are independently selected from the group consisting of: 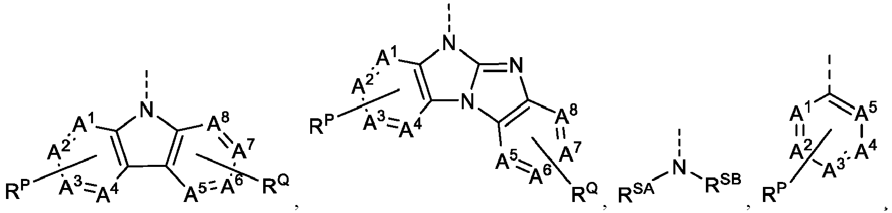 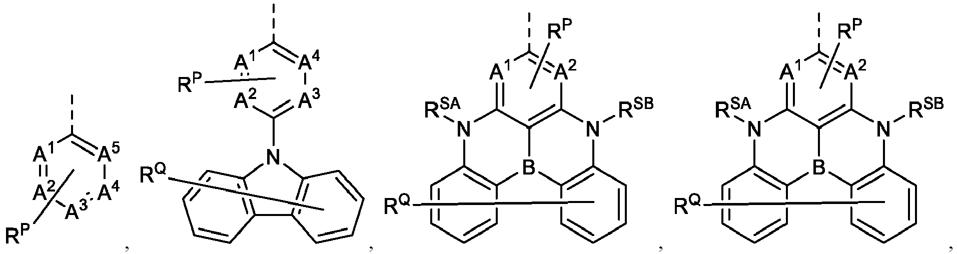 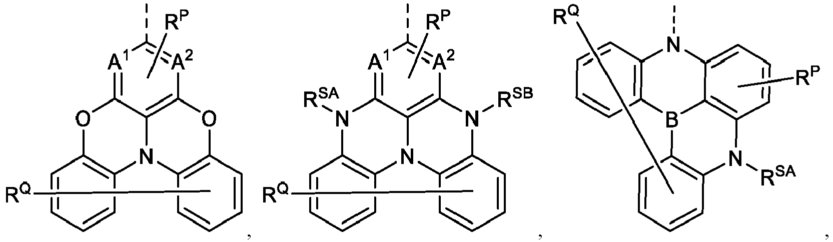 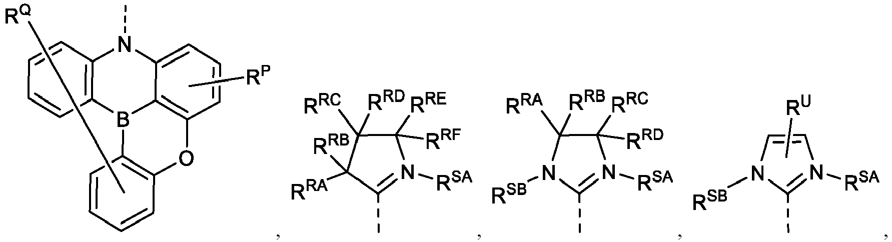 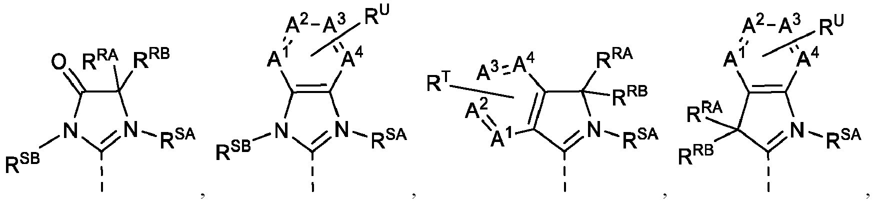 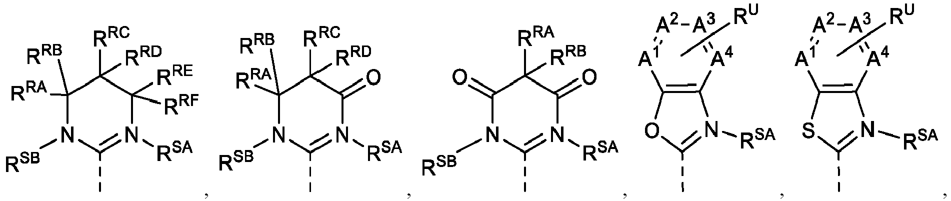 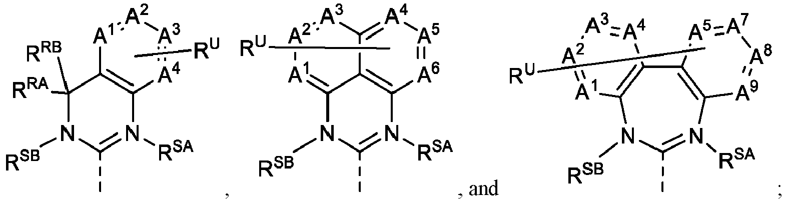
wherein A¹-A⁹ are each independently selected from C or N;
wherein each R^{P}, R^{P}, R^{U}, R^{SA}, R^{SB}, R^{RA}, R^{RB}, R^{RC}, R^{RD}, R^{RE}, and R^{RF} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In some embodiments of the OLED, the TADF emitter is selected from the group consisting of the structures in the following TADF LIST:

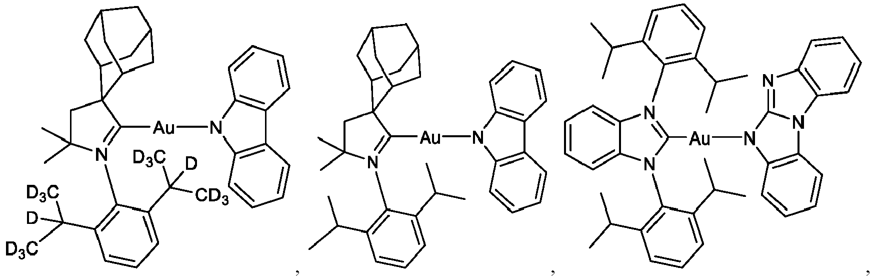

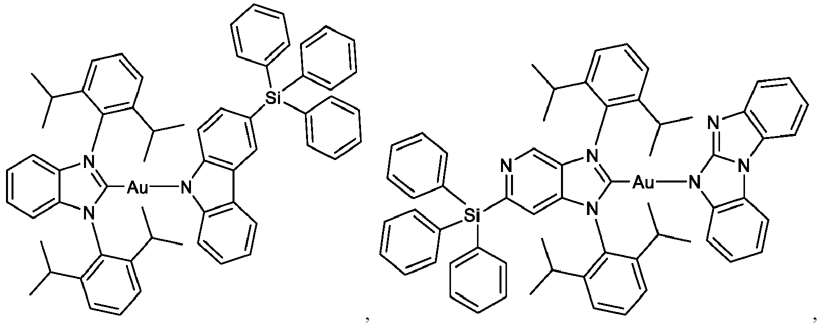

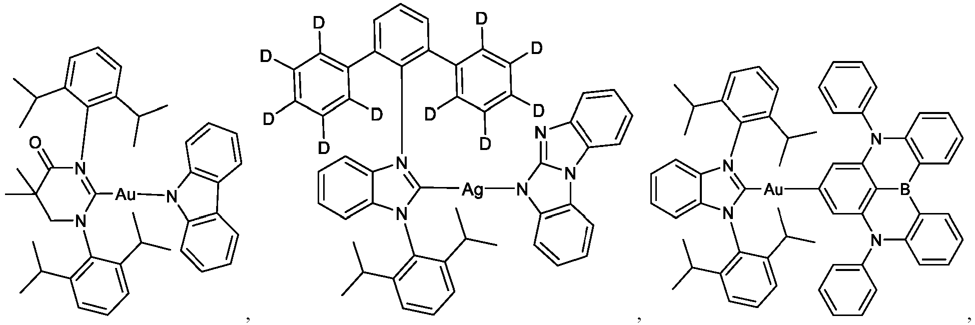

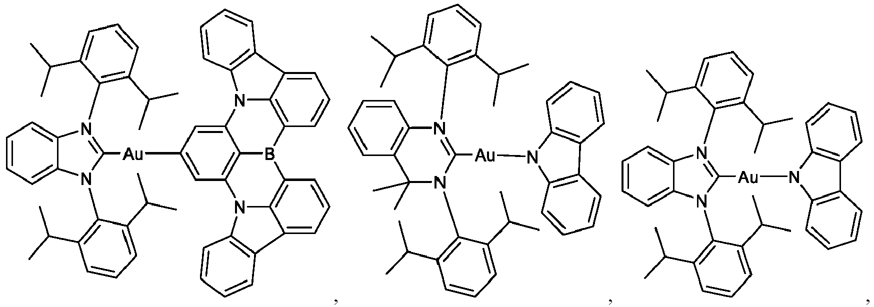

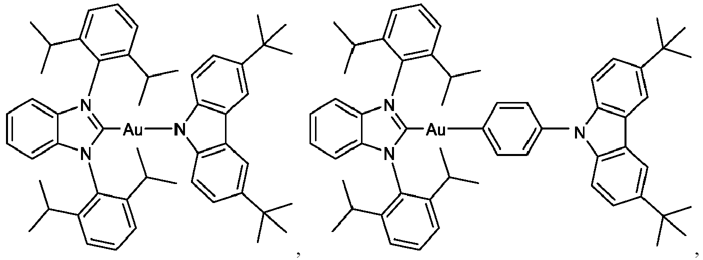

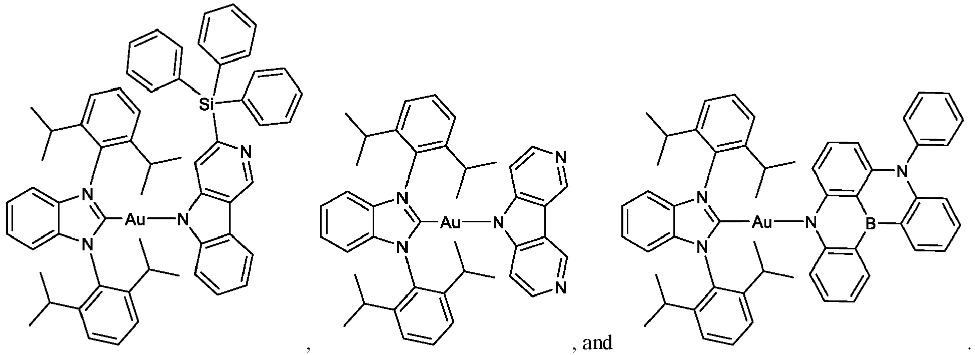

In some embodiments, the inventive OLED has a peak emission wavelength ≤ 470 nm. In some embodiments, the OLED has a peak emission wavelength ≤ 465 nm. In some embodiments, the OLED has a peak emission wavelength of 520 nm. In some embodiments, the OLED has a peak emission wavelength of 620 nm.

In some embodiments, the EML has a FOM value equal to or greater than 2.50 and has a minimum thickness of 250 Å. In some embodiments, the EML has a maximum thickness of 300 Å. In some embodiments, the EML has a maximum thickness of 350 Å. In some embodiments, the EML has a maximum thickness of 400 Å. In some embodiments, the EML has a maximum thickness of 450 Å. In some embodiments, the EML has a maximum thickness of 500 Å. In some embodiments, the EML has a maximum thickness of 550 Å. In some embodiments, the EML has a maximum thickness of 600 Å. In some embodiments, the EML has a maximum thickness of 650 Å. In some embodiments, the EML has a maximum thickness of 700 Å. In some embodiments, the EML has a maximum thickness of 750 Å. In some embodiments, the EML has a maximum thickness of 800 Å. In some embodiments, the EML has a maximum thickness of 850 Å. In some embodiments, the EML has a maximum thickness of 900 Å, In some embodiments, the EML has a maximum thickness of 950 Å. In some embodiments, the EML has a maximum thickness of 1000Å.

In some embodiments, the OLED further comprises layers selected from the group consisting of a hole injection layer, a hole transport layer, an electron blocking layer, an electron injection layer, an electron transport layer, a hole blocking layer, a capping layer, and any combinations thereof.

In some embodiments, the OLED further comprises a capping layer deposited on the cathode or anode, on the side away from the EML.

In some embodiments, the OLED further comprises one or more additional EMLs each having a FOM value of ≥ 2.50. The additional EMLs can have the same emitter compound as the first EML or can have a different emitter compound as the first EML.

In some embodiments, the OLED further comprises additional EMLs that do not have a FOM value of ≥ 2.50.

In some embodiments, the OLED has an EML minimum thickness of 350Å and the OLED has a maximum operating voltage at 10 mA/cm² of 4.0 volts. In some embodiments, the OLED has an EML minimum thickness of 450Å and the OLED has a maximum operating voltage at 10 mA/cm² 4.5 volts; or wherein the OLED has an EML minimum thickness of 550Å and the OLED has a maximum operating voltage at 10 mA/cm² 5.0 volts.

In some embodiments, the OLED contains a plurality of EMLs wherein each EML has a minimum thickness of 350Å and each EML has a maximum operating voltage at 10 mA/cm² of 4.0 volts. In some embodiments, the OLED contains a plurality of EMLs wherein each EML has a minimum thickness of 450Å and each EML has a maximum operating voltage at 10 mA/cm² of 4.5 volts. In some embodiments, the OLED contains a plurality of EMLs wherein each EML has a minimum thickness of 500Å and each EML has a maximum operating voltage at 10 mA/cm² of 5.0 volts.

In some embodiments, the OLED has a minimum thickness of 350Å and the OLED has a minimum LT90 device lifetime at 20 mA/cm² of 5 hours. In some embodiments, the OLED has a minimum thickness of 350Å and the OLED has a minimum LT90 device lifetime at 20 mA/cm² of 10 hours, 15 hours, 20 hours, 25 hours, 30 hours, 35 hours, 40 hours, 45 hours, 50 hours, 55 hours, or 60 hours. In some embodiments the OLED has a minimum thickness of 450Å and the OLED has a minimum LT90 lifetime at 20 mA/cm² of 5 hours. In some embodiments the OLED has a minimum thickness of 450Å and the OLED has a minimum LT90 lifetime at 20 mA/cm² of 10 hours, 15 hours, 20 hours, 25 hours, 30 hours, 35 hours, 40 hours, 45 hours, 50 hours, 55 hours, or 60 hours. In some embodiments, the OLED has a minimum thickness of 500Å and the OLED has a minimum LT90 lifetime at 20 mA/cm² of 5 hours. In some embodiments, the OLED has a minimum thickness of 500Å and the OLED has a minimum LT90 lifetime at 20 mA/cm² of 5 hours, 10 hours, 15 hours, 20 hours, 25 hours, 30 hours, 35 hours, 40 hours, 45 hours, 50 hours, 55 hours, or 60 hours.

In some embodiments of the OLED having more than one EML, each EML within the OLED can be formulated to emit only a single color. A "single color" refers to a light emission spectrum having a peak wavelength range that is within a specified range such as defined below. In some embodiments, a "single color" can refer to a specified shape in 1931 CIE coordinate color space as defined below.

As used herein, a "red" emission refers to a light emission spectrum with a peak wavelength in the range of about 600-700 nm; a "green" emission refers to a light emission spectrum with a peak wavelength in the range of about 500-600 nm; a "blue" emission refers to a light emission spectrum with a peak wavelength in the range of about 400-500 nm.

In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. As used herein, a "light blue" emission refers to a light emission spectrum with a peak wavelength in the range of about 465-500nm, and a "deep blue" emission refers to a light emission spectrum with a peak wavelength in the range of about 400-470nm.

A color altering layer refers to a layer that changes the color of light passing through the layer by modifying the spectrum of a light emission passing through the layer to a spectrum designated for the desired color output. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy.

An OLED component "of a color" refers to a component of an OLED that, when activated or used, produces or otherwise emits light having a particular color as previously described. For example, a "first emissive region of a first color" and a "second emissive region of a second color different than the first color" describes two emissive regions that, when activated within a device, emit two different colors. A component of an OLED can be a layer, a region, a material, sub-pixel, etc.

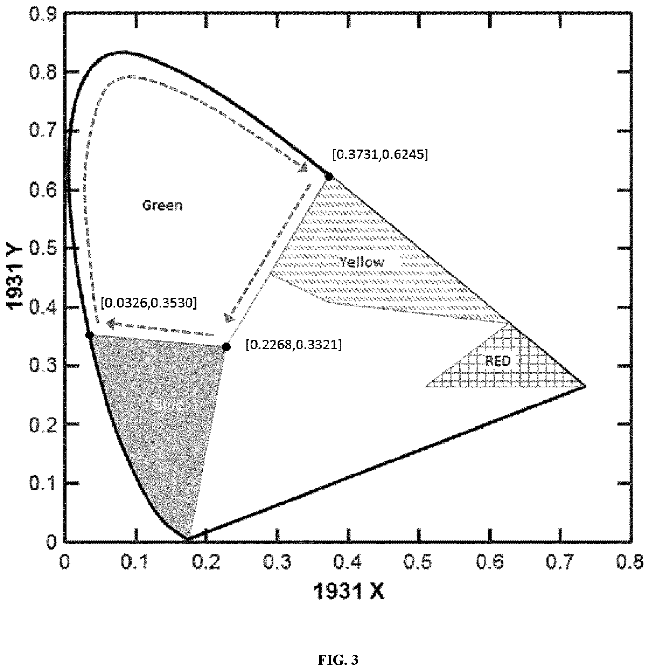

In some cases, it may be preferable to describe the color of an OLED component in terms of a color region defined by 1931 CIE coordinates in 1931 CIE coordinate color space. For example, a yellow emissive material may have multiple peak emission wavelengths, one in or near an edge of the "green" region, and one within or near an edge of the "red" region. The shape in 1931 CIE coordinate color space is constructed by following the locus between two color points and any additional interior points. For example, interior shape parameters for red, green, blue, and yellow may be defined by CIE shape parameters as provided in Table 1. These CIE shape parameters are illustrated in FIG. 3.

**Table 1**

| **Color** | **CIE shape parameters** |
|---|---|
| Central Red | Locus: [0.6270,0.3725];[0.7347,0.2653]; Interior: [0.5086,0.2657] |
| Central Green | Locus: [0.0326,0.3530];[0.3731,0.6245]; Interior:[0.2268,0.3321] |
| Central Blue | Locus: [0.1746,0.0052];[0.0326,0.3530]; Interior:[0.2268,0.3321] |
| Central Yellow | Locus: [0.3731,0.6245];[0.6270,0.3725]; |
| | Interior:[0.3700,0.4087];[0.2886,0.4572]; |

Thus, for example, a "red" emissive region will emit light having CIE coordinates within the triangle formed by the vertices [0.6270,0.3725];[0.7347,0.2653]:[0.5086,0.2657]. Where the line between points [0.6270,0.3725] and [0.7347,0.2653] follows the locus of the 1931 CIE color space. More complex color space regions can similarly be defined, such as the case with the green region. The color of the component is typically measured perpendicular to the substrate.

In some embodiments of the OLED of the present disclosure, the EML comprises a first host, wherein the first host is a boron-containing compound.

In some embodiments of the OLED of the present disclosure, the EML comprises a first host, wherein the first host is a silicon-containing compound.

In some embodiments of the OLED of the present disclosure, the EML comprises a first host, wherein the first host is a boron-containing compound. In some embodiments, the EML comprises a first host, wherein the first host has a formula selected from the group consisting of: 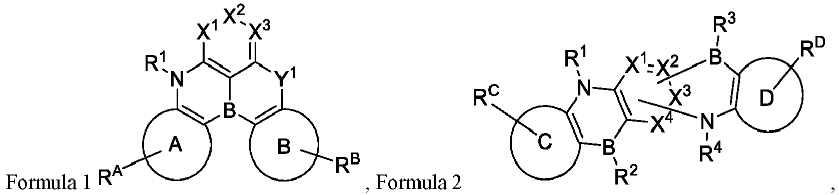 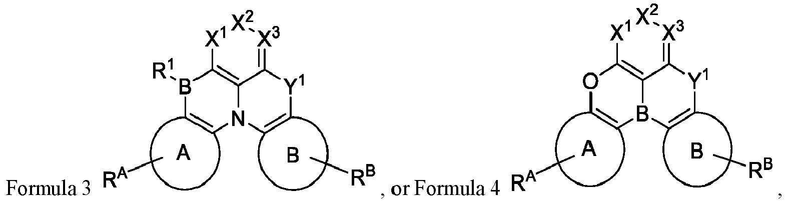 wherein:
each of ring A, ring B, ring C, and ring D is independently a 5-memebred or 6-membered carbocyclic or heterocyclic ring;
each of X¹, X², X³, and X⁴ is independently C, CR or N;
Y¹ is selected from the group consisting of a single bond, O, S, Se, NR, CRR', SiRR', GeRR', BR, and BRR'; each of R^{A}, R^{B}, R^{C}, and R^{D} independently represents zero, mono, or up to the maximum allowed number of substitutions to its associated ring;
each of R, R', R^{A}, R^{B}, R^{C}, R^{D}, R¹, R², R³, and R⁴ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof; and any two adjacent R, R', R^{A}, R^{B}, R^{C}, R^{D}, R¹, R², R³, or R⁴ can be joined to form a ring.

In some embodiments of the OLED of the present disclosure, the EML comprises a first host, wherein the first host has a formula selected from the group consisting of: 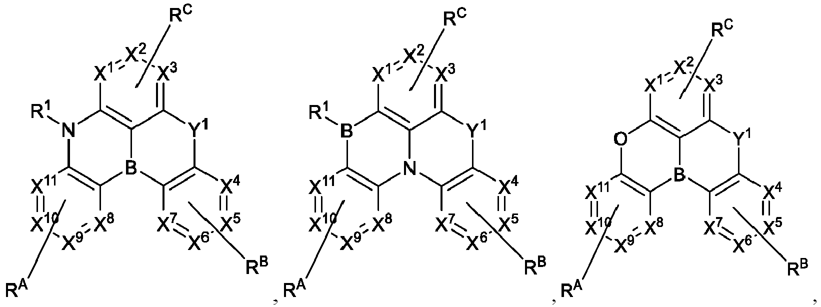 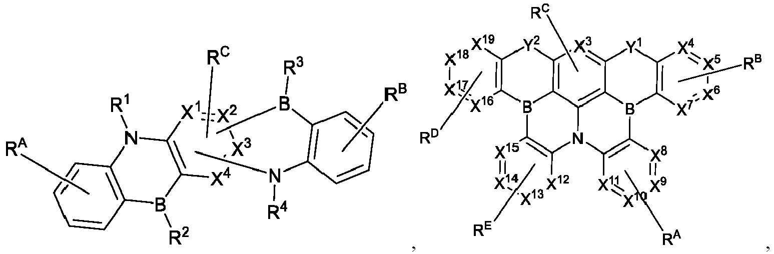 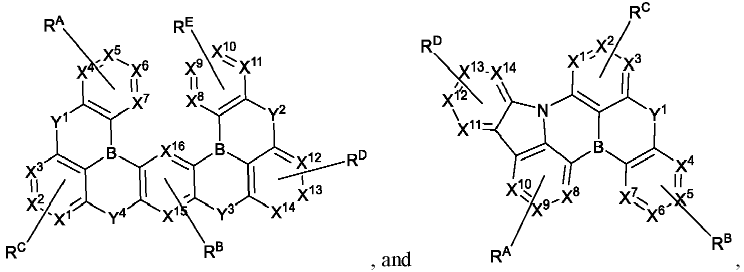
wherein X⁵-X¹⁹ are each independently C or N;
R^{E} represents zero, mono, or up to the maximum allowed number of substitutions to its associated ring; and
Y², Y³, and Y⁴ are each independently selected from the group consisting of a single bond, O, S, Se, NR, CRR', SiRR', GeRR', BR, and BRR'.

In another aspect, the present disclosure provides an OLED comprising:
an anode; a cathode; and an organic layer disposed between the anode and the cathode,
wherein the organic layer comprises an EML;
wherein the EML has a minimum thickness of 350 Å;
wherein the EML comprises a first host;
wherein the first host is a boron-containing compound.

In some such embodiments, the EML is formed of an Emissive System that has a FOM value equal to or larger than 2.50.

In some embodiments of the OLED of the present disclosure, the EML has a minimum thickness selected from the group consisting of 350, 400, 450, 500, 550, 600, 650 and 700 Å.

In some embodiments, the first host has a formula selected from the group consisting of: 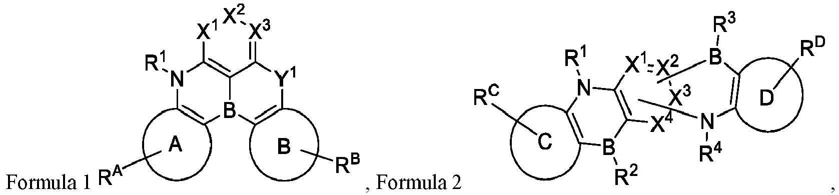 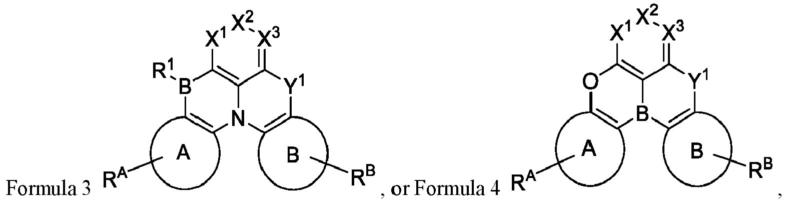 wherein:
each of ring A, ring B, ring C, and ring D is independently a 5-memebred or 6-membered carbocyclic or heterocyclic ring;
each of X¹, X², X³, and X⁴ is independently C, CR or N;
Y¹ is selected from the group consisting of a single bond, O, S, Se, NR, CRR', SiRR', GeRR', BR, and BRR'; each of R^{A}, R^{B}, R^{C}, and R^{D} independently represents zero, mono, or up to the maximum allowed number of substitutions to its associated ring;
each of R, R', R^{A}, R^{B}, R^{C}, R^{D}, R¹, R², R³, and R⁴ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof; and
any two R, R', R^{A}, R^{B}, R^{C}, R^{D}, R¹, R², R³, or R⁴ can be joined to form a ring.

In some embodiments, the first host has a formula selected from the group consisting of: 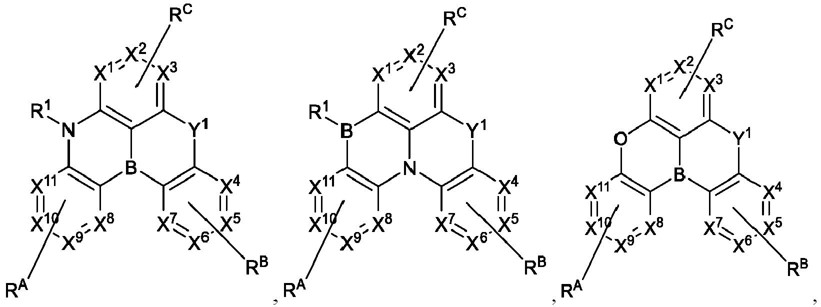 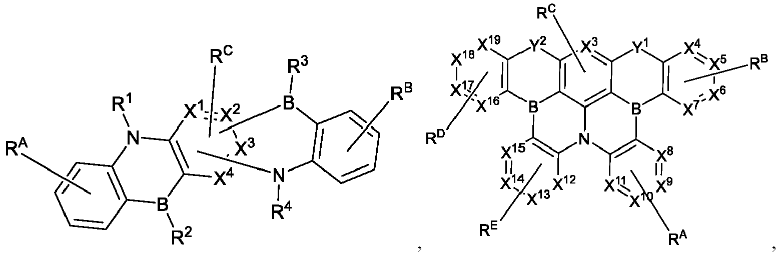 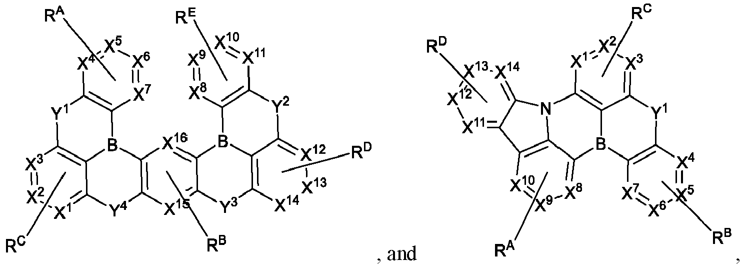
wherein X⁵-X¹⁹ are each independently C or N;
R^{E} represents zero, mono, or up to the maximum allowed number of substitutions to its associated ring; and
Y², Y³, and Y⁴ are each independently selected from the group consisting of a single bond, O, S, Se, NR, CRR', SiRR', GeRR', BR, and BRR'.

In some embodiments, the inventive OLED has a minimum thickness of 350Å and the OLED has a maximum operating voltage at 10 mA/cm² of 4.0 volts. In some embodiments, the OLED has a minimum thickness of 450Å and the OLED has a maximum operating voltage at 10 mA/cm² of 4.5 volts. In some embodiments, the OLED has a minimum thickness of 550Å and the OLED has a maximum operating voltage at 10 mA/cm² of 5.0 volts.

In some embodiments, the inventive OLED has a minimum thickness of 350Å and the OLED has a maximum operating voltage at 10 mA/cm2 of a value selected from the group consisting of 3.0, 3.5, 4.0, and 4.5, and 5.0 volts. In some embodiments, the inventive OLED has a minimum thickness of 450Å and the OLED has a maximum operating voltage at 10 mA/cm2 of a value selected from the group consisting of 3.5, 4.0, 4.5, and 5.0, and 5.5 volts. In some embodiments, the inventive OLED has a minimum thickness of 550Å and the OLED has a maximum operating voltage at 10 mA/cm2 of a value selected from the group consisting of 3.5, 4.0, 4.5, 5.0, 5.5., and 6.0 volts.

In some embodiments of the inventive OLED, the EML emits blue light. In some embodiments, the EML may include any materials/structures as described herein that are applicable to EML related embodiments throughout this disclosure.

In yet another aspect, the present disclosure also provides an OLED comprising:
an anode; a cathode; and an organic layer disposed between the anode and the cathode,
wherein the organic layer comprises an EML having an Emissive System that has a FOM value equal to or larger than 2.50 and the EML has a minimum thickness of 350 Å;
wherein the EML comprises a first host and a second host;
wherein the first host is an electron transporting host comprising an electron transporting moiety, the second host is a hole transporting host comprising an hole transporting moiety;
wherein the hole transporting moiety of the second host is selected from the group consisting of: 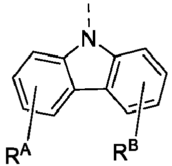 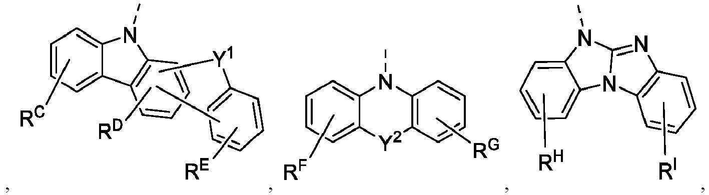 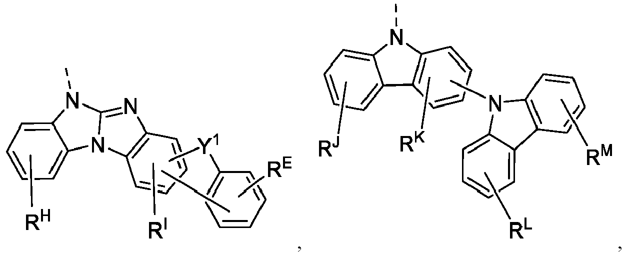 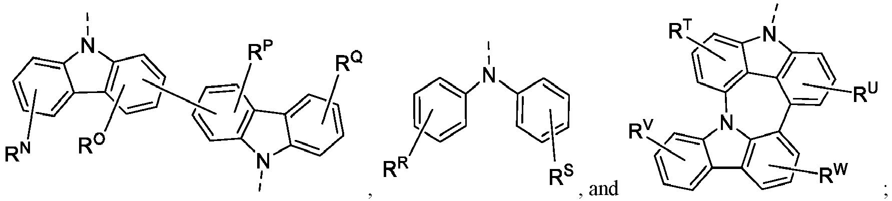
wherein:
   each of Y¹ and Y² is independently selected from the group consisting of BR, BRR', NR, PR, P(O)R, O, S, Se, C=O, C=S, C=Se, C=NR, C=CRR', S=O, SO₂, CRR', SiRR', and GeRR';
   each of R^{A} to R^{W} is independently monosubstituted to the maximum allowable substitution, or no substitution;
   each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
   two adjacent of R, R', or R^{A} to R^{W} can be joined or fused to form a ring;
wherein the electron transporting moiety of the first host is selected from the group consisting of: 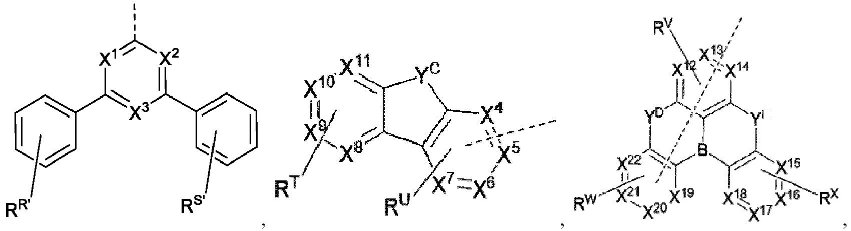 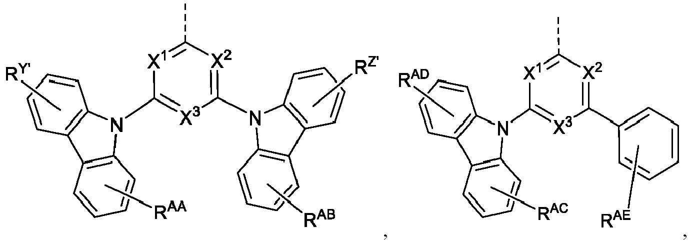 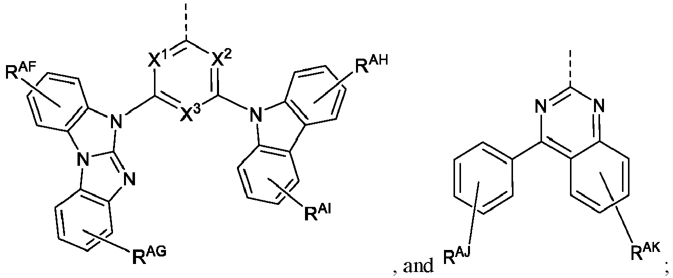
wherein:
   each of X¹ to X²² is independently C or N;
   at least one of X¹ to X³ is N;
   at least one of X⁴ to X¹¹ is N;
   each of Y^{C}, Y^{D}, and Y^{E} is independently selected from the group consisting of BR, BRR', NR, PR, P(O)R, O, S, Se, C=O, C=S, C=Se, C=NR, C=CRR', S=O, SO₂, CRR', SiRR', and GeRR';
   each of R^{R'} to R^{Z'} and R^{AA} to R^{AK} is independently monosubstituted to the maximum allowable substitution, or no substitution;
   each R, R', R^{R'} to R^{Z'}, and R^{AA} to R^{AK} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
   two adjacent of R, R', R^{R'} to R^{Z'}, or R^{AA} to R^{AK} can be joined or fused to form a ring.

In some such embodiments, the EML is formed from an Emissive System that has a FOM value equal to or larger than 2.50.

In some embodiments, the first host has an electron transport moiety and a |LUMO energy| < 2.8 eV. In some embodiments, the first host has an electron transport moiety and a |LUMO energy| < 2.7 eV. In some embodiments, the first host has an electron transport moiety and a |LUMO energy| < 2.6 eV. In some embodiments, the first host has an electron transport moiety and a |LUMO energy| < 2.4 eV.

In some embodiments, the second host has a hole transport moiety and |HOMO energy| > 5.8 eV. In some embodiments, the second host has a hole transport moiety and |HOMO energy| > 5.7 eV. In some embodiments, the second host has a hole transport moiety and |HOMO energy| > 5.6 eV. In some embodiments, the second host has a hole transport moiety and |HOMO energy| > 5.5 eV. In some embodiments, the second host has a hole transport moiety and |HOMO energy| > 5.4 eV. In some embodiments, the second host has a hole transport moiety and |HOMO energy| > 5.3 eV.

In some embodiments of the inventive OLED, the EML has a minimum thickness of 400, 450, 500, 550, 600, 650 or 700 Å.

In some embodiments, the inventive OLED further comprises layers selected from the group consisting of a hole injection layer, a hole transport layer, an electron blocking layer, an electron injection layer, an electron transport layer, a hole blocking layer, a capping layer, and any combinations thereof.

In some embodiments of the inventive OLED, the EML comprises an emitting material selected from the group consisting of a phosphorescent emitter, a fluorescent emitter, a TADF emitter, and combinations thereof.

In some embodiments of the inventive OLED, the EML comprises an emitting material being capable of emitting light from a triplet excited state to a ground singlet state at room temperature.

In some embodiments, the EML comprises an emitting material being a metal coordination complex having a metal-carbon bond.

In some embodiments, the EML comprises an emitting material being a metal coordination complex having a metal-nitrogen bond.

In some embodiments, the metal is selected from the group consisting of Ir, Rh, Re, Ru, Os, Pt, Au, and Cu. In some embodiments, the metal is Ir. In some embodiments, the metal is Pt.

In some embodiments, the inventive OLED has a minimum thickness of 350Å and the OLED has a maximum operating voltage at 10 mA/cm² of 4.0 volts. In some embodiments, the OLED has a minimum thickness of 450Å and the OLED has a maximum operating voltage at 10 mA/cm² of 4.5 volts. In some embodiments, the OLED has a minimum thickness of 550Å and the OLED has a maximum operating voltage at 10 mA/cm² of 5.0 volts.

In some embodiments, the emitting material has a formula selected from the group consisting of Ir(L_{A})₃, Ir(L_{A})(L_{B})₂, Ir(L_{A})₂(L_{B}), Ir(L_{A})₂(L_{C}), Ir(L_{A})(L_{B})(L_{C}), and Pt(L_{A})(L_{B});
wherein L_{A}, L_{B}, and L_{C} are different from each other in the Ir compounds;
wherein L_{A} and L_{B} can be the same or different in the Pt compounds; and
wherein L_{A} and L_{B} can be connected to form a tetradentate ligand in the Pt compounds.

In some embodiments, the EML comprises an emitting material comprising at least one donor group and at least one acceptor group.

In some embodiments, the emitting material is a metal complex.

In some embodiments, the emitting material is a non-metal complex.

In some embodiments, the emitting material is a Cu, Ag, or Au complex.

Also provided is an OLED comprising: an anode; a cathode; and an organic layer disposed between the anode and the cathode, wherein the organic layer comprises an EML; wherein the EML has a minimum thickness of 350 Å; wherein the EML comprises a first host and a second host; wherein the first host is an electron transporting host comprising an electron transporting moiety, wherein the second host is a hole transporting host comprising a hole transporting moiety and
wherein the charge mobility of any of the first host or the second host is higher than 1E⁻¹³ cm²V⁻¹s⁻¹.

In some embodiments of the OLED, the first host contains a boron. In some embodiments of the OLED, the first host has an electron mobility that is higher than 1E⁻¹² cm²V⁻¹s⁻¹. In some embodiments, the first host has an electron mobility that is higher than 1E⁻¹¹ cm²V⁻¹s⁻¹. In some embodiments, the first host has an electron mobility that is higher than 1E⁻¹⁰ cm²V⁻¹s⁻¹. In some embodiments, the first host has an electron mobility that is higher than 1E⁻⁹ cm²V⁻¹s⁻¹. In some embodiments, the second host has a hole mobility that is higher than 1E⁻¹²cm²V⁻¹s⁻¹. In some embodiments, the second host has a hole mobility that is higher than 1E⁻¹¹ cm²V⁻¹s⁻¹. In some embodiments, the second host has a hole mobility that is higher than 1E⁻¹⁰ cm²V⁻¹s⁻¹. In some embodiments, both the first host and the second host have a charge mobility that is higher than 1E⁻¹² cm²V⁻¹s⁻¹. In some embodiments, both the first host and the second host have a charge mobility that is higher than 1E⁻¹¹ cm²V⁻¹s⁻¹. In some embodiments, both the first host and the second host have a charge mobility that is higher than 1E⁻¹⁰ cm²V⁻¹s⁻¹. In some embodiments, both the first host and the second host have a charge mobility that is higher than 1E⁻⁹ cm²V⁻¹s⁻¹.

In some embodiments of the disclosure, the first host and the second host are selected from the pairs selected from the group consisting of:

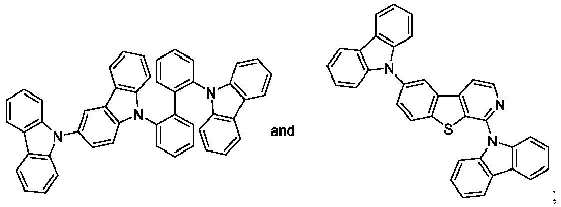

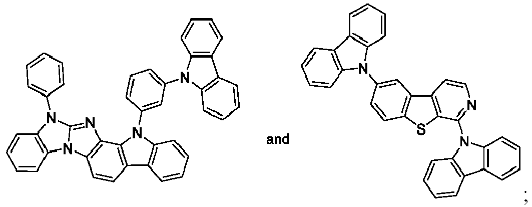

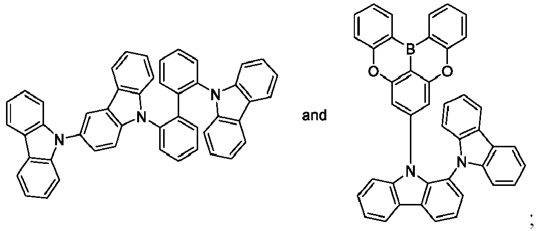

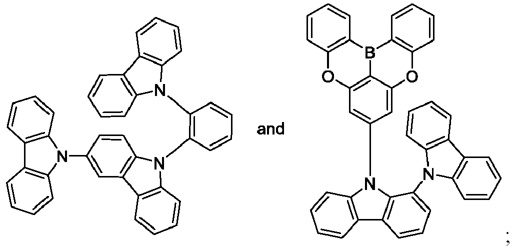

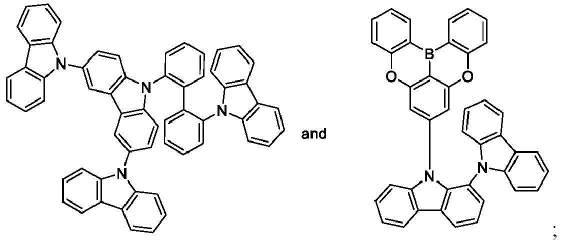

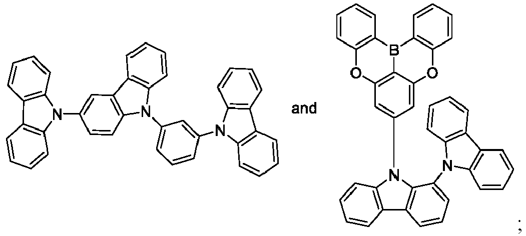

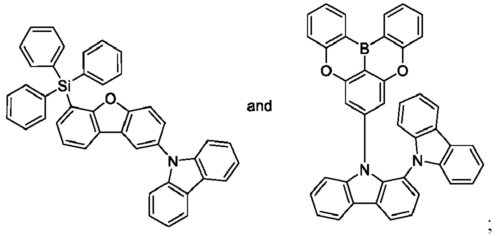

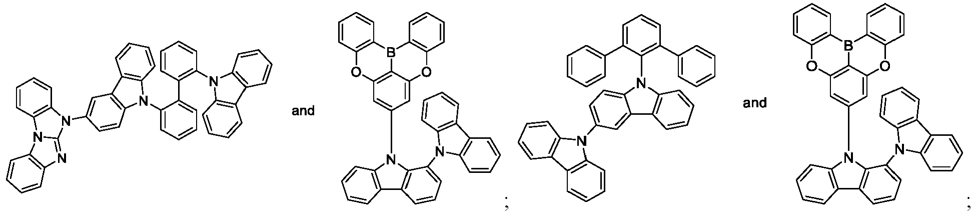

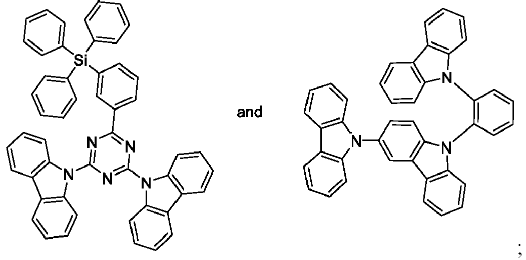

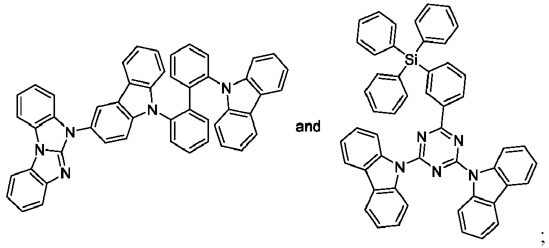

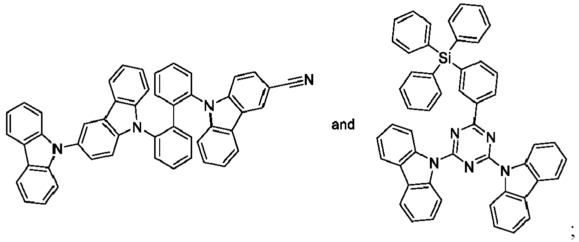

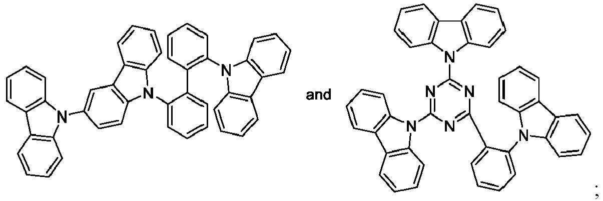

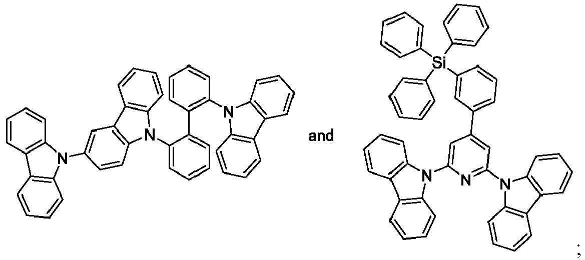

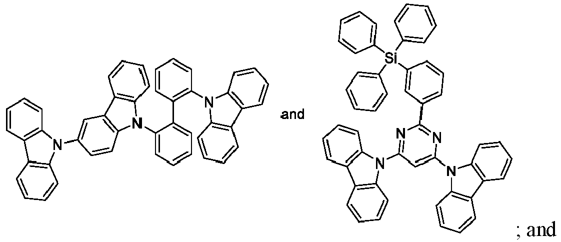

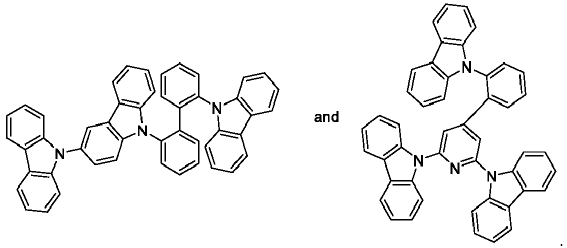

In some embodiments, the hole transporting moiety of the hole transporting host consists of: 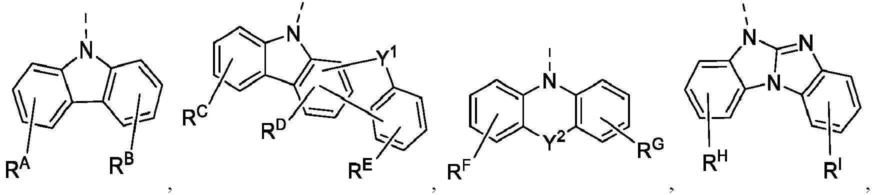 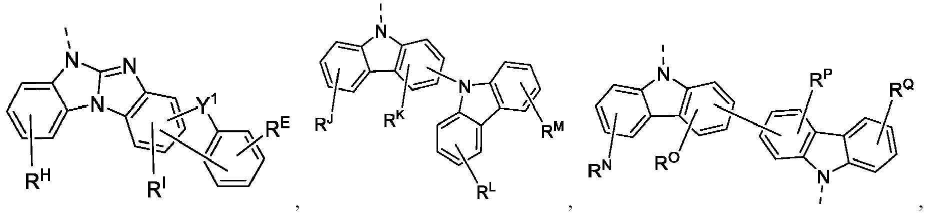 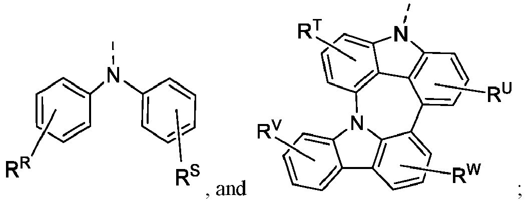 wherein:
each of Y¹ and Y² is independently selected from the group consisting of BR, BRR', NR, PR, P(O)R, O, S, Se, C=O, C=S, C=Se, C=NR, C=CRR', S=O, SO₂, CRR', SiRR', and GeRR';
each of R^{A} to R^{W} is independently monosubstituted to the maximum allowable substitution, or no substitution;
each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
two adjacent of R, R', or R^{A} to R^{W} are optionally joined or fused to form a ring.

In some embodiments, the first host is at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated.

In some embodiments, the second host is at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated.

The devices of the present disclosure have greater stability and low operating voltages at larger EML thickness. This can be accomplished by increasing the conductivity of one or more of components of the EML. For example, the device could feature a hole transporting host that has a large hole mobility. Thus, through utilizing the high hole mobility hole transporting hosts, the voltage of the device can be kept low even when the total emissive layer is thick. If the high hole mobility host is not paired with a high electron mobility electron transporting host, the device can still have low operating voltage as the conductivity for a least one of the charge carriers is high. However, the device stability may not be great as the imbalance in charge conductivity could lead to an exciton recombination profile with a high density of excitons in one spatial position of the EML or near an interface where the cleanliness of the deposition system becomes important. Thus, the composition of the EML and neighboring layers can be an important part of achieving both large stability and low operating voltage. In the below paragraphs, some of the design methods are outlined that can be applied to achieve good stability and low voltage.

In OLED devices where the conductivities of the hole and the electron in the emissive layer are not similar in magnitude, then the exciton recombination profile and/or the stability can be modified by changing the relative composition of the EML. For example, if the electron conductivity is much greater than the hole conductivity in the EML, then by lowering the volume fraction of electron transporting host in the EML, the lifetime can be enhanced. In this case, it is important to think about both the total concentration of electron transporting host in the EML but also the ratio between the electron transporting host and the hole transporting host. For example, the electron transporting host may be between 5 to 25% by volume. If the emitter doping were 10% by volume, this would translate to a h-host to e-host ratio of 17 to 2.6. Importantly, there will be a concentration of electron transporting host at which the percolation pathway of charges becomes disrupted by further lowering of the concentration. At this point, although the ratio of hosts nor the doping percentage will not change dramatically, the device stability could be modified drastically by even fractions of a percent change in the volume percent of hosts. A back of the envelop calculation puts the percolation point somewhere between 0.5 and 5% depending on various assumptions.

In cases where the conductivities of electrons and holes on their respective hosts are similar in magnitude, then the stability can be tuned by host volume percentage. However, the ratios between hosts carrying charge are expected to be closer to 1 with a range between 3 and 0.33.

In some EML configurations, the emitter or emitters are the primary charge conduction pathway for at least one charge carrier in the EML. In these cases, the volume percent of the host that carries charge equivalent to the one on the emitter will not play a significant role in the stability of the device. Instead, the stability will be dominated by the volume percentages of the emitter or emitters carrying charge and the other host or hosts conducting the opposite charge.

In OLED devices where the conductivities of the hole and the electron in the emissive layer are not similar in magnitude, then the exciton recombination profile and/or the stability can be modified by changing the charge mobility or the relevant energy levels of the hole and or electron blocking materials. For example, if the electron conductivity is much greater than the hole conductivity in the EML, then by choosing an electron blocking material that has higher hole conductivity than the hole transporting host or the emitter, the device lifetime can be enhanced, while simultaneously reducing the device voltage. In a similar manner, if the hole conductivity is much greater than the electron conductivity in the EML, then by choosing a hole blocking material that has higher electron conductivity than the electron transporting host or the emitter, the device lifetime can be enhanced, while simultaneously reducing the device voltage.

In some devices, where the conductivities of the hole and the electron in the emissive layer are not similar in magnitude, then the exciton recombination profile and or the stability can be modified by tuning the relevant energy levels of the blocking layer materials compared to the hosts and or emitters in the EML. For example, if the electron conductivity is much greater than the hole conductivity in the EML, then choosing an electron blocking layer material whose Highest Occupied Molecular Orbital energy level is relatively aligned to that of the emitter or the hole transporting host, the hole injection barrier between the blocking layers and the hole transporting host or emitter in the EML will be reduced, and the device lifetime can be enhanced while simultaneously reducing the operating voltage of the device.

In addition to modifying the charge conductivity through the EML itself, the device voltage can be modified by modulating the injection barriers into the EML. For example, we can increase hole conduction through the device by removing hole injection barriers from the HTL or EBL into the EML. Injection barriers can be minimized if the difference between the Highest Occupied Molecular Orbital energy level of the electron blocking layer material and the Highest Occupied Molecular Orbital energy level of the dopant and or the hole transporting host is between the range of 0 eV and 0.5 eV in absolute values.

In some embodiments, the HTL has a HOMO energy that is shallower than the HOMO energy of the hole transporting material in the EML. In these embodiments, the hole injection barrier can be reduced by using an EBL material with a HOMO level intermediate to the HTL and the hole transporting material in the EML. For example, the HTL may have a HOMO level of -5.2 eV and in the EML the dopant may be the hole transporting material with a HOMO of -5.4 eV. In this case, an EBL of -5.3 eV may limit any injection barrier into the EML. Further, if an EBL material can be sourced with an intermediate HOMO level, the closer the HOMO level of the EBL to the HOMO level of the hole transporting material in the EML the lower the injection barrier. In the above example, an EBL with a HOMO of -5.4 eV would be better than an EBL with a HOMO of -5.5 eV.

In some embodiments, the HTL has a HOMO energy that is deeper than the HOMO energy of the hole transporting material in the EML. In these embodiments, the HOMO level of the EBL should be intermediate between the HTL HOMO level and the HOMO level of the hole transporting material in the EML. For example, if the HTL has a HOMO level of -5.8 eV and the emitter is the hole transporting material in the EML with a HOMO level of -5.3 eV, then an EBL material with a HOMO level of -5.4 eV should not have any hole injection barrier.

In some devices, if the hole conductivity is much greater than the electron conductivity in the EML, then by choosing a hole blocking layer material whose Lowest Unoccupied Molecular Orbital energy level is relatively aligned to that of the emitter and/or the electron transporting host, the electron injection barrier between the hole blocking layers and the hole transporting host and or emitter in the EML will be reduced, and the device lifetime can be enhanced while simultaneously reducing the operating voltage of the device. For example, the difference between the Lowest Unoccupied Molecular Orbital energy level of the hole blocking layer material and the Lowest Unoccupied Molecular Orbital energy level of the dopant and or the electron transporting layer may be between the range of 0 eV and 0.5 eV in absolute values, so for example, if the Lowest Unoccupied Molecular Orbital energy level of the electron transporting host and or dopant is -2.8 eV, then the Lowest Unoccupied Molecular Orbital energy level of the hole blocking layer material may be in the range between -2.8 eV and -2.3 eV

In OLED devices where the conductivities of the hole and the electron in the EML are not similar in magnitude, then the exciton recombination profile and or the stability can be modified by the addition of a third or a fourth host to the EML. For example, if the electron conductivity is much greater than the hole conductivity in the EML, then adding a third hole transporting host that has a higher hole conductivity in the EML, or a fourth electron transporting host that has a lower electron conductivity in the EML, the device lifetime can be enhanced. In another example, if the hole conductivity is much greater than the electron conductivity in the EML, by adding a third hole transporting host that has a lower hole conductivity in the EML or adding a fourth electron transporting host that has a higher electron conductivity in the EML, the device lifetime can be enhanced. In this case, it is important to think about both the total concentration of the third or fourth hosts in the EML and the relative ratio of the third or fourth hosts in the EML compared to the hole transport host or the electron transporting host, respectively. For example, the third host maybe between 0.5 to 35% by volume, and if the emitter doping is 10% by volume and the electron transporting host is 40% by volume, this would translate to a third host to hole transporting host ratio of 99 to 0.43. In another example, the fourth host maybe between 0.5 to 35% by volume, and if the emitter is 10% by volume and the hole transporting host is 40% by volume, this would translate to a fourth host to electron transporting host ratio of 99 to 0.43.

In some embodiments, the FOM is calculated using device lifetime and driving voltages calculated at constant luminance. In some of these embodiments, the luminance is 1,000 cd/m². At constant luminance, the device color and efficiency of the device will partially set the lifetime and operating voltage at 1,000 cd/m². Thus, the FOM reflects some aspect of the color of the device as well as the efficiency. Higher external quantum efficiency (EQE) will result in lower driving voltage to achieve 1,000 cd/m² for the same spectral shape. In other embodiments, the FOM is calculated using the device lifetime from a specific current density, 20 mA/cm², and the driving voltage from a specific current density, 10 mA/cm².

In some embodiments, the electron transporting host (Ehost) doping percentage in the EML is chosen to reflect the optimal performance of the device at one of the two thicknesses used for the two test OLEDs in determining the FOM of a given EML.

In some embodiments we demonstrate that a drastic change in the hole transporting host (Hhost) to EHost ratio in the EML does not affect the FOM which speaks to the robustness of FOM as a metric. In some embodiments the HHostEHost ratio in the EML is changed from 1.5:1.0 to 0.8:1.0.

It should be understood that all of the materials/compounds/structures described herein for EML application can be employed in all the embodiments/features/attributes/aspects/properties in relation to EML where applicable in all of the OLED device embodiments described throughout this disclosure. The same should be understood to be true for the disclosed hole transporting host or material, the electron transporting host or material, and other materials where applicable.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

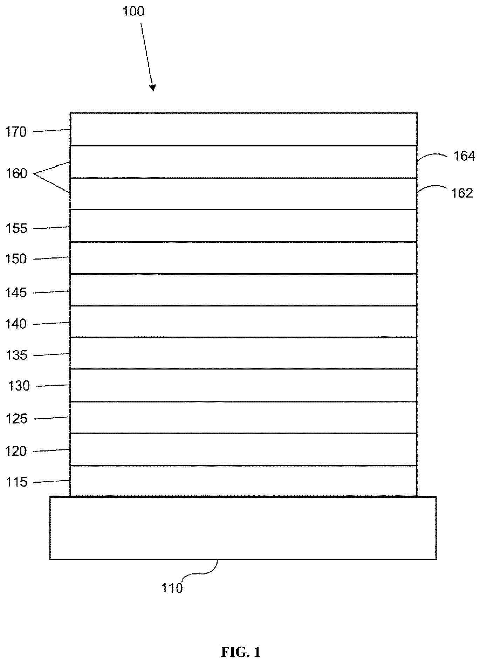

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U. S. Patent Application Publication No. 2003/0230980, which are incorporated by reference in their entireties. Examples of injection layers are provided in U.S. Patent Application Publication No. 2004/0174116, which is incorporated by reference in its entirety. Barrier layer 170 may be a single- or multi-layer barrier and may cover or surround the other layers of the device. The barrier layer 170 may also surround the substrate 110, and/or it may be arranged between the substrate and the other layers of the device. The barrier also may be referred to as an encapsulant, encapsulation layer, protective layer, or permeation barrier, and typically provides protection against permeation by moisture, ambient air, and other similar materials through to the other layers of the device. Examples of barrier layer materials and structures are provided in U.S. Patent Nos. 6,537,688, 6,597,111, 6,664,137, 6,835,950, 6,888,305, 6,888,307, 6,897,474, 7,187,119, and 7,683,534, each of which is incorporated by reference in its entirety.

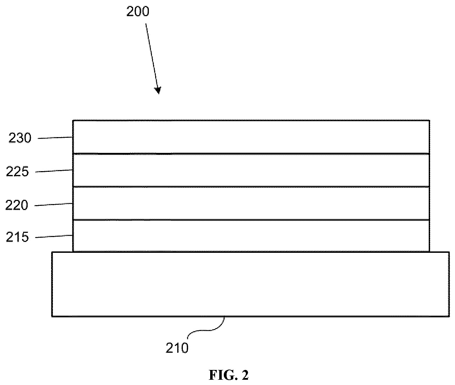

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may
further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

According to an embodiment, an organic light emitting diode/device (OLED) is also provided. The OLED can include an anode, a cathode, and an organic layer, disposed between the anode and the cathode. According to an embodiment, the organic light emitting device is incorporated into one or more device selected from a consumer product, an electronic component module, and/or a lighting panel.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

### Experimental Data:

To determine FOM, the OLED devices were grown on a glass substrate pre-coated with an indium-tin-oxide (ITO) layer having a sheet resistance of 15-Q/sq. Prior to any organic layer deposition or coating, the substrate was degreased with solvents and then treated with an oxygen plasma for 1.5 minutes with 50W at 100 mTorr and with UV ozone for 5 minutes.

The devices in Tables 1-3 were fabricated in high vacuum (< 10⁻⁶ Torr) by thermal evaporation. The anode electrode was 750 Å of indium tin oxide (ITO). The device example had organic layers consisting of, sequentially, from the ITO surface, 100 Å of Compound 1 (HIL), specific thickness of Compound 2 (HTL), 50 Å of HHost (EBL), specific thickness of HHost doped with a percentage of EHost and 12% of Compound 3 (EML), 50 Å of EHost (BL), specific thickness of Compound 4 doped with 35% of Compound 5 (ETL), 10 Å of Compound 4 (EIL) followed by 1,000 Å of Al (Cathode). All devices were encapsulated with a glass lid sealed with an epoxy resin in a nitrogen glove box (<1 ppm of H₂O and O₂) immediately after fabrication with a moisture getter incorporated inside the package. Doping percentages are in volume percent.

When the thickness of HHost in EML is 300 Å, the thickness of Compound 2 in HTL is 250 Å, and the thickness of Compound 4 in ETL is 300 Å. When the thickness of HHost in EML is 350 Å, the thickness of Compound 2 in HTL is 200 Å, and the thickness of compound 4 in ETL is 300 Å. When the thickness of HHost in EML is 400 Å, the thickness of Compound 2 in HTL is 100 Å, and the thickness of Compound 4 in ETL is 275 Å. When the thickness of HHost in EML is 450 Å, the thickness of Compound 2 in HTL is 100 Å, and the thickness of Compound 4 in ETL is 275 Å. When the thickness of HHost in EML is 500 Å, the thickness of Compound 2 in HTL is 100 Å, and the thickness of Compound 4 in ETL is 275 Å.

Provided below is Table 1 containing a summary of FOM calculated for devices with various HHost and EHost mixtures. The thickness of the EML of the first test OLED is 350Å, and the thickness of the EML of the second test OLED is 450Å. The FOM is calculated by dividing **ΔLT/ΔV**, where **ΔLT** = **t2/t1**, where **t1** and **t2** are the LT90 device lifetime of the first and second test OLEDs, respectively, measured at current density of 20 mA/cm² and **ΔV** = **V2-V1,** where **V1** and **V2** are the operating (a.k.a. driving) voltage of the first and second test OLEDs, respectively, measured at current density of 10 mA/cm².

**Table 1**

| **Device** | **HHost** | **EHost** | **EHost [%]** | **ΔV at 10 mA/cm²** | **ΔLT at 20 mA/cm²** | **FOM** |
|---|---|---|---|---|---|---|
| Comparative Device | HH1 | EH1 | 35 | 0.67 | 1.44 | 2.15 |
| Inventive Device 1 | HH2 | EH1 | 50 | 0.41 | 1.06 | 2.57 |
| Inventive Device 2 | HH3 | EH1 | 50 | 0.41 | 1.38 | 3.38 |
| Inventive Device 3 | HH14 | EH1 | 50 | 0.48 | 1.23 | 2.56 |
| Inventive Device 4 | HH10 | EH1 | 50 | 0.51 | 1.24 | 2.43 |
| Inventive Device 5 | HH5 | EH2 | 30 | 0.26 | 1.09 | 4.12 |
| Inventive Device 6 | HH6 | EH2 | 30 | 0.17 | 1.16 | 6.70 |
| Inventive Device 7 | HH3 | EH2 | 30 | 0.50 | 1.24 | 2.48 |
| Inventive Device 8 | HH2 | EH2 | 30 | 0.38 | 1.10 | 2.87 |
| Inventive Device 9 | HH7 | EH2 | 30 | 0.29 | 1.17 | 4.03 |
| Inventive Device 10 | HH8 | EH2 | 30 | 0.45 | 1.18 | 2.63 |
| Inventive Device 11 | HH2 | EH3 | 30 | 0.22 | 1.38 | 6.29 |
| Inventive Device 12 | HH1 | EH3 | 30 | 0.38 | 1.29 | 3.37 |
| Inventive Device 13 | HH3 | EH3 | 30 | 0.30 | 1.13 | 3.71 |
| Inventive Device 14 | HH5 | EH3 | 30 | 0.18 | 1.30 | 7.23 |
| Inventive Device 15 | HH4 | EH3 | 30 | 0.39 | 1.26 | 3.25 |
| Inventive Device 16 | HH6 | EH3 | 30 | 0.19 | 0.99 | 5.19 |
| Inventive Device 17 | HH12 | EH3 | 30 | 0.30 | 1.22 | 4.07 |
| Inventive Device 18 | HH13 | EH3 | 30 | 0.28 | 1.14 | 4.08 |
| Inventive Device 19 | HH8 | EH3 | 30 | 0.04 | 1.07 | 26.63 |
| Inventive Device 20 | HH9 | EH3 | 30 | 0.26 | 1.27 | 4.90 |
| Inventive Device 21 | HH10 | EH3 | 30 | 0.24 | 1.33 | 5.56 |
| Inventive Device 22 | HH11 | EH3 | 30 | 0.29 | 1.18 | 4.06 |
| Inventive Device 23 | HH14 | EH3 | 30 | 0.22 | 1.18 | 5.37 |
| Inventive Device 24 | HH15 | EH3 | 30 | 0.25 | 1.25 | 4.99 |
| Inventive Device 25 | HH16 | EH3 | 30 | 0.35 | 1.09 | 3.11 |
| Inventive Device 26 | HH2 | EH4 | 60 | 0.45 | 1.20 | 2.69 |
| Inventive Device 27 | HH1 | EH5 | 50 | 0.34 | 1.30 | 3.82 |
| Inventive Device 29 | HH1 | EH7 | 30 | 0.28 | 1.05 | 3.75 |
| Inventive Device 30 | HH8 | EH7 | 30 | 0.39 | 1.07 | 2.74 |
| Inventive Device 31 | HH1 | EH8 | 50 | 0.59 | 1.40 | 2.38 |
| Inventive Device 32 | HH1 | EH9 | 30 | 0.37 | 1.19 | 3.23 |
| Inventive Device 33 | HH2 | EH9 | 30 | 0.48 | 1.31 | 2.74 |
| Inventive Device 34 | HH8 | EH9 | 30 | 0.47 | 1.18 | 2.53 |

As shown in Table 1, 33 inventive devices show FOM higher than or equal to the FOM of Comparative Device. For example, we find that Inventive Device 1, containing HH2 and EH1 has a FOM = 2.57, which is higher than the FOM of Comparative Device, containing HH1 and EH1, which is equal to 2.50.

Provided below is Table 2 containing a summary of FOM values calculated for devices with various HHost and EHost mixtures. The thickness of the EML of the first test OLED is 300Å, and the thickness of the EML of the second test OLED is 400Å. The FOM is calculated by dividing **ΔLT/ΔV**, where **ΔLT** = **t2/t1**, where **t1** and **t2** are the LT90 device lifetime of the first and second test OLEDs, respectively, measured at current density of 20 mA/cm² and **ΔV = V2-V1**, where **V1** and **V2** are the operating voltage of the first and second test OLEDs, respectively, measured at current density of 10 mA/cm².

**Table 2**

| **Device** | **HHost** | **EHost** | **EHost [%]** | **ΔV at 10 mA/cm²** | **ΔLT at 20 mA/cm²** | **FOM** |
|---|---|---|---|---|---|---|
| Comparative Device | HH1 | EH1 | 35 | 0.62 | 1.48 | 2.39 |
| Inventive Device 1 | HH2 | EH1 | 50 | 0.39 | 1.13 | 2.91 |
| Inventive Device 2 | HH3 | EH1 | 50 | 0.38 | 1.46 | 3.84 |
| Inventive Device 3 | HH2 | EH2 | 30 | 0.34 | 1.23 | 3.61 |
| Inventive Device 4 | HH7 | EH2 | 30 | 0.29 | 1.39 | 4.79 |
| Inventive Device 5 | HH8 | EH2 | 30 | 0.43 | 1.21 | 2.80 |
| Inventive Device 6 | HH5 | EH3 | 30 | 0.18 | 1.39 | 7.57 |
| Inventive Device 7 | HH4 | EH3 | 30 | 0.37 | 1.28 | 3.50 |
| Inventive Device 8 | HH6 | EH3 | 30 | 0.16 | 0.97 | 5.91 |
| Inventive Device 9 | HH12 | EH3 | 30 | 0.29 | 1.19 | 4.10 |
| Inventive Device 10 | HH13 | EH3 | 30 | 0.24 | 1.17 | 4.86 |
| Inventive Device 11 | HH8 | EH3 | 30 | 0.13 | 1.10 | 8.46 |
| Inventive Device 12 | HH9 | EH3 | 30 | 0.21 | 1.30 | 6.19 |
| Inventive Device 13 | HH10 | EH3 | 30 | 0.22 | 1.21 | 6.20 |
| Inventive Device 14 | HH11 | EH3 | 30 | 0.26 | 1.13 | 4.33 |
| Inventive Device 15 | HH1 | EH7 | 30 | 0.36 | 1.11 | 3.08 |
| Inventive Device 16 | HH2 | EH9 | 30 | 0.44 | 1.40 | 3.16 |
| Inventive Device 17 | HH8 | EH9 | 30 | 0.38 | 1.22 | 3.23 |

As shown in Table 2, using different EML thicknesses for the first and the second test OLEDs to calculate the FOM shows that many of the devices in Table 1 have higher FOM than the Comparative Device. For example, we find that Inventive Device 1, containing HH2 and EH1, has a FOM = 2.91, that is higher than the FOM of the Comparative Device, containing HH1 and EH1, which has FOM = 2.39.

Provided below is Table 3 containing a summary of FOM calculated for devices with various HHost and EHost mixtures. The thickness of the EML of the first test OLED is 350Å, and the thickness of the EML of the second test OLED is 450Å. The FOM is calculated by dividing **ΔLT/ΔV**, where **ΔLT = t2/t1**, where **t1** and **t2** are the LT90 device lifetime of the first and second test OLEDs, respectively, calculated at a luminance of 1000 cd/m² of and **ΔV = V2-V1**, where **V1** and **V2** are the operating voltage of the first and second test OLEDs, respectively, calculated at a luminance of 1000 cd/m².

**Table 3**

| **Device** | **HHost** | **EHost** | **EHost [%]** | **ΔV at 10 mA/cm²** | **ΔLT at 20 mA/cm²** | **FOM** |
|---|---|---|---|---|---|---|
| Comparative Device | HH1 | EH1 | 35 | 0.55 | 1.42 | 2.58 |
| Inventive Device 1 | HH2 | EH1 | 50 | 0.31 | 1.07 | 3.40 |
| Inventive Device 2 | HH14 | EH1 | 50 | 0.39 | 1.16 | 2.98 |
| Inventive Device 3 | HH5 | EH2 | 30 | 0.24 | 1.07 | 4.54 |
| Inventive Device 4 | HH6 | EH2 | 30 | 0.26 | 0.98 | 3.41 |
| Inventive Device 5 | HH3 | EH2 | 30 | 0.39 | 1.27 | 3.22 |
| Inventive Device 6 | HH2 | EH2 | 30 | 0.28 | 1.23 | 4.43 |
| Inventive Device 7 | HH7 | EH2 | 30 | 0.26 | 1.09 | 4.20 |
| Inventive Device 8 | HH8 | EH2 | 30 | 0.36 | 1.22 | 3.40 |
| Inventive Device 9 | HH2 | EH3 | 30 | 0.17 | 1.38 | 8.03 |
| Inventive Device 10 | HH1 | EH3 | 30 | 0.28 | 1.36 | 4.78 |
| Inventive Device 11 | HH3 | EH3 | 30 | 0.25 | 1.08 | 4.31 |
| Inventive Device 12 | HH5 | EH3 | 30 | 0.16 | 1.26 | 7.85 |
| Inventive Device 13 | HH4 | EH3 | 30 | 0.34 | 1.17 | 3.49 |
| Inventive Device 14 | HH12 | EH3 | 30 | 0.29 | 1.12 | 3.86 |
| Inventive Device 15 | HH13 | EH3 | 30 | 0.24 | 1.10 | 4.56 |
| Inventive Device 16 | HH8 | EH3 | 30 | 0.13 | 0.92 | 7.09 |
| Inventive Device 17 | HH9 | EH3 | 30 | 0.22 | 1.11 | 5.06 |
| Inventive Device 18 | HH10 | EH3 | 30 | 0.23 | 1.22 | 5.31 |
| Inventive Device 19 | HH11 | EH3 | 30 | 0.32 | 1.01 | 3.17 |
| Inventive Device 20 | HH14 | EH3 | 30 | 0.17 | 1.19 | 7.01 |
| Inventive Device 21 | HH15 | EH3 | 30 | 0.22 | 1.15 | 5.22 |
| Inventive Device 22 | HH16 | EH3 | 30 | 0.31 | 1.01 | 3.26 |
| Inventive Device 23 | HH2 | EH4 | 60 | 0.37 | 1.26 | 3.40 |
| Inventive Device 24 | HH1 | EH5 | 50 | 0.32 | 1.17 | 3.64 |
| Inventive Device 26 | HH1 | EH7 | 30 | 0.22 | 0.99 | 4.51 |
| Inventive Device 27 | HH8 | EH7 | 30 | 0.29 | 1.03 | 3.54 |
| Inventive Device 28 | HH1 | EH8 | 50 | 0.46 | 1.42 | 3.06 |
| Inventive Device 29 | HH1 | EH9 | 30 | 0.29 | 1.17 | 4.11 |
| Inventive Device 30 | HH2 | EH9 | 30 | 0.39 | 1.28 | 3.25 |
| Inventive Device 31 | HH8 | EH9 | 30 | 0.41 | 1.07 | 2.59 |

As shown in Table 3, calculating the FOM based on constant luminance values shows that many of the devices in Table 1 have higher FOM than the Comparative Device. For example, we find that Inventive Device 1, containing HH2 and EH1, has a FOM = 3.40, that is higher than the FOM of the Comparative Device, containing HH1 and EH1, which has FOM = 2.58.

The devices in Tables 4 were fabricated in high vacuum (< 10⁻⁶ Torr) by thermal evaporation. The anode electrode was 750 Å of indium tin oxide (ITO). The device example had organic layers consisting of, sequentially, from the ITO surface, 100 Å of Compound 1 (HIL), 250 of Å Compound 2 (HTL), 50 Å of HHost (EBL), specific thickness of HHost doped with a percentage of EHost and 12% of Compound 3 (EML), 50 Å of EHost (BL), 300 Å of Compound 4 doped with 35% of Compound 5 (ETL), 10 Å of Compound 4 (EIL) followed by 1,000 Å of Al (Cathode). All devices were encapsulated with a glass lid sealed with an epoxy resin in a nitrogen glove box (<1 ppm of H₂O and O₂) immediately after fabrication with a moisture getter incorporated inside the package. Doping percentages are in volume percent.

Provided below is Table 4 containing a summary of FOM calculated for devices with various HHost and EHost mixtures. The thickness of the EML of the first test OLED is 350Å, and the thickness of the EML of the second test OLED is 450Å. The FOM is calculated by dividing **ΔLT/ΔV**, where **ΔLT =** t2/t1, where t1 and t2 are the LT90 device lifetime of the first and second test OLEDs, respectively, measured at current density of 20 mA/cm² and **ΔV = V2-V1**, where **V1** and **V2** are the operating voltage of the first and second test OLEDs, respectively, measured at current density of 10 mA/cm².

| **Device** | **HHost** | **EHost** | **EHost [%]** | **ΔV at 10 mA/cm²** | **ΔLT at 20 mA/cm²** | **FOM** |
|---|---|---|---|---|---|---|
| Comparative Device | HH1 | EH1 | 35 | 0.60 | 1.26 | 2.10 |
| Inventive Device 1 | HH2 | EH1 | 50 | 0.54 | 1.13 | 2.10 |
| Inventive Device 2 | HH5 | EH3 | 30 | 0.38 | 1.33 | 3.47 |
| Inventive Device 3 | HH3 | EH3 | 30 | 0.38 | 1.21 | 3.20 |

As shown in Table 4, calculating the FOM based on devices that have constant transport layer thicknesses does not change the conclusions. For example, we find that Inventive Device 1, containing HH2 and EH1, has a FOM = 2.10, that is equal to the FOM of the Comparative Device, containing HH1 and EH1.

The devices in Tables 5, were fabricated in high vacuum (< 10⁻⁶ Torr) by thermal evaporation. The anode electrode was 750 Å of indium tin oxide (ITO). The device example had organic layers consisting of, sequentially, from the ITO surface, 100 Å of Compound 1 (HIL), specific thickness of Compound 2 (HTL), 50 Å of HH1 (EBL), specific thickness of HH1 doped with a percentage of EH1 and 12% of Compound 3 (EML), 50 Å of EH1 (BL), specific thickness of Compound 4 doped with 35% of Compound 5 (ETL), 10 Å of Compound 4 (EIL) followed by 1,000 Å of A1 (Cathode). All devices were encapsulated with a glass lid sealed with an epoxy resin in a nitrogen glove box (<1 ppm of H₂O and O₂) immediately after fabrication with a moisture getter incorporated inside the package. Doping percentages are in volume percent.

When the thickness of HH1 in EML is 300 Å, the thickness of Compound 2 in HTL is 250 Å, and the thickness of Compound 4 in ETL is 300 Å. When the thickness of HH1 in EML is 350 Å, the thickness of Compound 2 in HTL is 200 Å, and the thickness of Compound 4 in ETL is 300 Å. When the thickness of HH1 in EML is 400 Å, the thickness of Compound 2 in HTL is 100 Å, and the thickness of Compound 4 in ETL is 275 Å. When the thickness of HH1 in EML is 450 Å, the thickness of Compound 2 in HTL is 100 Å, and the thickness of Compound 4 in ETL is 275 Å. When the thickness of HH1 in EML is 500 Å, the thickness of Compound 2 in HTL is 100 Å, and the thickness of Compound 4 in ETL is 275 Å.

Provided below is Table 5 containing a summary of FOM calculated for devices with HH1 and a varying doping percentage of EH1. The thickness of the EML of the first test OLED is 350Å, and the thickness of the EML of the second test OLED is 450Å. The FOM is calculated by dividing **ΔLT / ΔV**, where **ΔLT** = **t2/t1**, where **t1** and **t2** are the LT₉₀ device lifetime of the first and second tes tOLEDs, respectively, measured at current density of 20 mA/cm² and **ΔV = V2-V1,** where V1 and **V2** are the operating voltage of the first and second test OLEDs, respectively, measured at current density of 10 mA/cm².

| **Device** | **HHost** | **EHost** | **EHost [%]** | **ΔV at 10 mA/cm²** | **ΔLT at 20 mA/cm²** | **F.O.M** |
|---|---|---|---|---|---|---|
| Device 1 | HH1 | EH1 | 35 | 0.67 | 1.44 | 2.15 |
| Device 2 | HH1 | EH1 | 50 | 0.50 | 1.17 | 2.34 |

As shown in Table 5, significantly changing the HH1: EH1 ratio in the EML from 1.5:1.0 to 0.8:1.0 only changed the FOM by around 10% which showcases the robustness of FOM as a metric.

The compounds utilized for the test OLEDs in the above-mentioned experiments are:

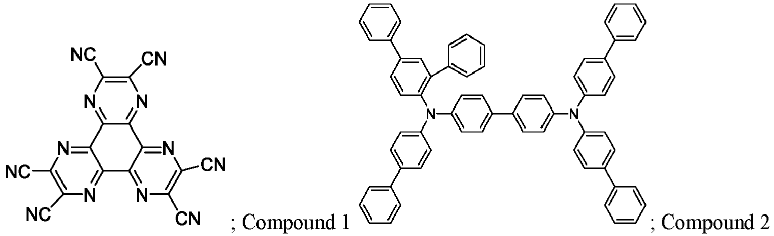

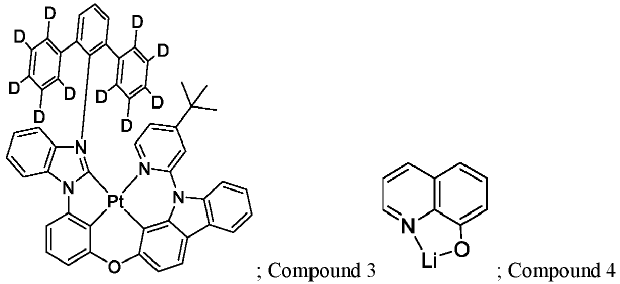

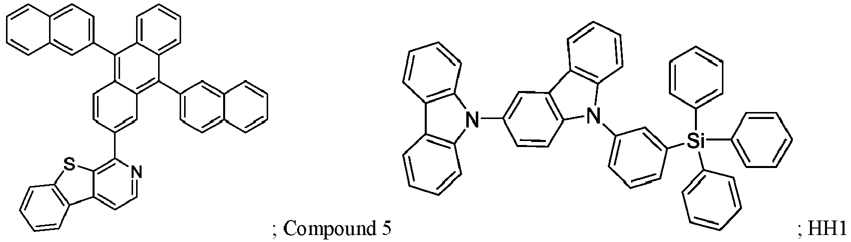

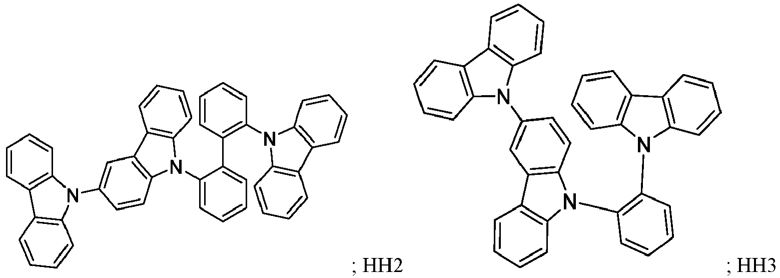

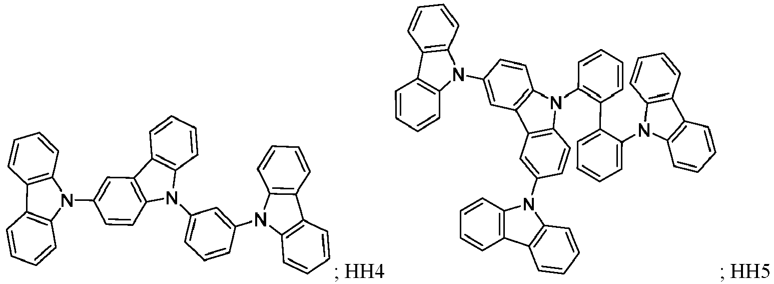

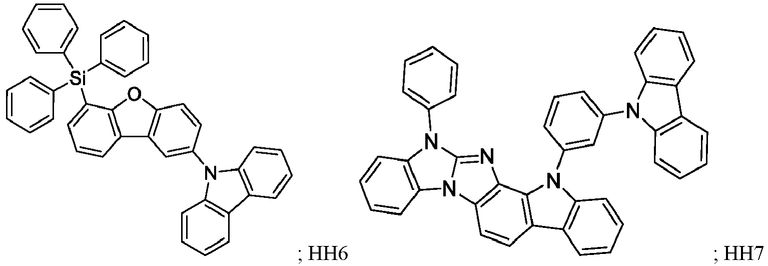

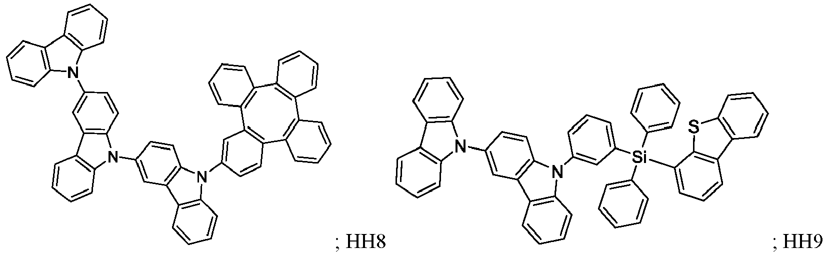

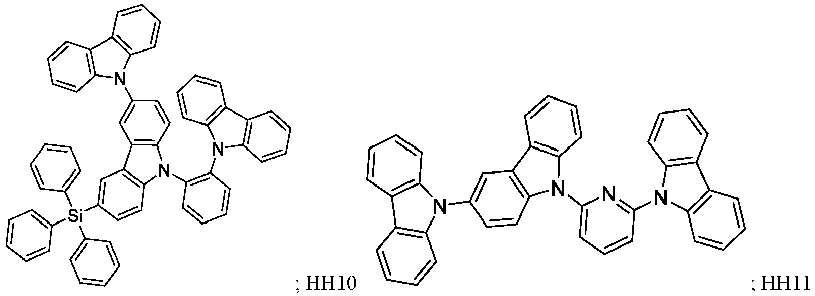

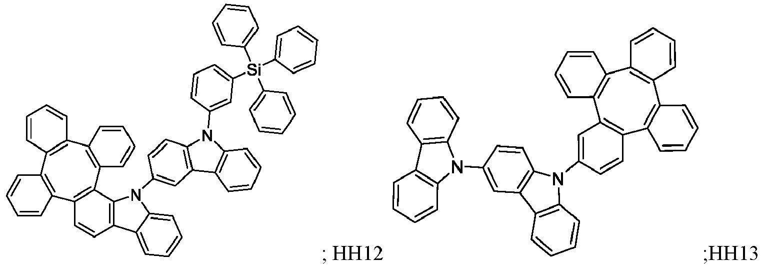

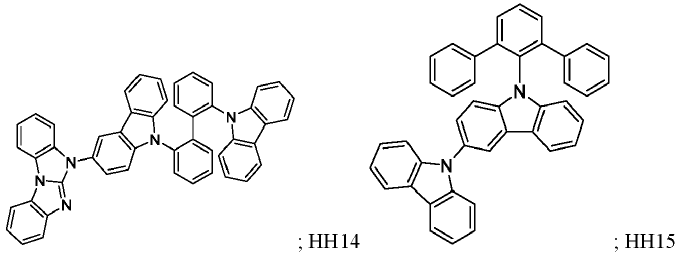

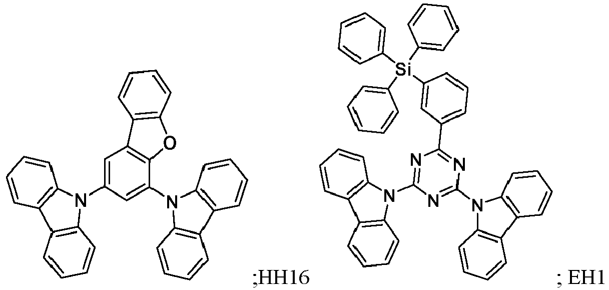

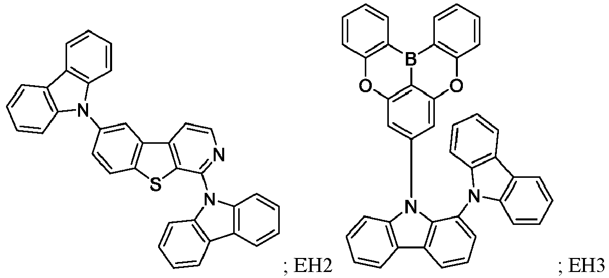

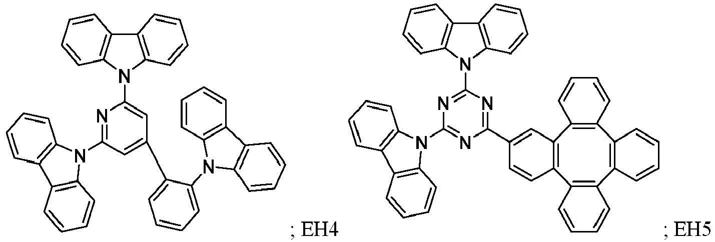

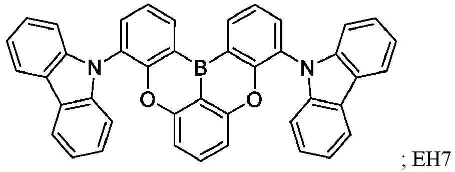

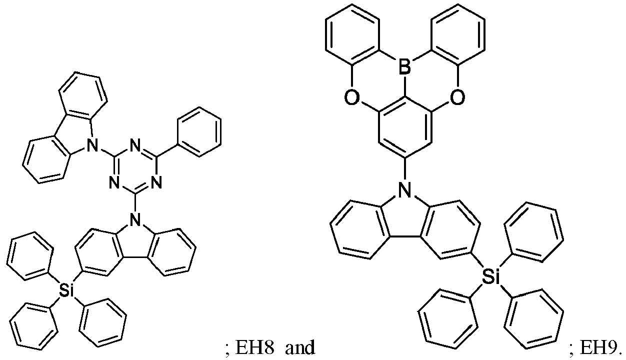

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.
The invention is further described by the following numbered aspects:
1. An organic light emitting device (OLED) comprising: an anode; a cathode; and an organic layer disposed between the anode and the cathode, wherein the organic layer comprises a light emitting layer (EML); wherein the EML is formed from an Emissive System where the EML has a FOM value equal to or larger than 2.50.
2. The OLED of aspect 1, wherein the EML comprises at least one hole transporting host, and/or at least one electron transporting host.
3. The OLED of aspect 1 or 2, wherein the EML comprises a first host material, a second host material and an emitting material.
4. The OLED of aspect 3, wherein the first host material has an electron transport moiety and a |LUMO energy| < 2.8 eV; and/or wherein the second host material has a hole transport moiety and |HOMO energy| > 5.3 eV.
5. The OLED of aspect 1, wherein the lowest triplet energy among all host materials is ≥ 2.1 eV.
6. The OLED of aspect 4, wherein the hole transporting moiety of the second host material is selected from the group consisting of: 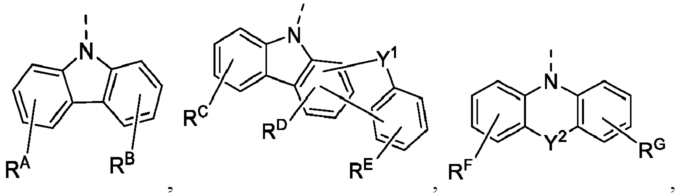 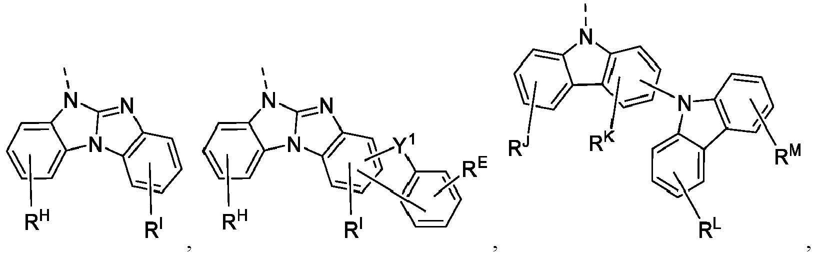 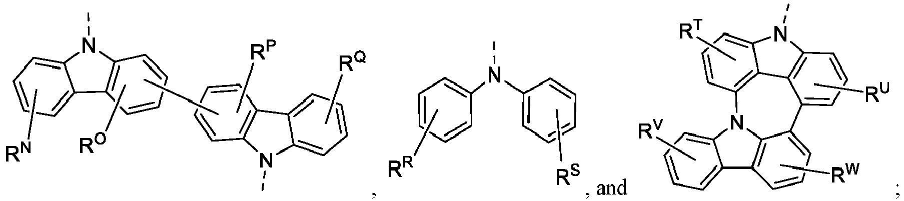 wherein:
   each of Y¹ and Y² is independently selected from the group consisting of BR, BRR', NR, PR, P(O)R, O, S, Se, C=O, C=S, C=Se, C=NR, C=CRR', S=O, SO₂, CRR', SiRR', and GeRR';
   each of R^{A} to R^{W} is independently monosubstituted to the maximum allowable substitution, or no substitution; each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
   two adjacent of R, R', or R^{A} to R^{W} are optionally joined or fused to form a ring.
7. The OLED of aspect 4, wherein the electron transporting moiety of the first host material is selected from the group consisting of: 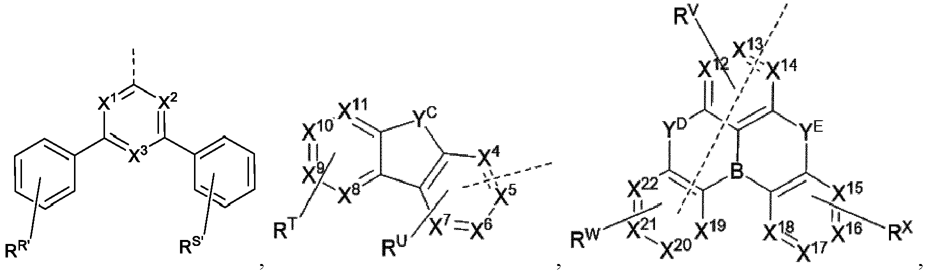 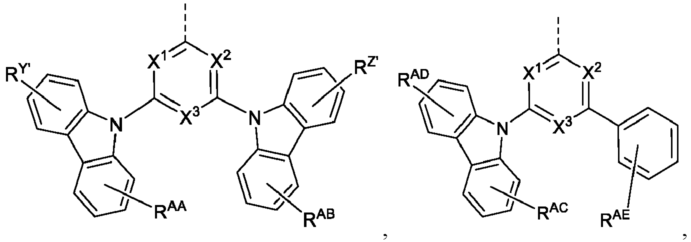 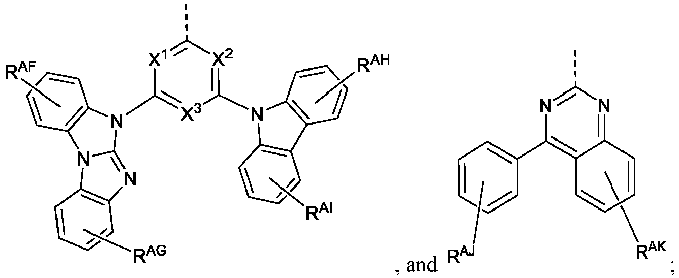 wherein: each of X¹ to X²² is independently C or N; at least one of X¹ to X³ is N; at least one of X⁴ to X¹¹ is N; each of Y^{C}, Y^{D}, and Y^{E} is independently selected from the group consisting of BR, BRR', NR, PR, P(O)R, O, S, Se, C=O, C=S, C=Se, C=NR, C=CRR', S=O, SO₂, CRR', SiRR', and GeRR'; each of R^{R}' to R^{Z}' and R^{AA} to R^{AK} is independently monosubstituted to the maximum allowable substitution, or no substitution; each R, R', R^{R}' to R^{Z'}, and R^{AA} to R^{AK} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; two adjacent of R, R', R^{R'} to R^{Z'}, or R^{AA} to R^{AK} are optionally joined or fused to form a ring.
8. The OLED of aspect 1, wherein the emitter material is selected from the group consisting of a phosphorescent emitter, a fluorescent emitter, a TADF emitter, and combinations thereof.
9. The OLED of aspect 1, wherein the emitter material is capable of emitting light from a triplet excited state to a ground singlet state at room temperature.
10. The OLED of aspect 1, wherein the emitter material is a metal coordination complex having a metal-carbon bond; and/or a metal-nitrogen bond.
11. The OLED of aspect 10, wherein the metal is selected from the group consisting of Ir, Rh, Re, Ru, Os, Pt, Au, and Cu.
12. The OLED of aspect 1, wherein the emitter material has a formula of M(L¹)ₓ(L²)_{y}(L³)_{z}; wherein L¹, L², and L³ can be the same or different; wherein x is 1, 2, or 3; wherein y is 0, 1, or 2; wherein z is 0, 1, or 2; wherein M is a metal and x+y+z is the oxidation state of the metal M; wherein L¹ is selected from the group consisting of: 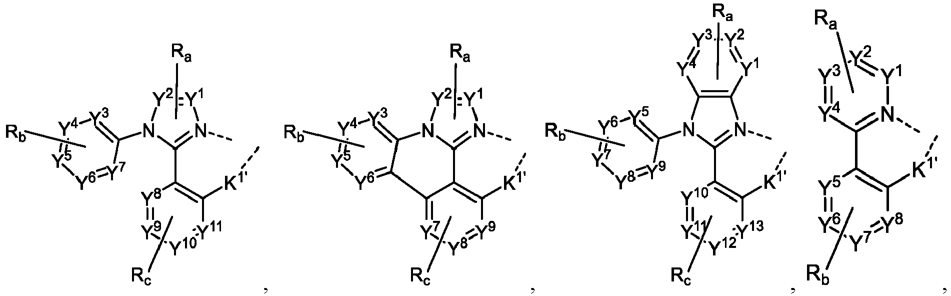 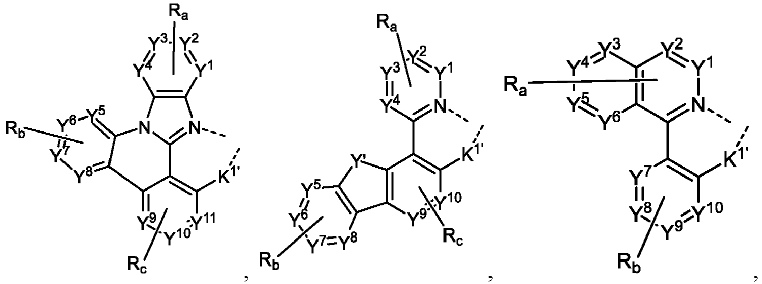 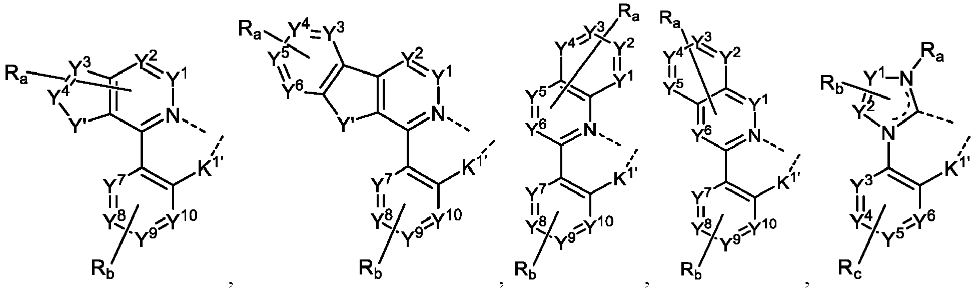 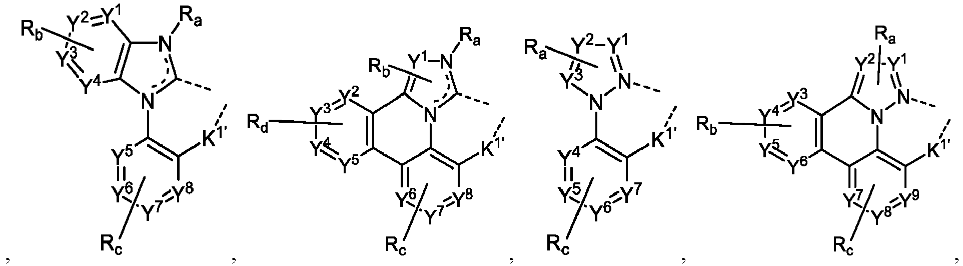 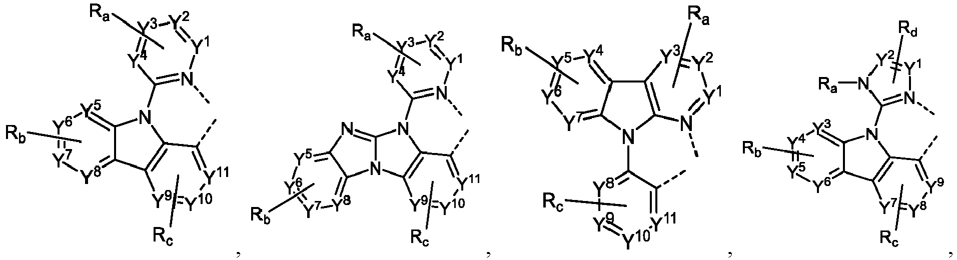 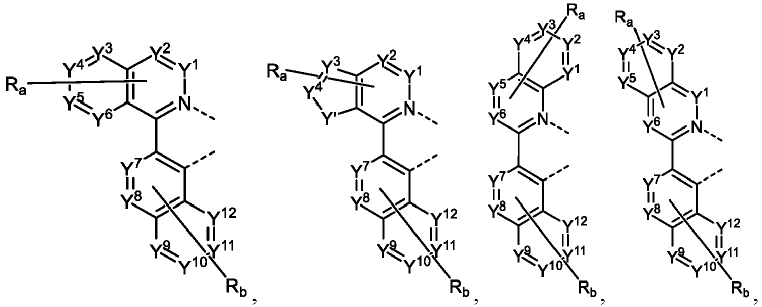 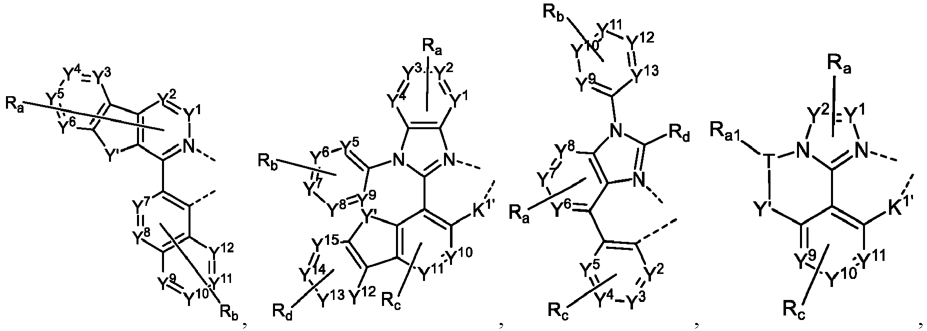 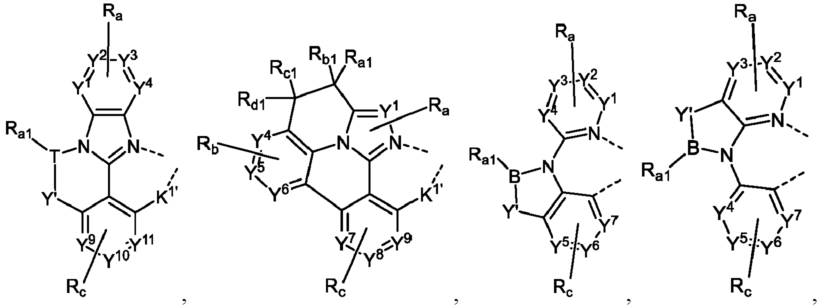 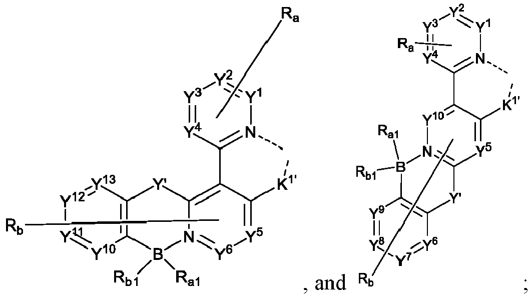 wherein L² and L³ are independently selected from the group consisting of 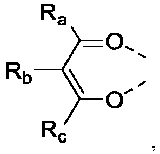 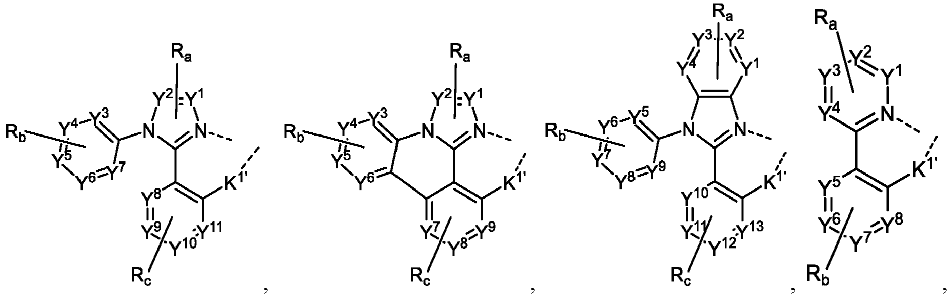 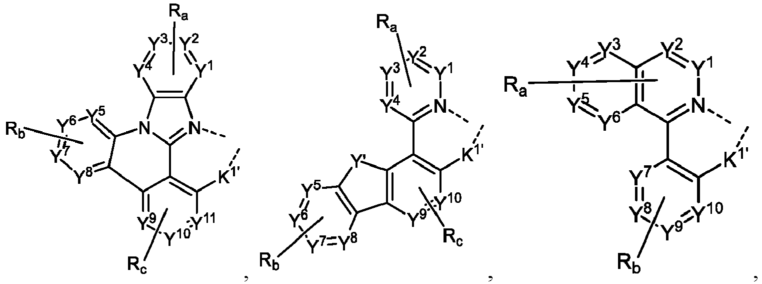 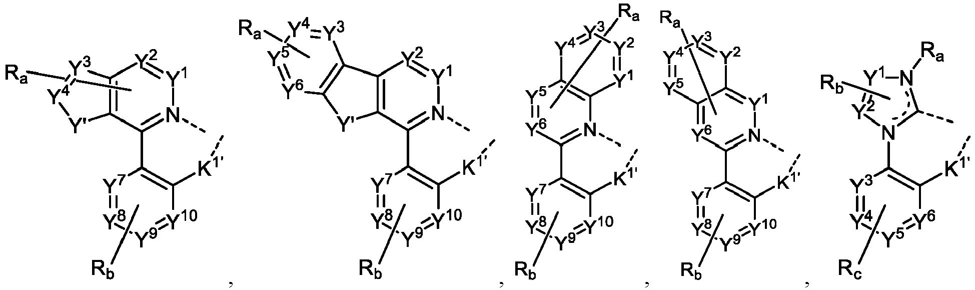 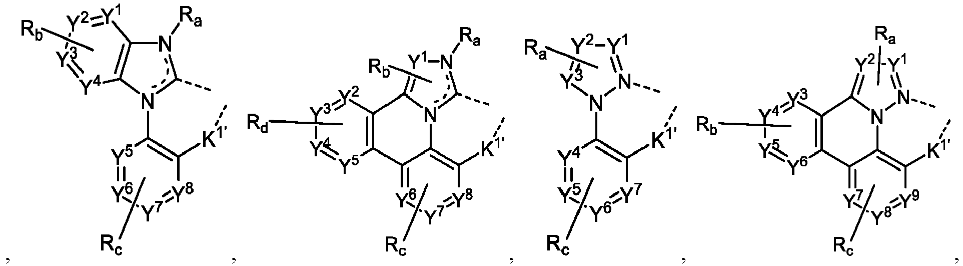 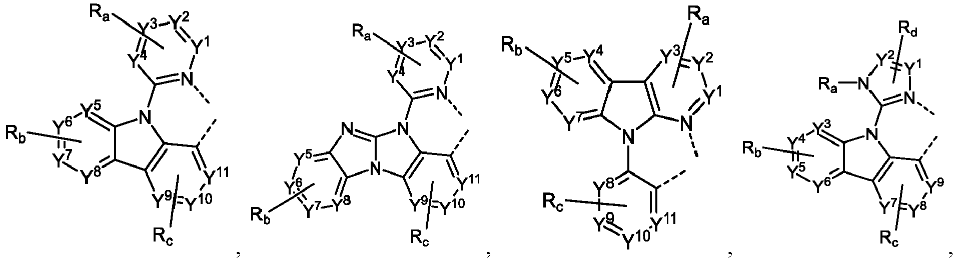 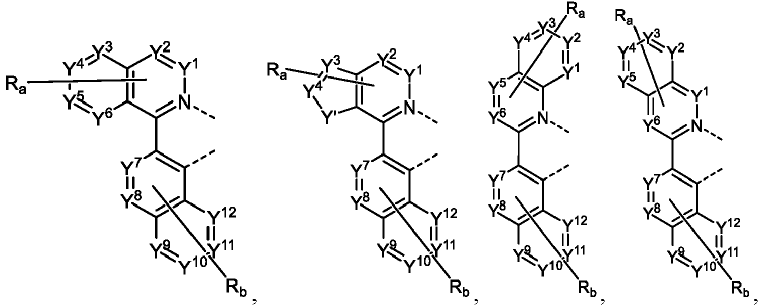 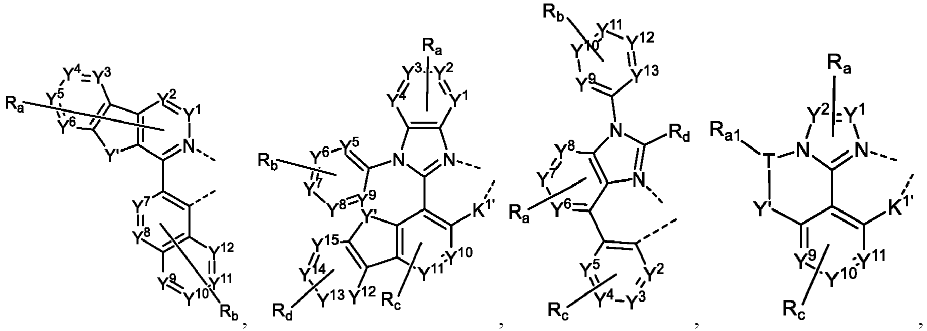 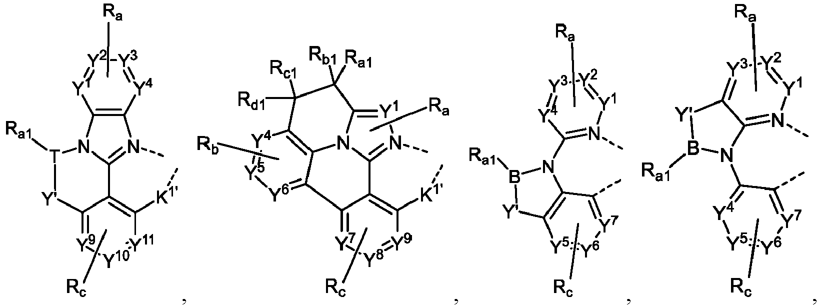 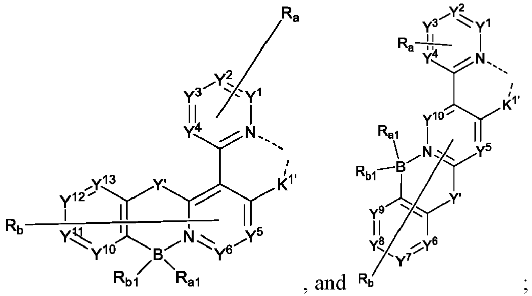 wherein T is selected from the group consisting of B, Al, Ga, and In; wherein K^{1'} is a direct bond or is selected from the group consisting of NRₑ, PRₑ, O, S, and Se; wherein each Y¹ to Y¹³ are independently selected from the group consisting of carbon and nitrogen; wherein Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SOz, CRₑR_{f}, SiRₑR_{f}, and GeRₑR_{f}; wherein Rₑ and R_{f} can be fused or joined to form a ring; wherein each Rₐ, R_{b}, R_{c}, and R_{d} can independently represent from mono to the maximum possible number of substitutions, or no substitution; wherein each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and wherein any two Rₐ₁, R_{b1}, R_{c1}, R_{d1}, Rₐ, R_{b}, R_{c}, and R_{d} can be fused or joined to form a ring or form a multidentate ligand.
13. The OLED of aspect 1, wherein the emitter material has a formula selected from the group consisting of: 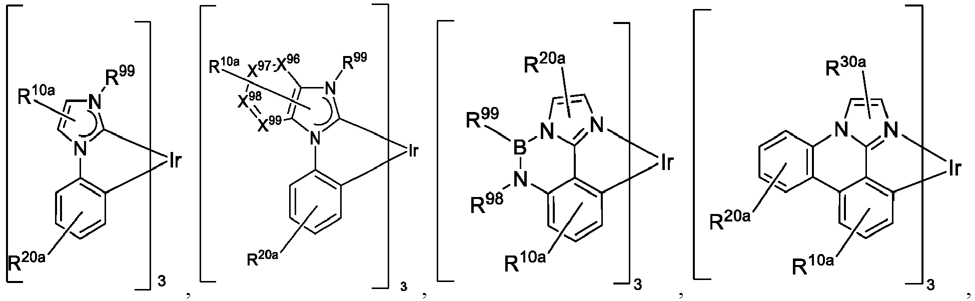 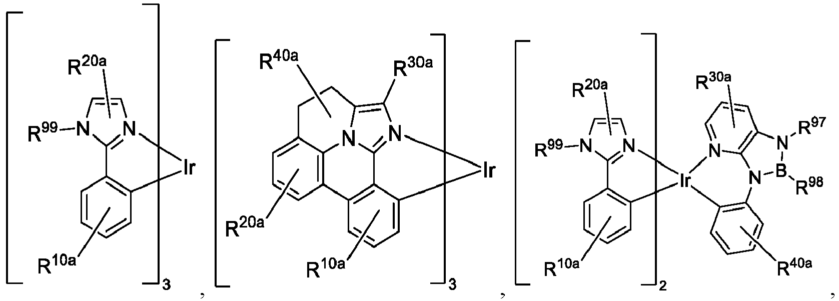 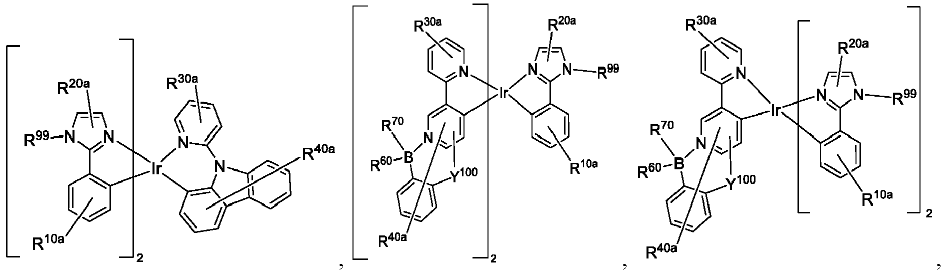 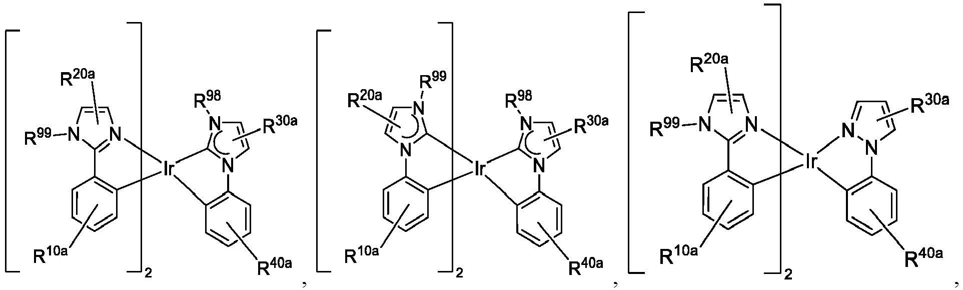 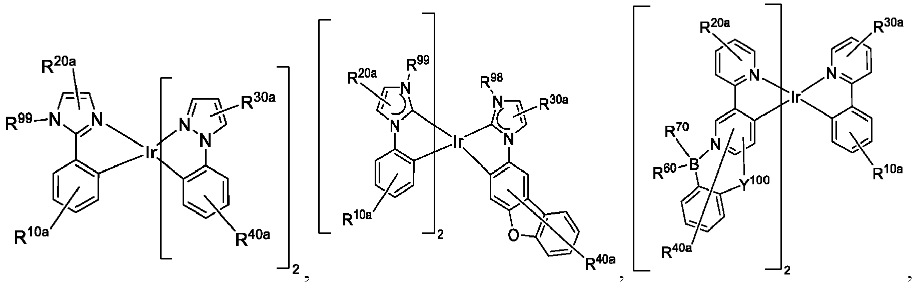 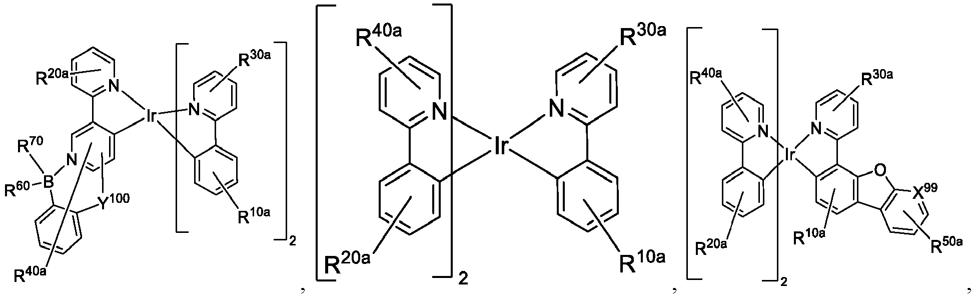 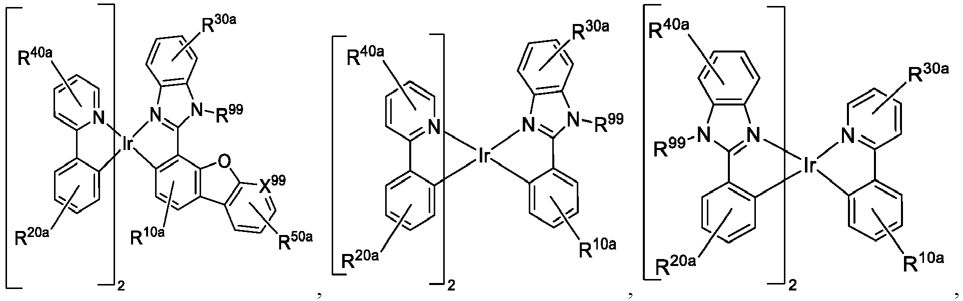 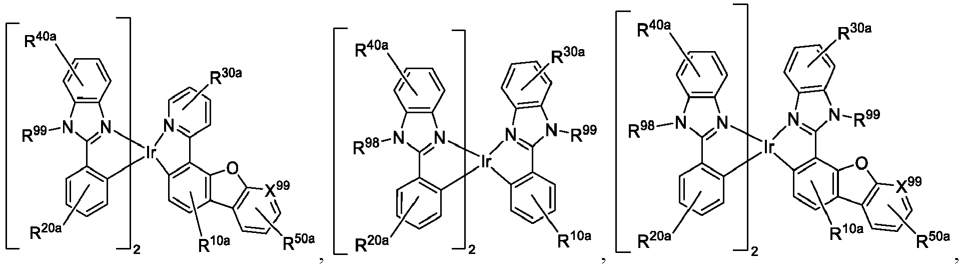 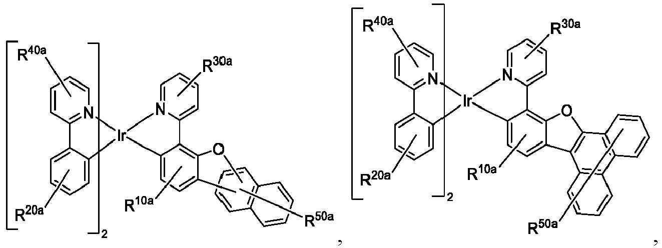 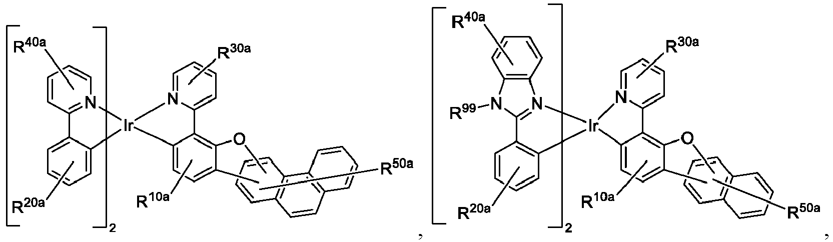 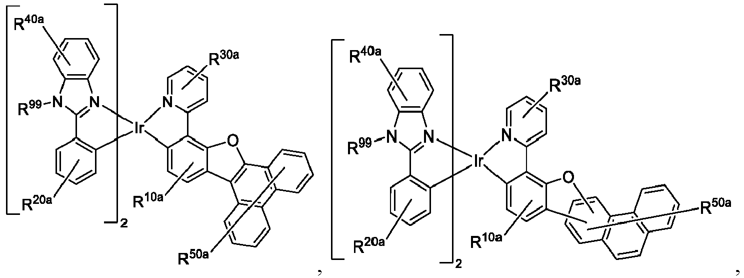 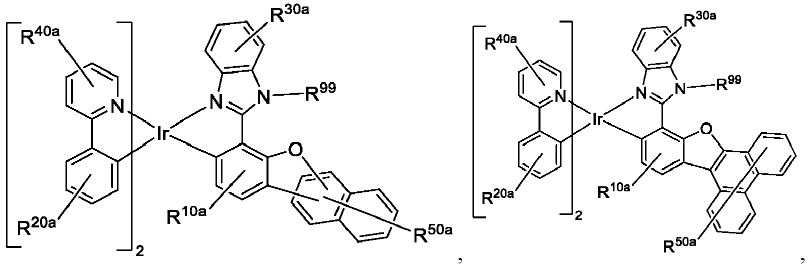 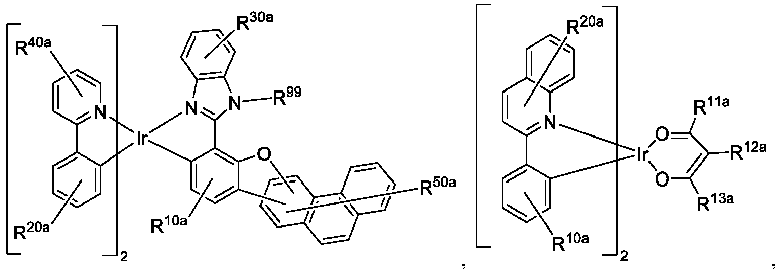 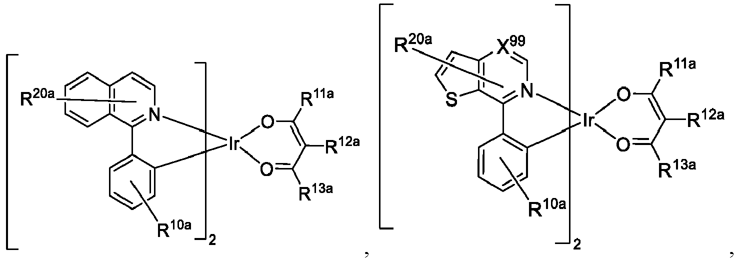 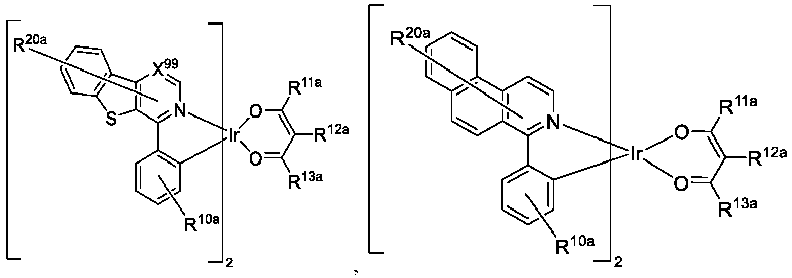 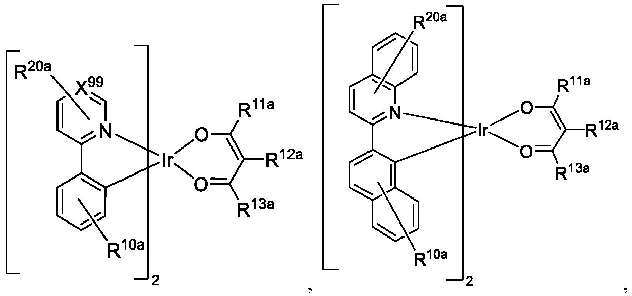 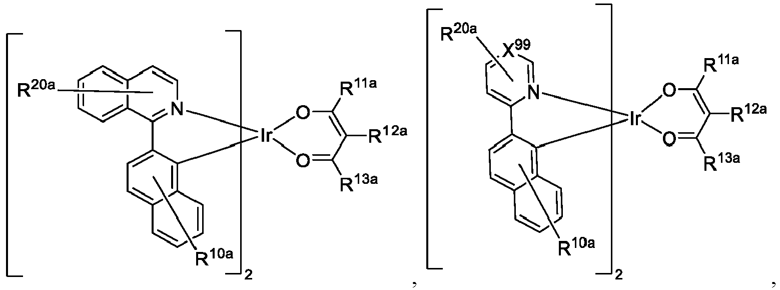 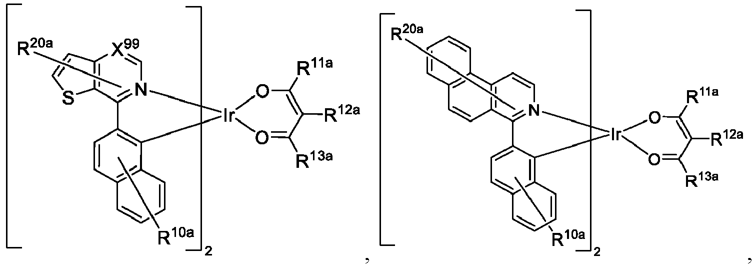 and 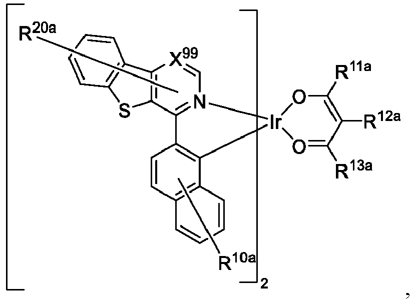 wherein each of X⁹⁶ to X⁹⁹ is independently C or N; each Y¹⁰⁰ is independently selected from the group consisting of a NR", O, S, and Se; each of R^{10a}, R^{20a}, R^{30a}, R^{40a}, and R^{50a} independently represents mono substitution, up to the maximum substitutions, or no substitution; each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof.
14. The OLED of aspect 1, wherein the emitting material has a formula selected from the group consisting of: 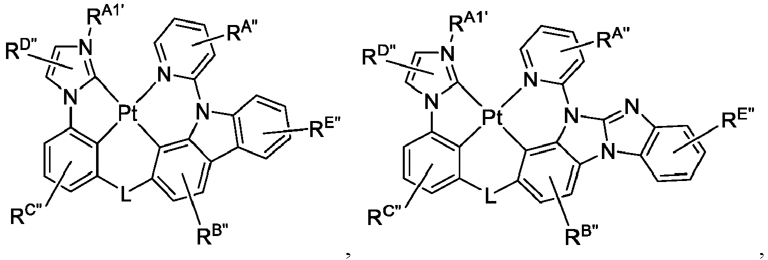 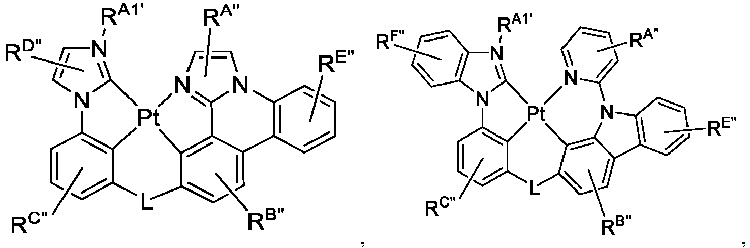 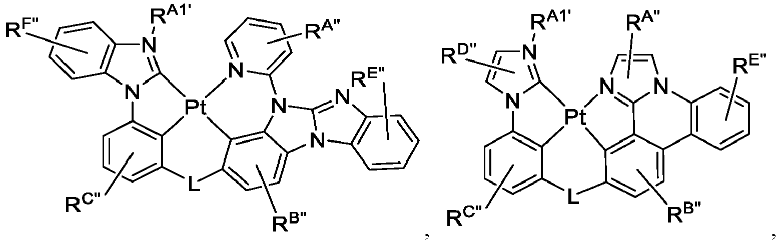 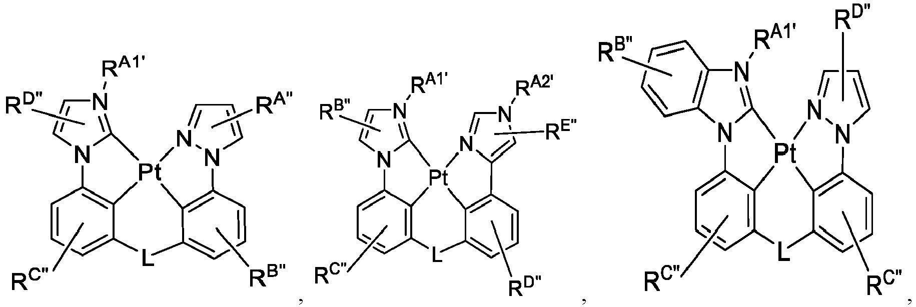 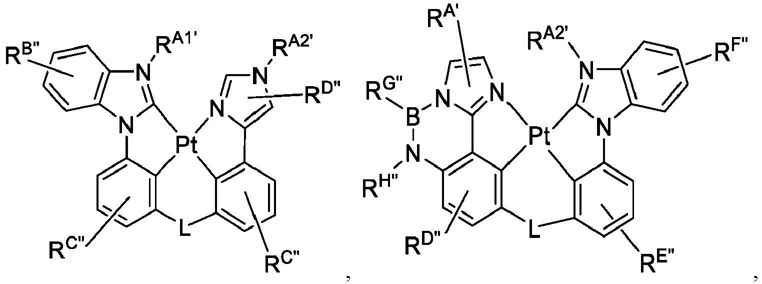 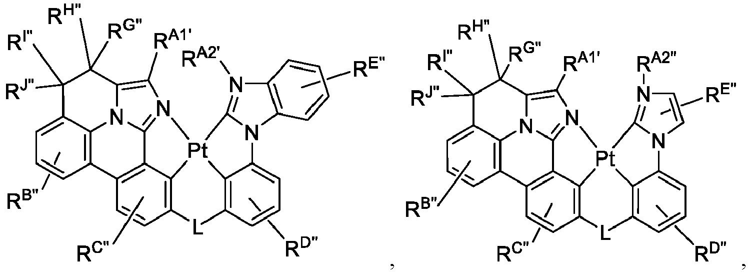 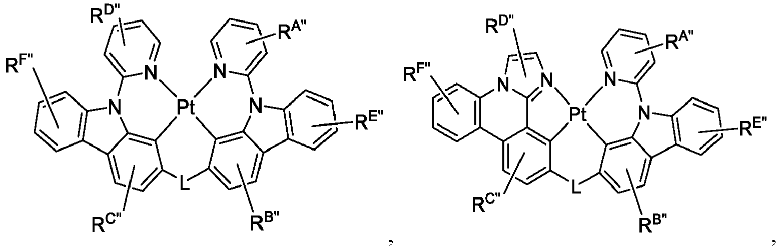 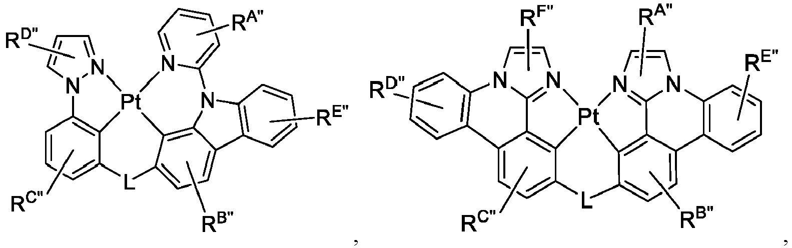 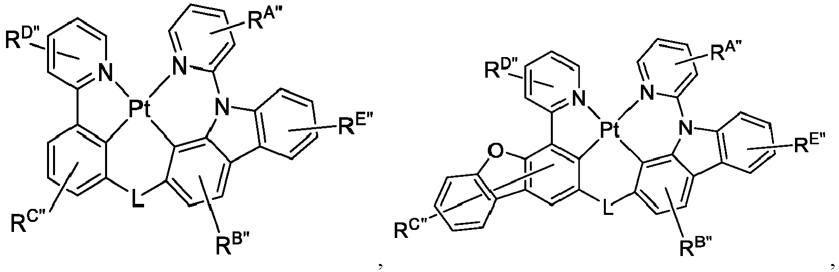 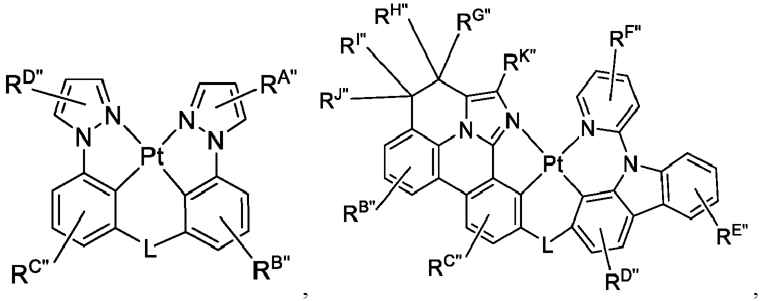 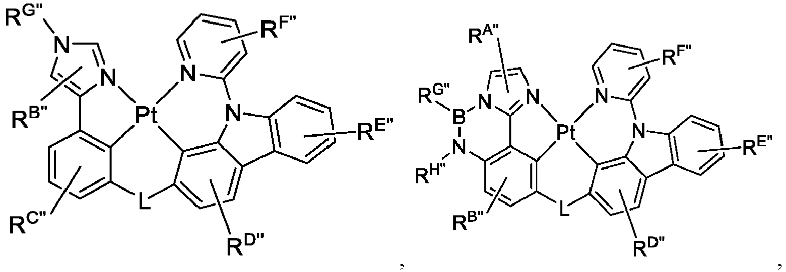 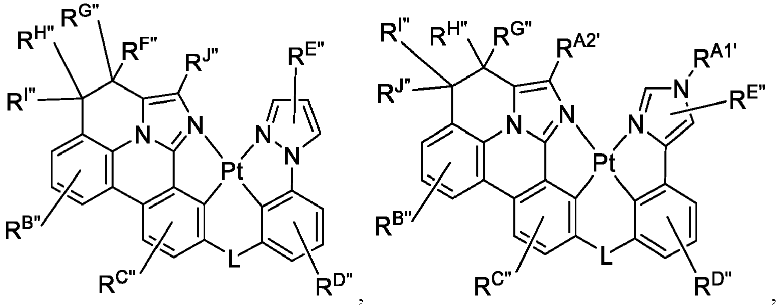 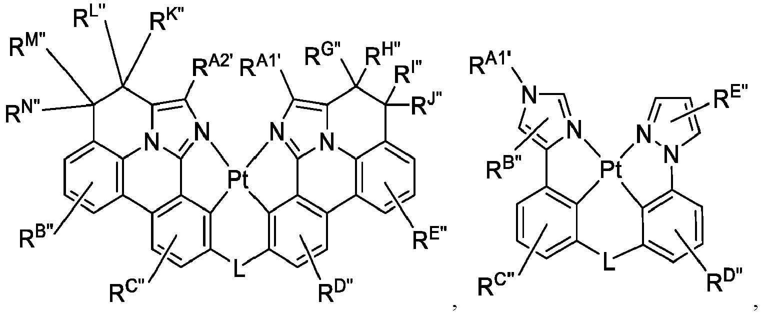 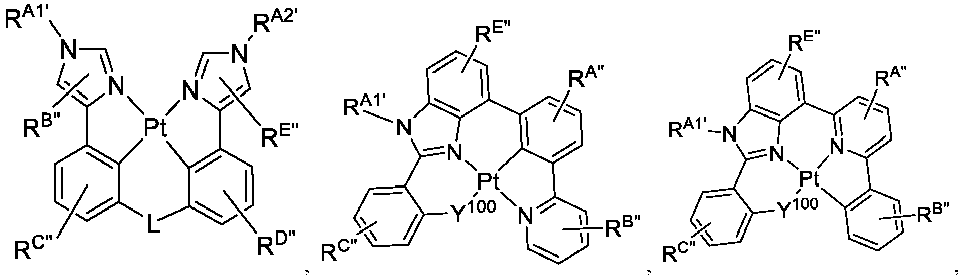 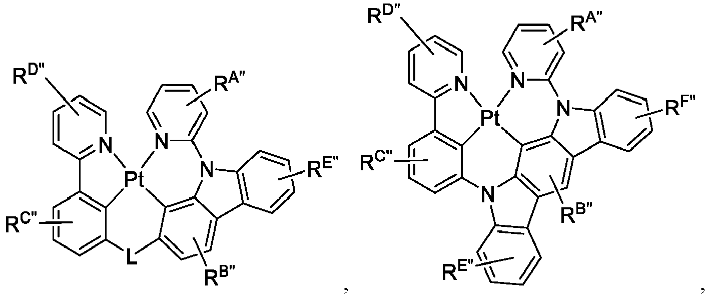 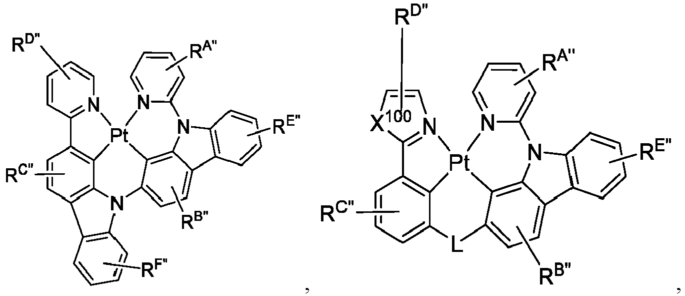 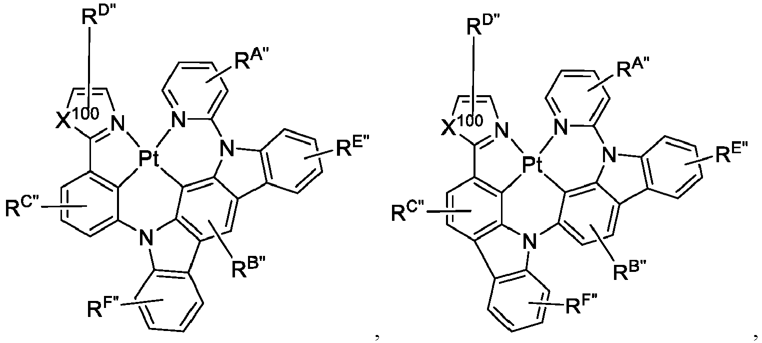 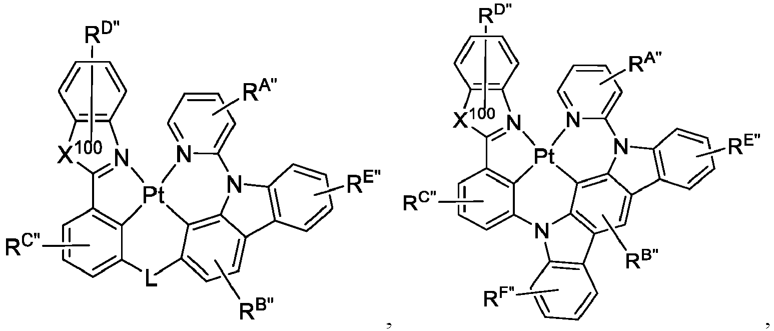 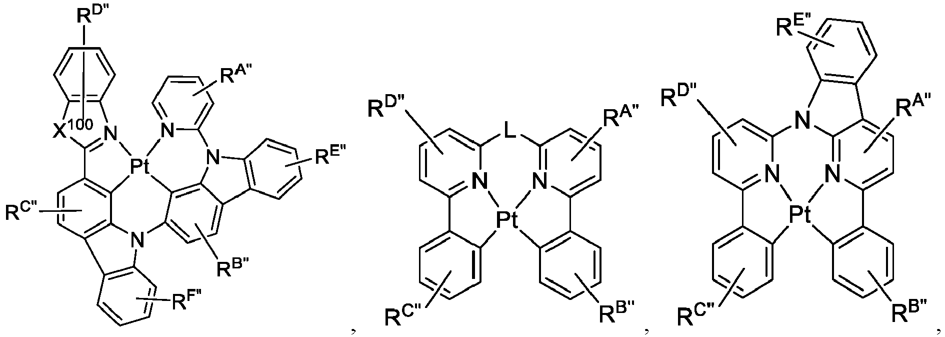 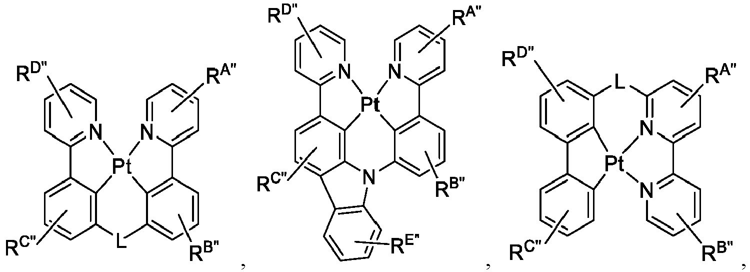 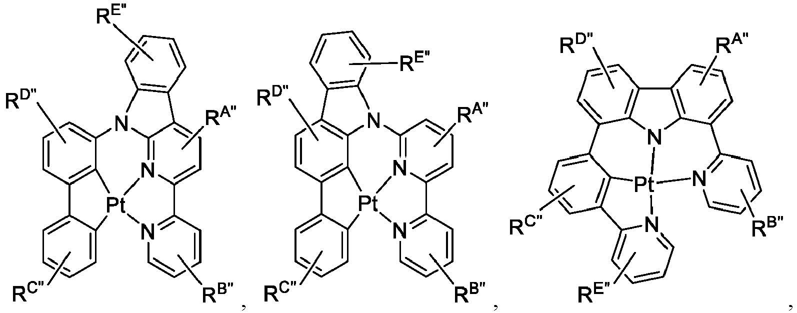 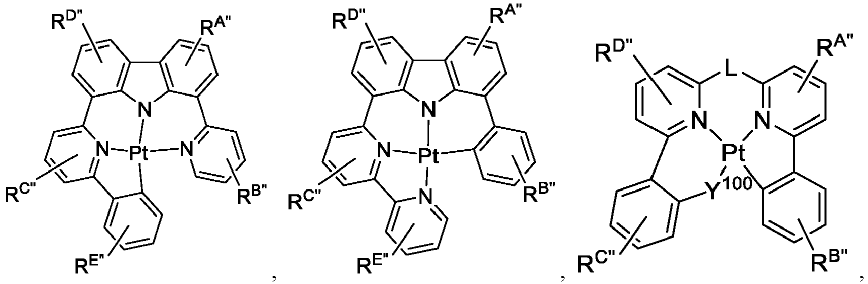 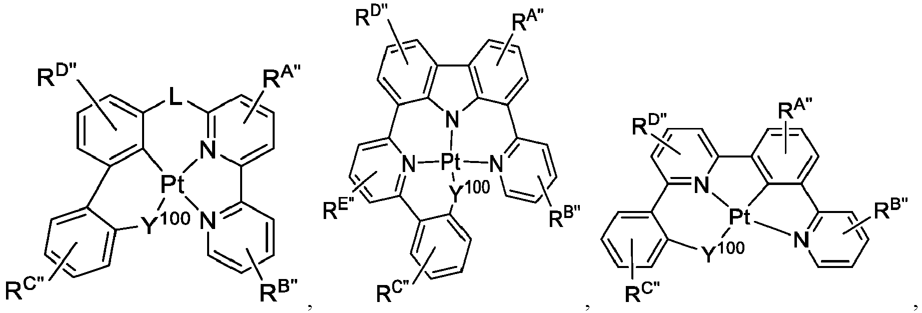 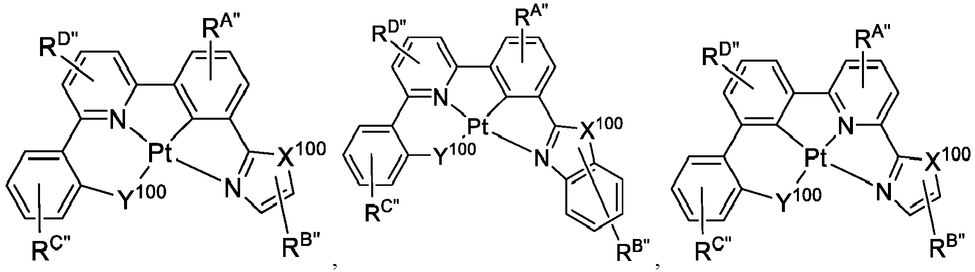 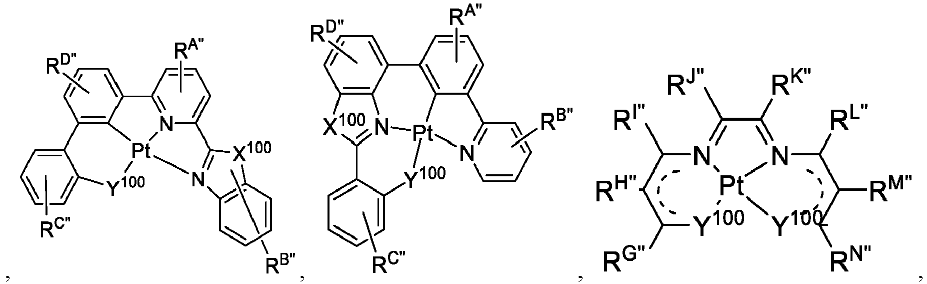 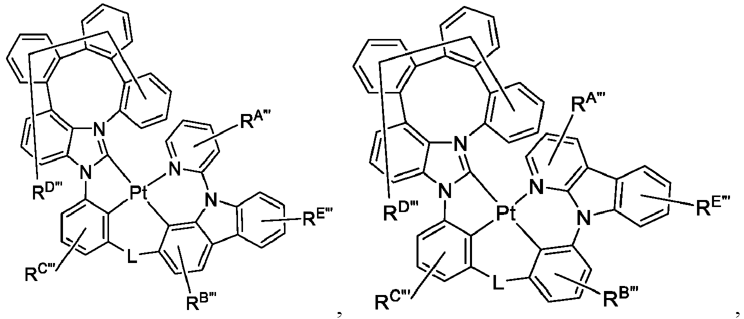 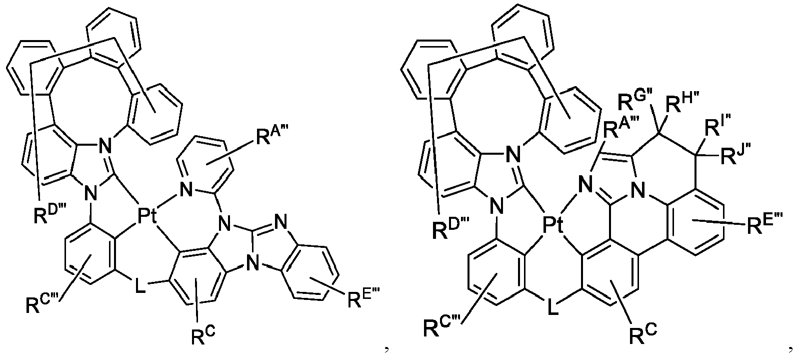 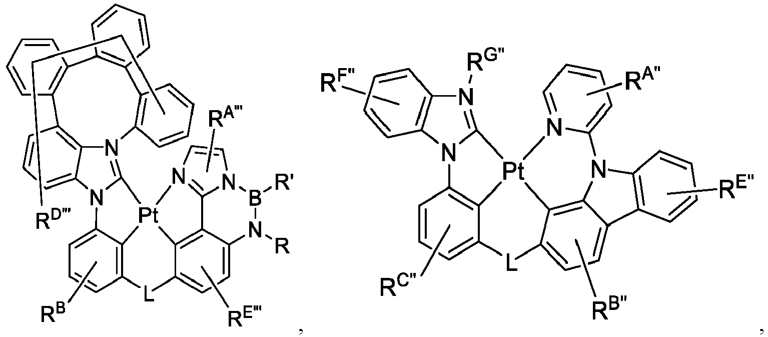 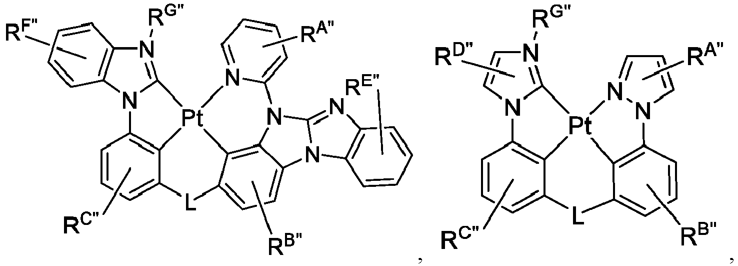 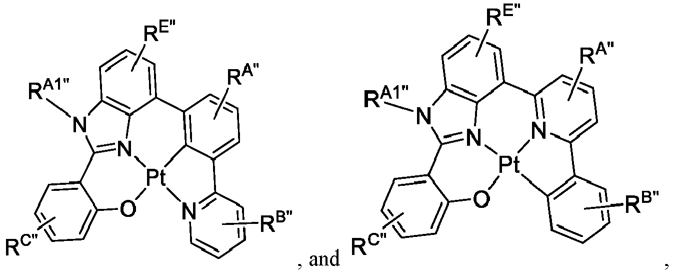 wherein: each Y¹⁰⁰ is independently selected from the group consisting of a NR", O, S, and Se; L is independently selected from the group consisting of a direct bond, BR", BR"R"', NR", PR", P(O)R", O, S, Se, C=O, C=S, C=Se, C=NR", C=CR"R"', S=O, SO₂, CR", CR"R"', SiR"R"', GeR"R"', alkyl, cycloalkyl, aryl, heteroaryl, and combinations thereof; X¹⁰⁰ for each occurrence is selected from the group consisting of O, S, Se, NR", and CR"R‴; each R^{A"}, R^{B"}, R^{C"}, R^{D"}, R^{E"}, and R^{F"} independently represents mono-, up to the maximum substitutions, or no substitutions; each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.
15. An organic light emitting device comprising: an anode; a cathode; and an organic layer disposed between the anode and the cathode, wherein the organic layer comprises a light emitting layer (EML); wherein the EML has a minimum thickness of 350 Å; wherein the EML comprises a first host; wherein the first host is a boron-containing compound.
16. An organic light emitting device (OLED) comprising: an anode; a cathode; and an organic layer disposed between the anode and the cathode, wherein the organic layer comprises a light emitting layer (EML); wherein the EML has a minimum thickness of 350 Å; wherein the EML comprises a first host and a second host; wherein the first host is an electron transporting host comprising an electron transporting moiety; wherein the second host is a hole transporting host comprising a hole transporting moiety.
17. The OLED of aspect 16, wherein the charge mobility of any of the first host or the second host is higher than 1E⁻¹³ cm²V⁻¹s⁻¹; or wherein the hole transporting moiety of the second host is selected from the group consisting of: 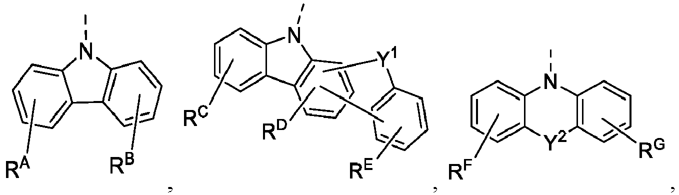 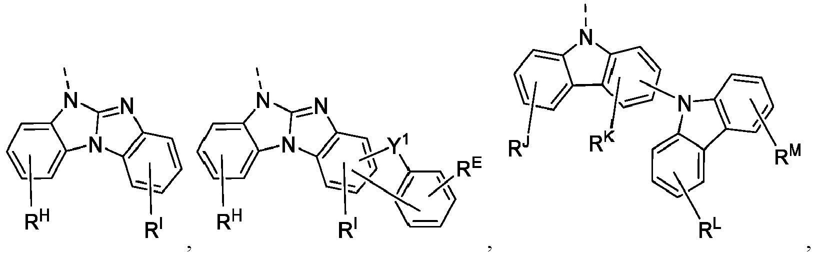 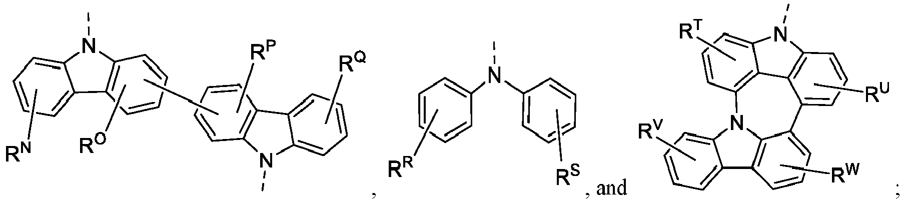 wherein: each of Y¹ and Y² is independently selected from the group consisting of BR, BRR', NR, PR, P(O)R, O, S, Se, C=O, C=S, C=Se, C=NR, C=CRR', S=O, SO₂, CRR', SiRR', and GeRR'; each of R^{A} to R^{W} is independently monosubstituted to the maximum allowable substitution, or no substitution; each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and two adjacent of R, R', or R^{A} to R^{W} are optionally joined or fused to form a ring; wherein the electron transporting moiety of the first host is selected from the group consisting of: 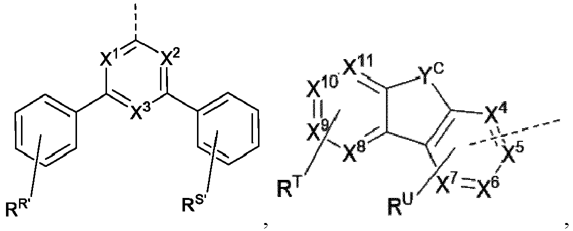 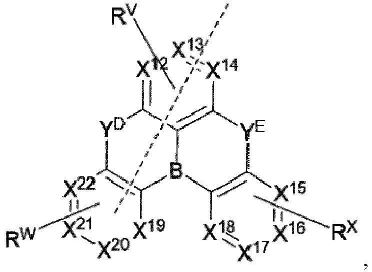 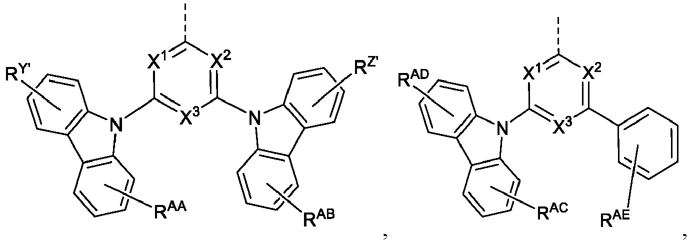 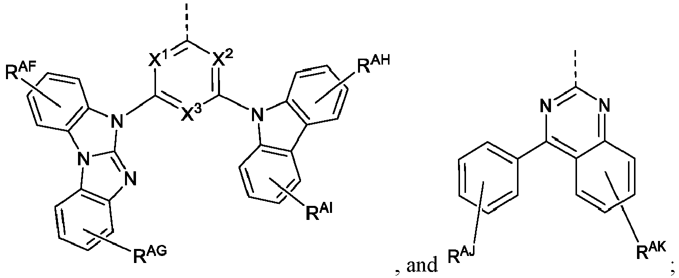 wherein: each of X¹ to X²² is independently C or N; at least one of X¹ to X³ is N; at least one of X⁴ to X¹¹ is N; each of Y^{C}, Y^{D}, and Y^{E} is independently selected from the group consisting of BR, BRR', NR, PR, P(O)R, O, S, Se, C=O, C=S, C=Se, C=NR, C=CRR', S=O, SOz, CRR', SiRR', and GeRR'; each of R^{R'} to R^{Z'} and R^{AA} to R^{AK} is independently monosubstituted to the maximum allowable substitution, or no substitution; each R, R', R^{R'} to R^{Z'}, and R^{AA} to R^{AK} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and two adjacent of R, R', R^{R'} to R^{Z'}, or R^{AA} to R^{AK} are optionally joined or fused to form a ring.
18. The OLED of aspect 16, wherein the first host is at least 30% deuterated; and/or the second host is at least 30% deuterated.
19. A consumer product comprising an organic light-emitting device according to any one of aspects 1 to 18.
20. The consumer product of aspect 19, wherein the consumer product is one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

## Claims

1. An organic light emitting device (OLED) comprising:
an anode;
a cathode; and
an organic layer disposed between the anode and the cathode, wherein the organic layer comprises a light emitting layer (EML); wherein the EML is formed from an Emissive System where the EML has a FOM value equal to or larger than 2.50.

2. The OLED of claim 1, wherein the EML comprises at least one hole transporting host, and/or at least one electron transporting host.

3. The OLED of claim 1, wherein the EML comprises a first host material, a second host material and an emitting material.

4. The OLED of claim 1, wherein the hole transporting moiety of the second host material is selected from the group consisting of: 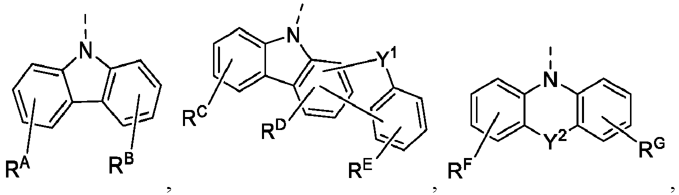 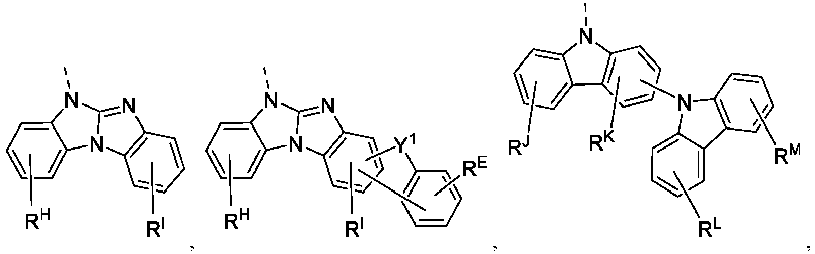 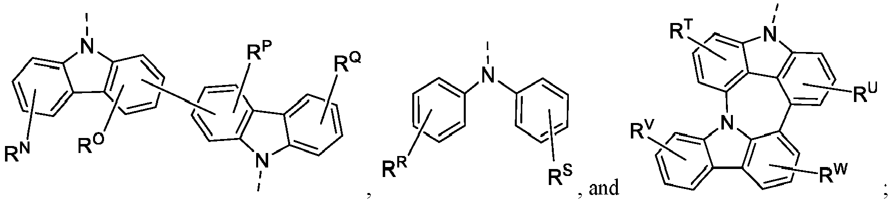 wherein:
each of Y¹ and Y² is independently selected from the group consisting of BR, BRR', NR, PR, P(O)R, O, S, Se, C=O, C=S, C=Se, C=NR, C=CRR', S=O, SO₂, CRR', SiRR', and GeRR';
each of R^{A} to R^{W} is independently monosubstituted to the maximum allowable substitution, or no substitution;
each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
two adjacent of R, R', or R^{A} to R^{W} are optionally joined or fused to form a ring.

5. The OLED of claim 1, wherein the electron transporting moiety of the first host material is selected from the group consisting of: 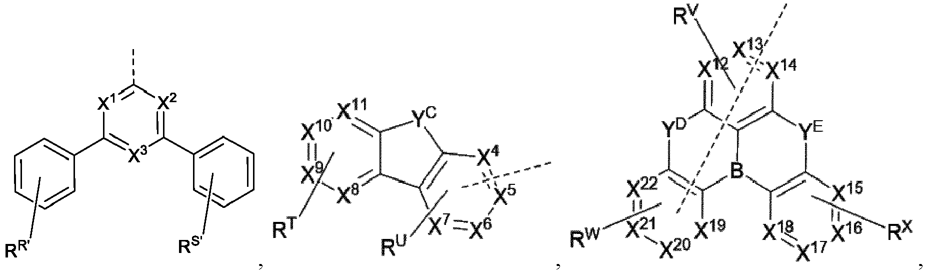 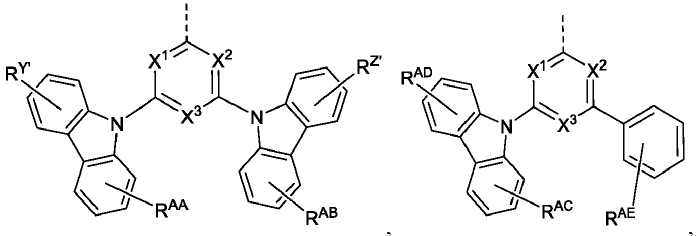 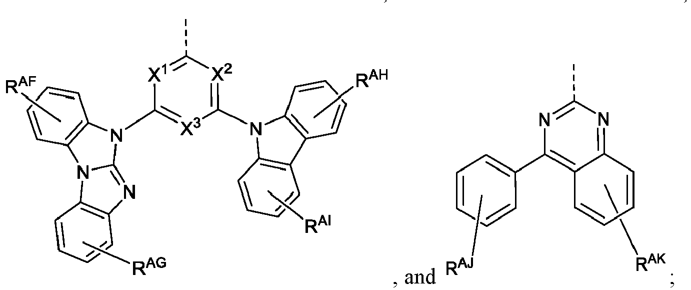 wherein:
each of X¹ to X²² is independently C or N;
at least one of X¹ to X³ is N;
at least one of X⁴ to X¹¹ is N;
each of Y^{C}, Y^{D}, and Y^{E} is independently selected from the group consisting of BR, BRR', NR, PR, P(O)R, O, S, Se, C=O, C=S, C=Se, C=NR, C=CRR', S=O, SO₂, CRR', SiRR', and GeRR';
each of R^{R'} to R^{Z'} and R^{AA} to R^{AK} is independently monosubstituted to the maximum allowable substitution, or no substitution;
each R, R', R^{R'} to R^{Z'}, and R^{AA} to R^{AK} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof;
two adjacent of R, R', R^{R'} to R^{Z'}, or R^{AA} to R^{AK} are optionally joined or fused to form a ring.

6. The OLED of claim 1, wherein the emitter material is selected from the group consisting of a phosphorescent emitter, a fluorescent emitter, a TADF emitter, and combinations thereof.

7. The OLED of claim 1, wherein the emitter material is capable of emitting light from a triplet excited state to a ground singlet state at room temperature.

8. The OLED of claim 1, wherein the emitter material is a metal coordination complex having a metal-carbon bond; and/or a metal-nitrogen bond; wherein the metal is selected from the group consisting of Ir, Rh, Re, Ru, Os, Pt, Au, and Cu.

9. The OLED of claim 1, wherein the emitter material has a formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein M is a metal and x+y+z is the oxidation state of the metal M;
wherein L¹ is selected from the group consisting of: 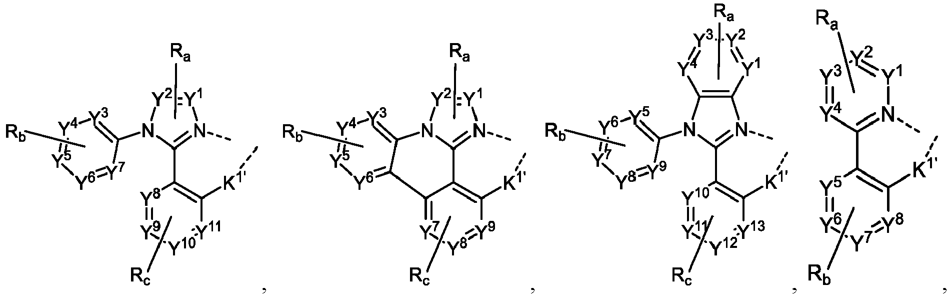 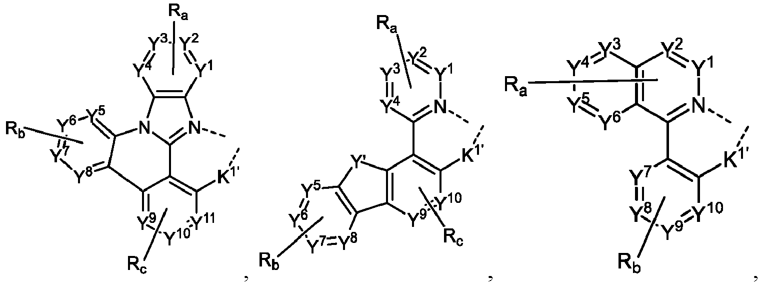 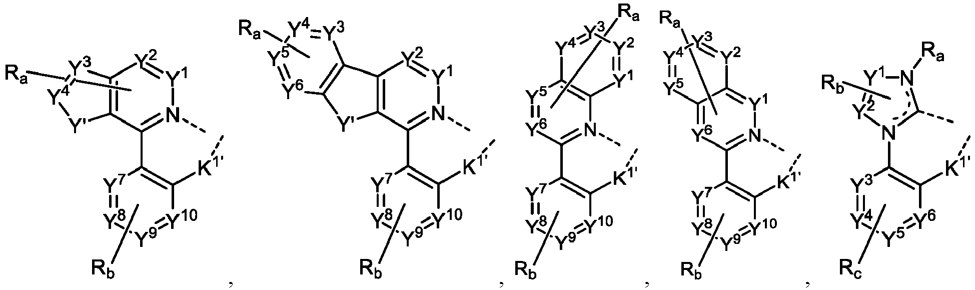 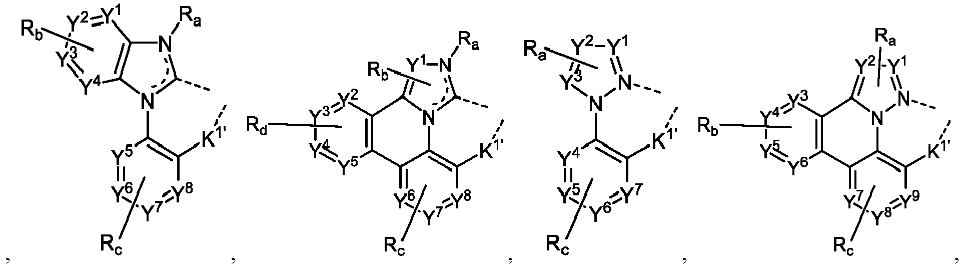 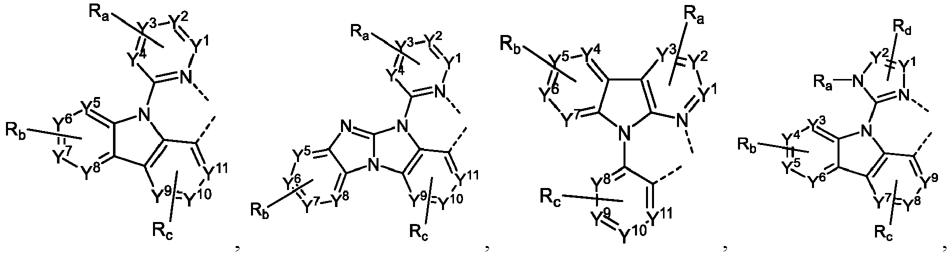 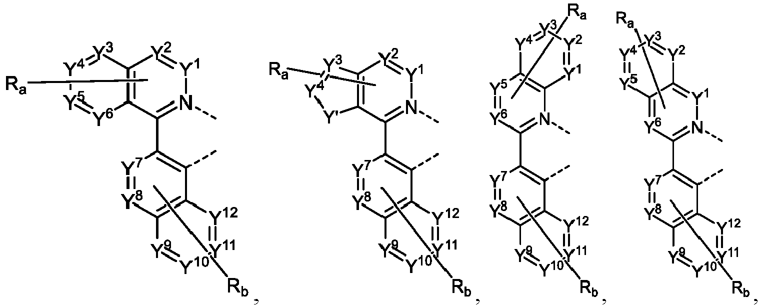 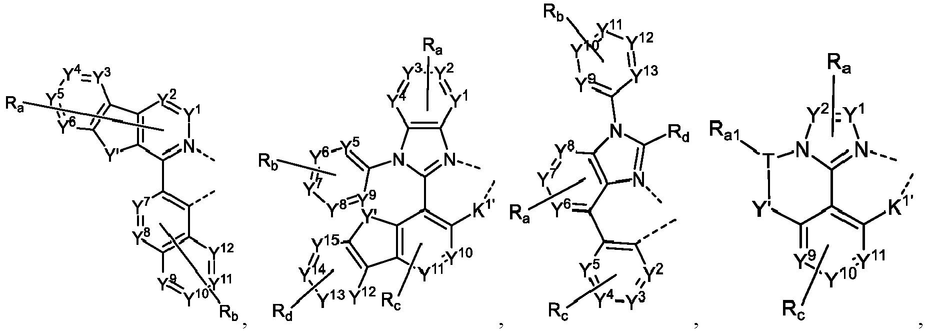 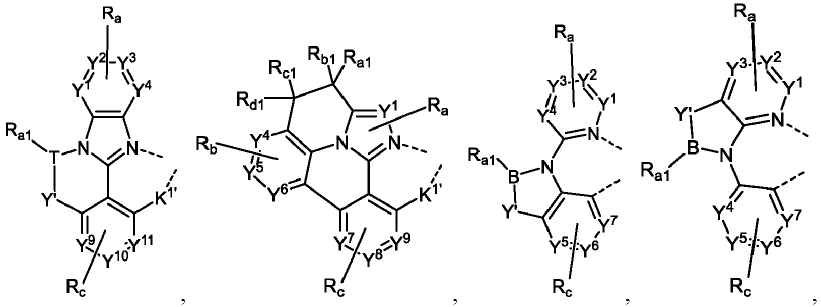 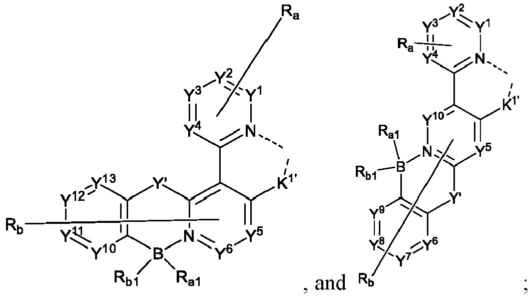
wherein L² and L³ are independently selected from the group consisting of 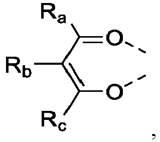 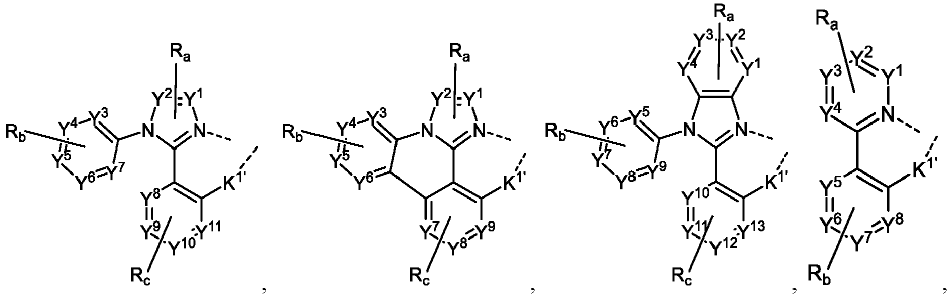 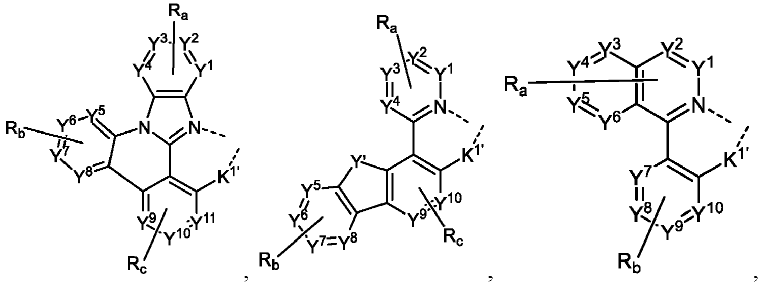 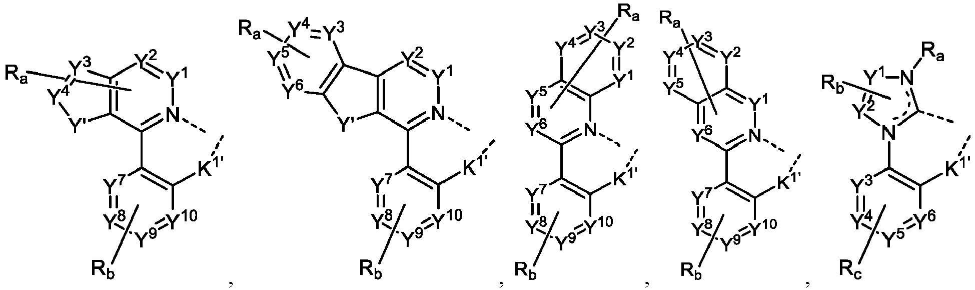 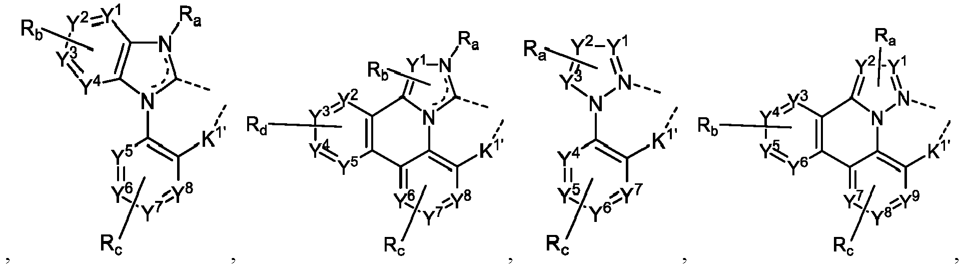 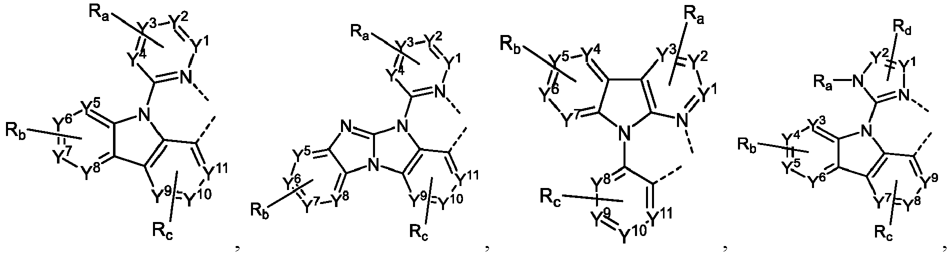 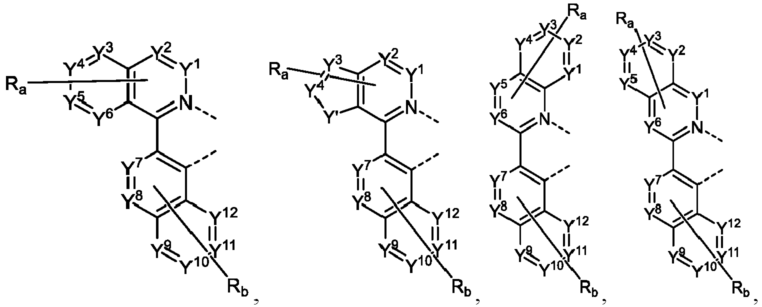 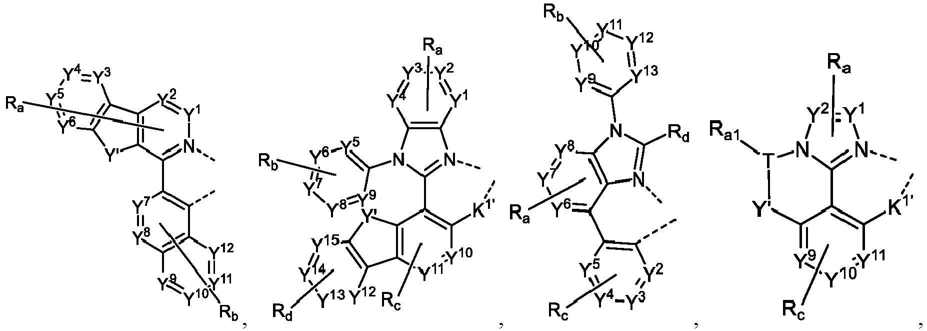 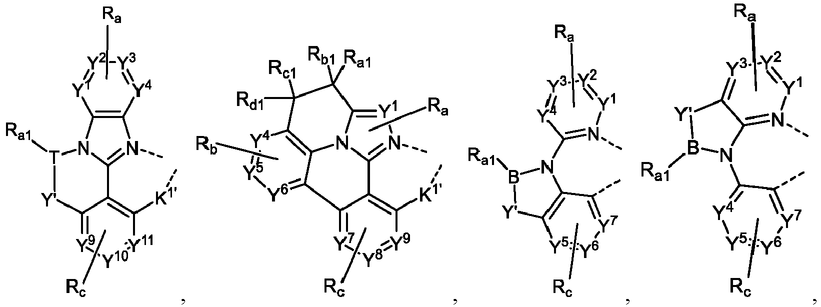 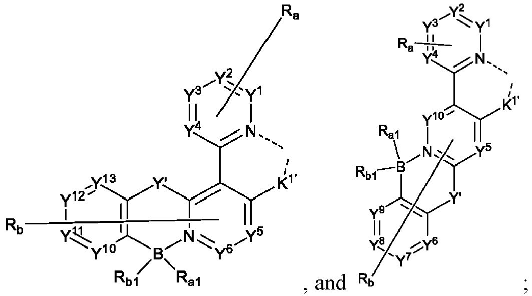
wherein T is selected from the group consisting of B, Al, Ga, and In;
wherein K^{1'} is a direct bond or is selected from the group consisting of NRₑ, PRₑ, O, S, and Se;
wherein each Y¹ to Y¹³ are independently selected from the group consisting of carbon and nitrogen;
wherein Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SOz, CRₑR_{f}, SiRₑR_{f}, and GeRₑR_{f};
wherein Rₑ and R_{f} can be fused or joined to form a ring;
wherein each Rₐ, R_{b}, R_{c}, and R_{d} can independently represent from mono to the maximum possible number of substitutions, or no substitution;
wherein each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and
wherein any two Rₐ₁, R_{b1}, R_{c1}, R_{d1}, Rₐ, R_{b}, R_{c}, and R_{d} can be fused or joined to form a ring or form a multidentate ligand.

10. The OLED of claim 1, wherein the emitter material has a formula selected from the group consisting of: 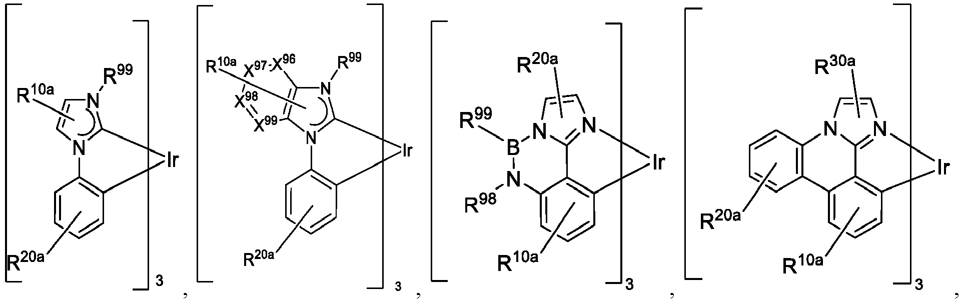 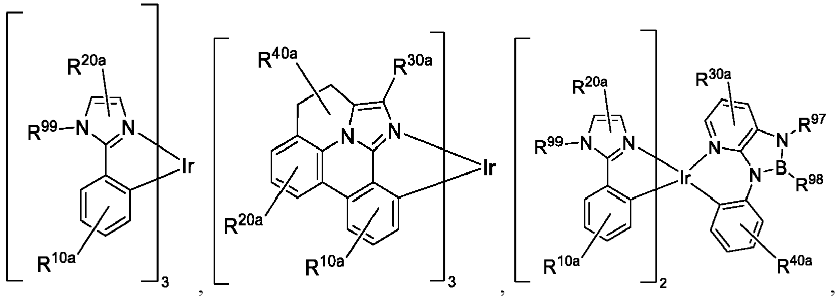 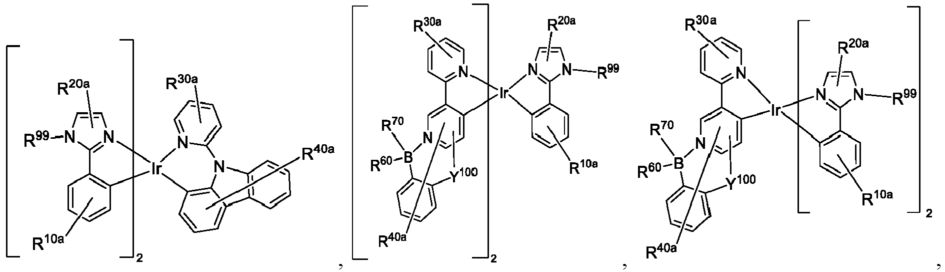 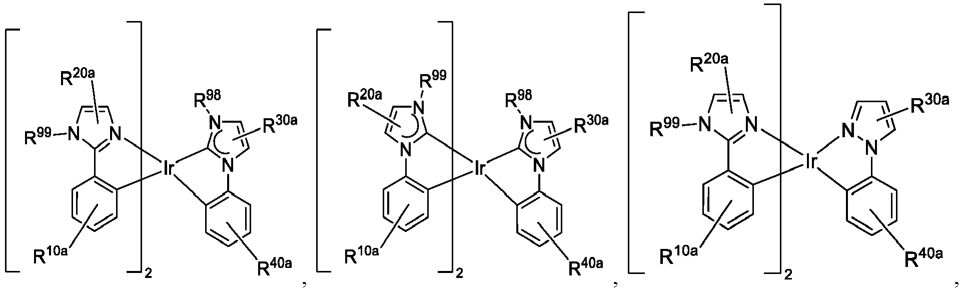 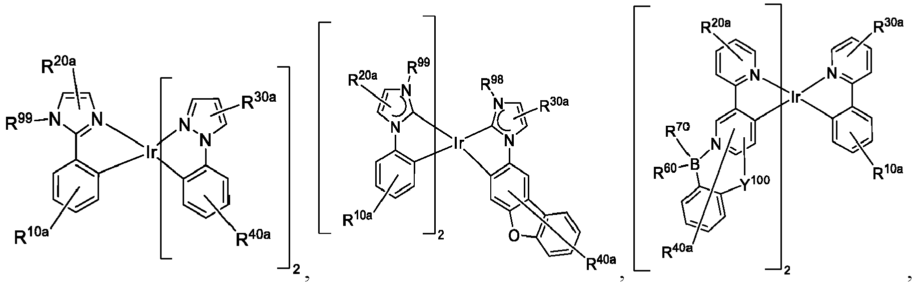 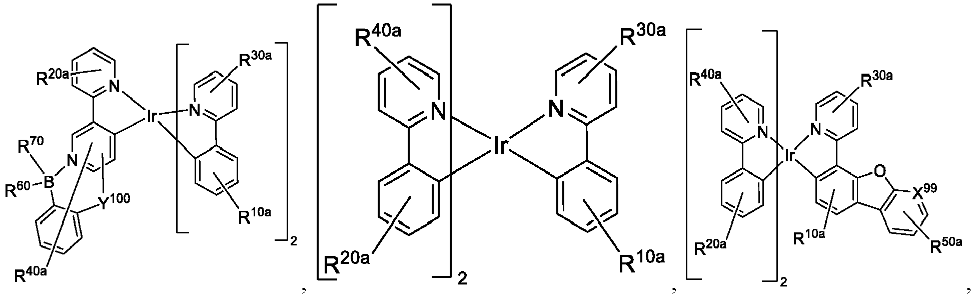 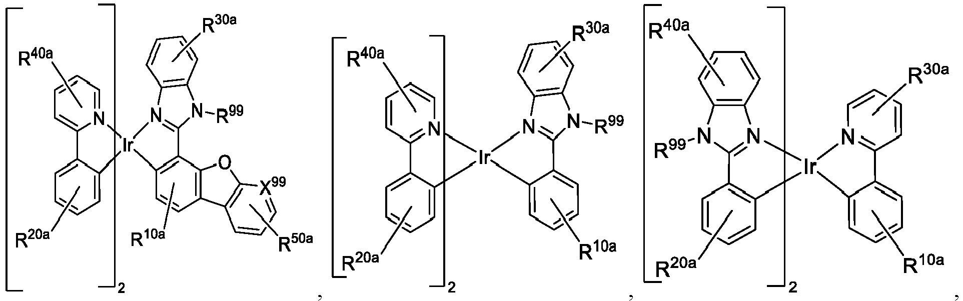 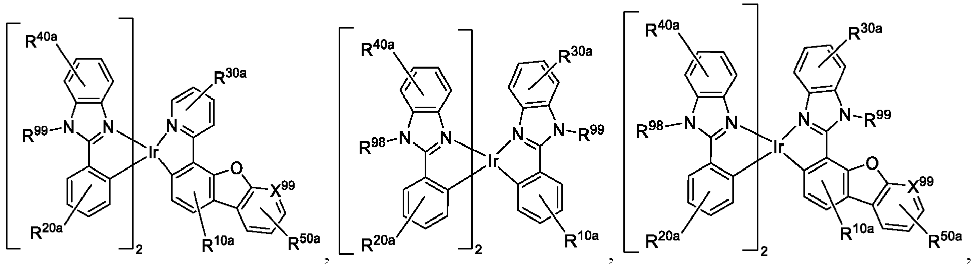 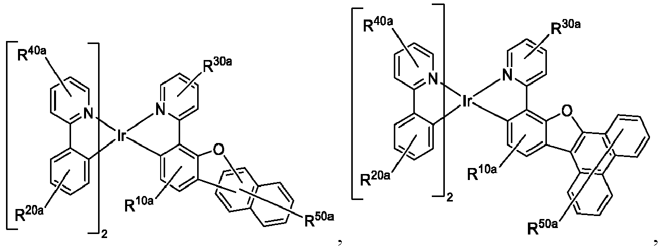 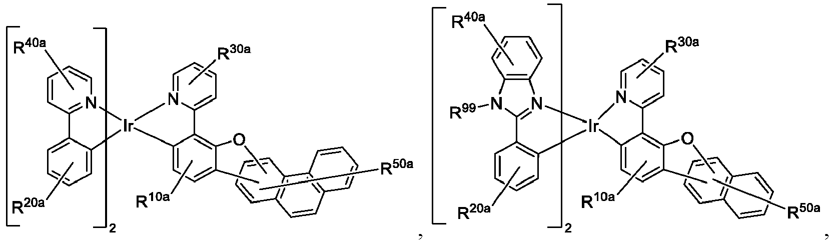 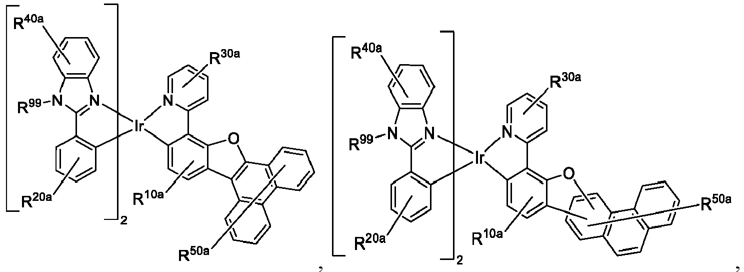 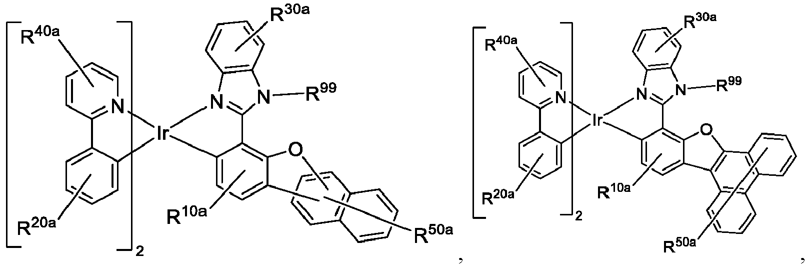 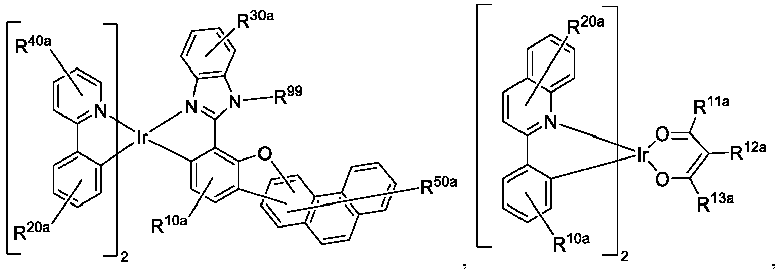 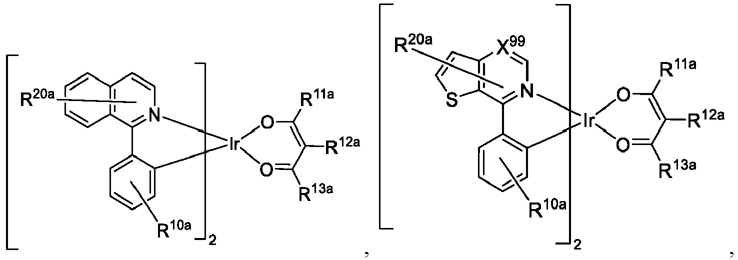 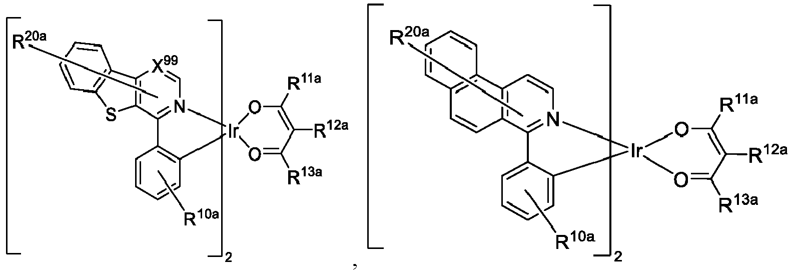 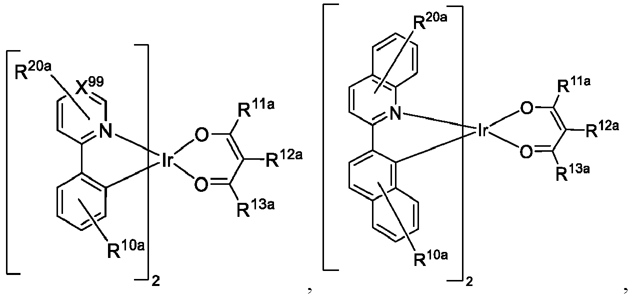 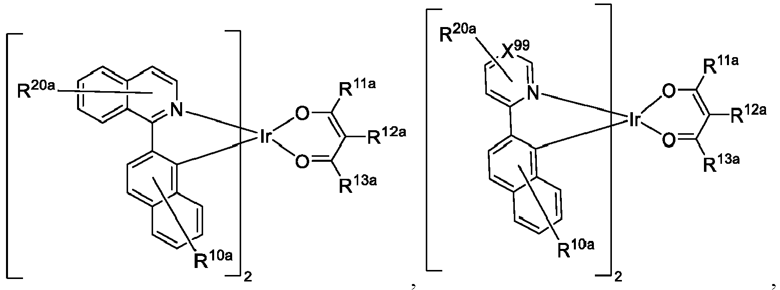 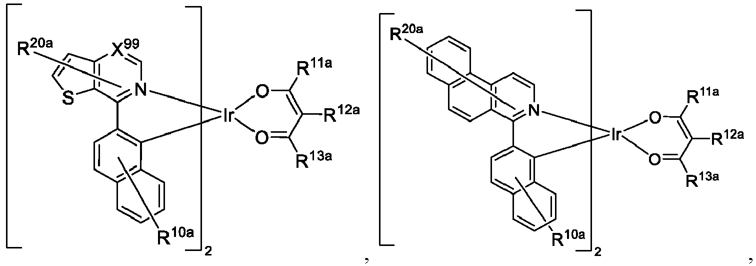 and 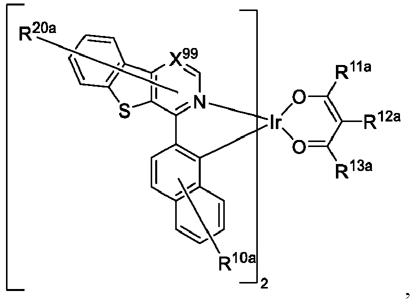 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of deuterium, halide, alkyl, cycloalkyl, heteroalkyl, arylalkyl, alkoxy, aryloxy, amino, silyl, gennyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof.

11. The OLED of claim 1, wherein the emitting material has a formula selected from the group consisting of: 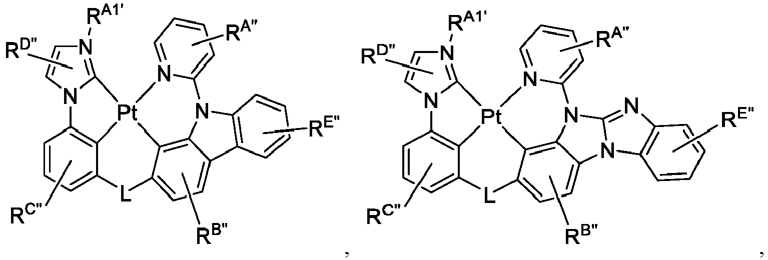 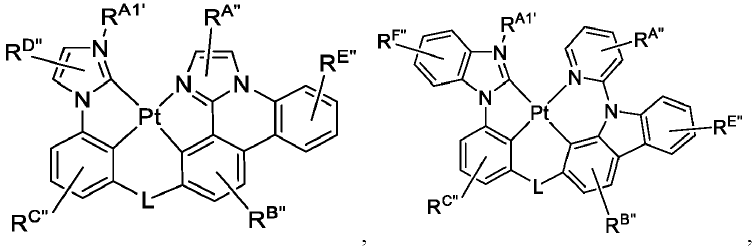 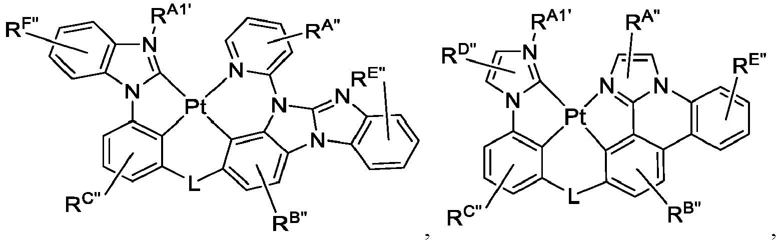 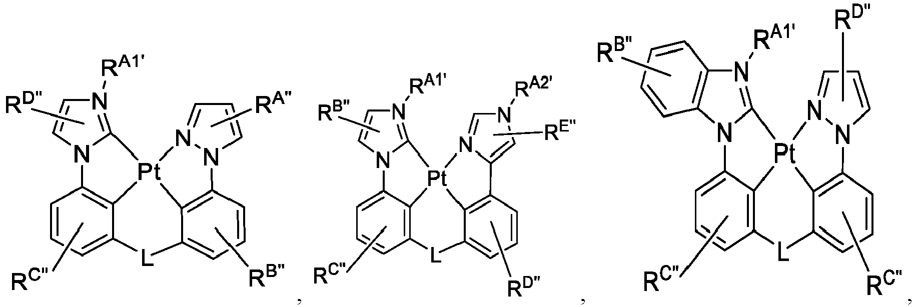 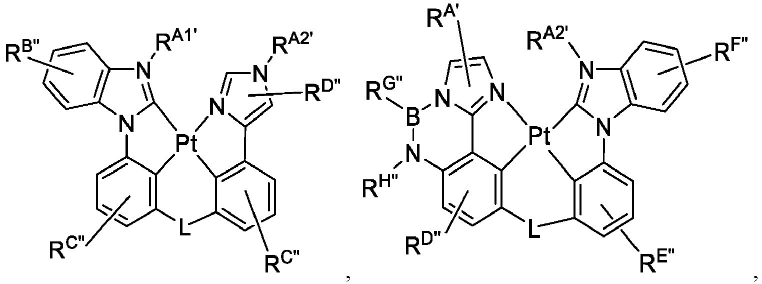 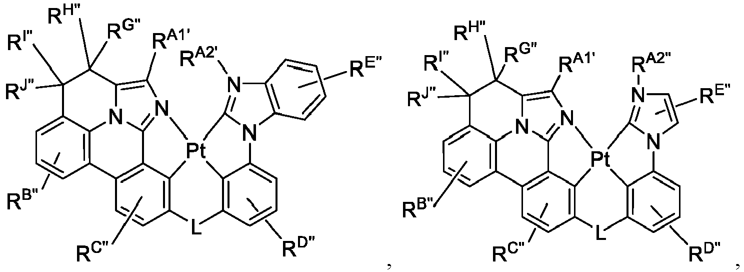 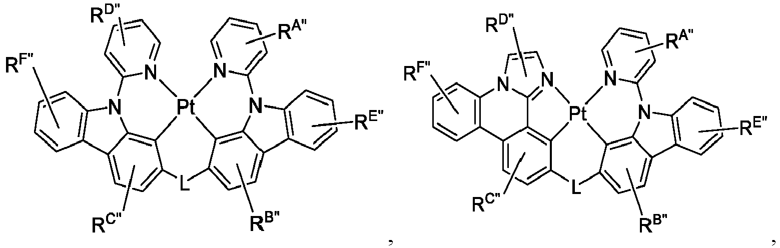 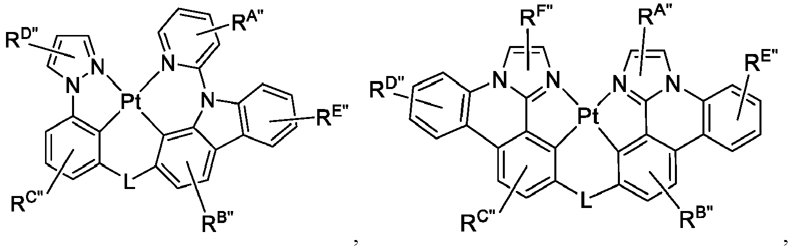 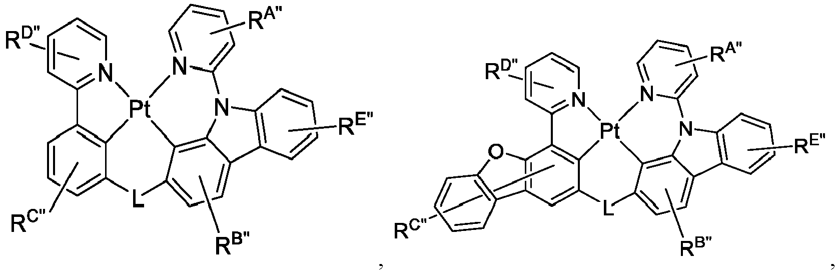 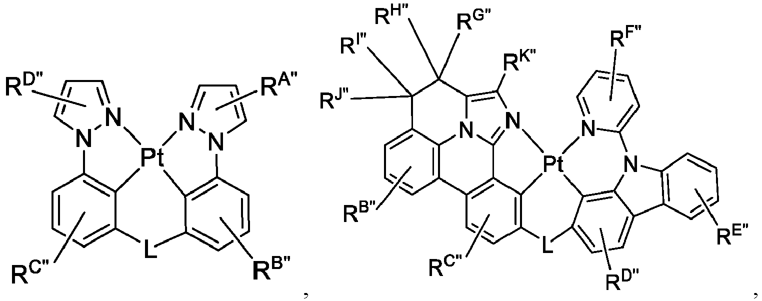 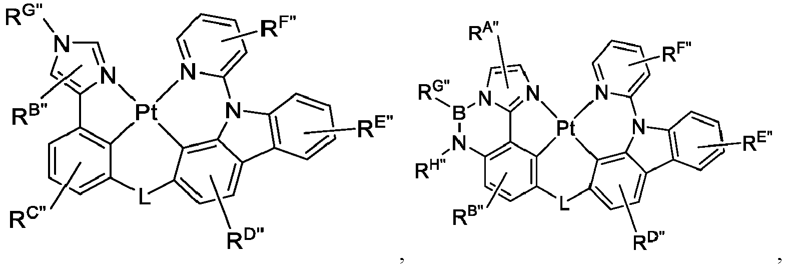 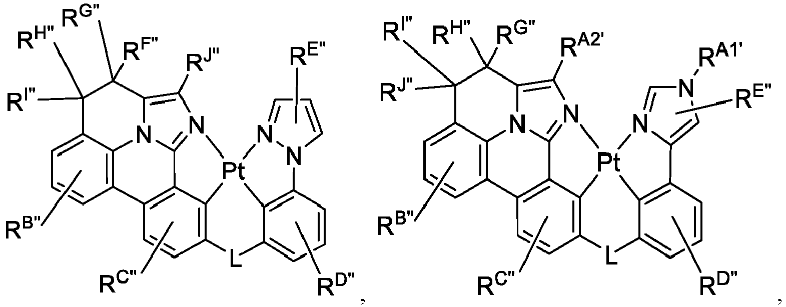 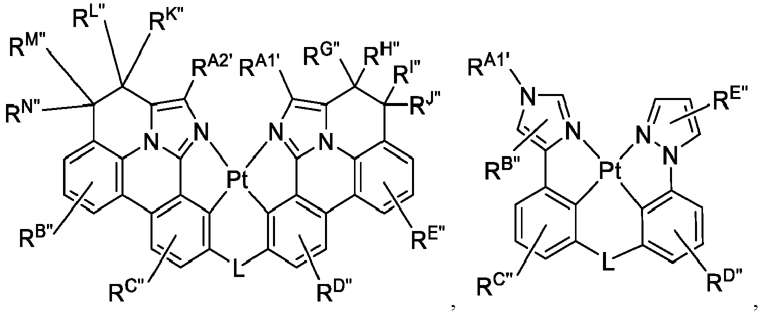 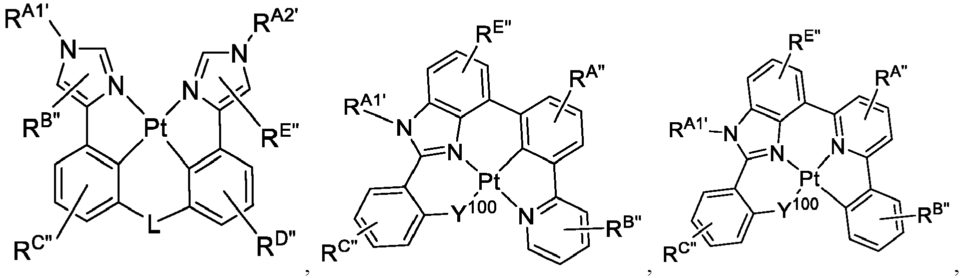 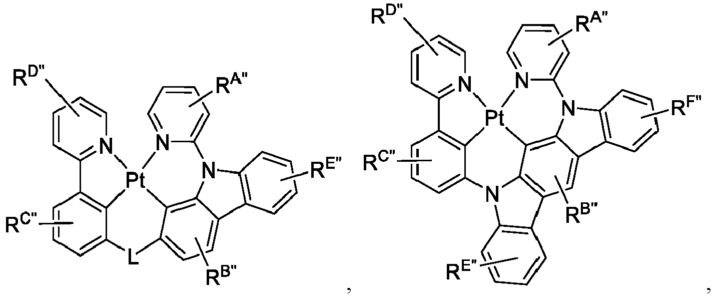 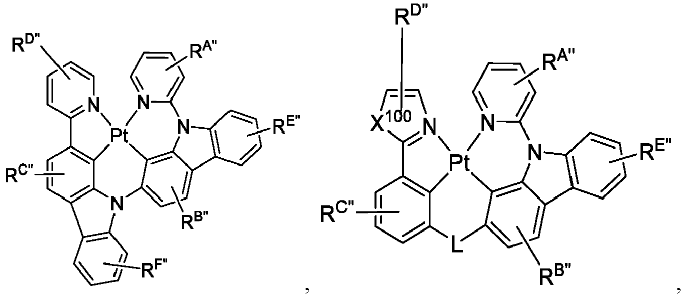 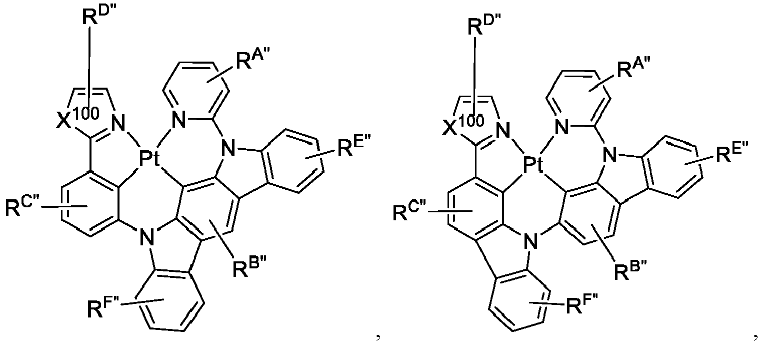 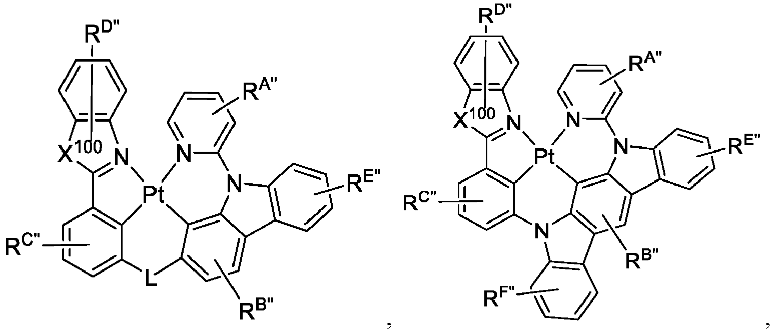 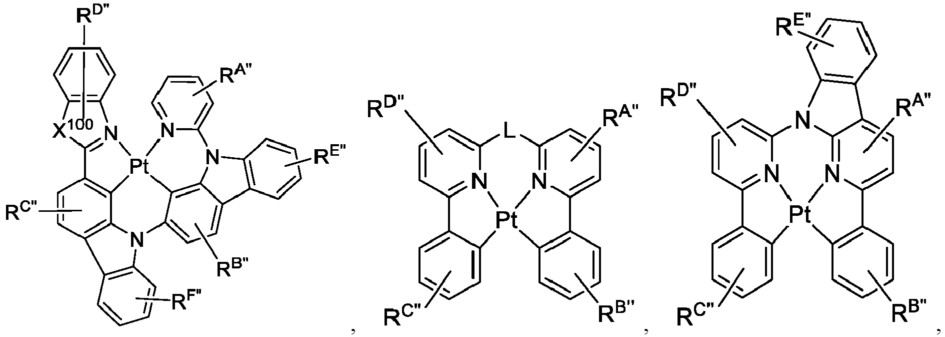 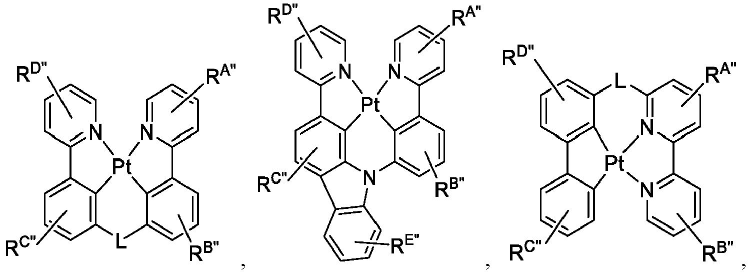 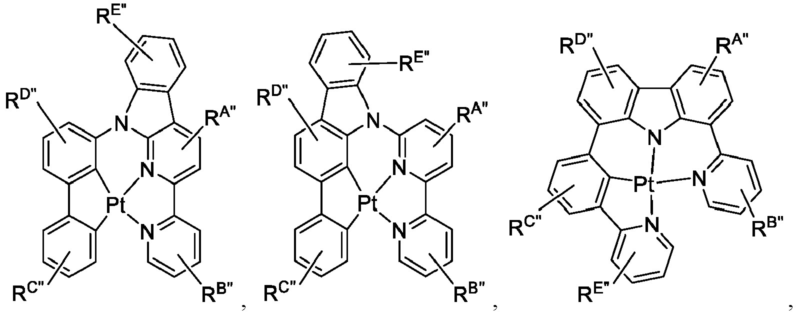 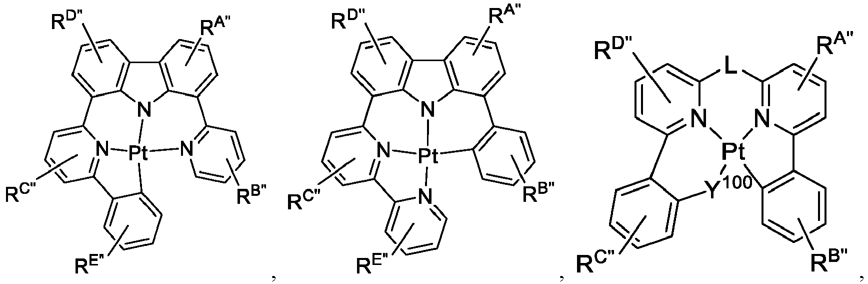 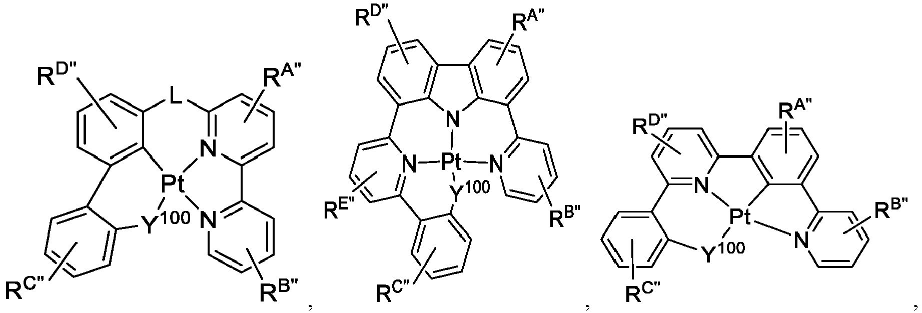 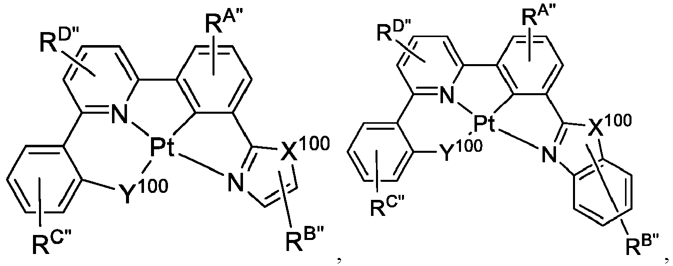 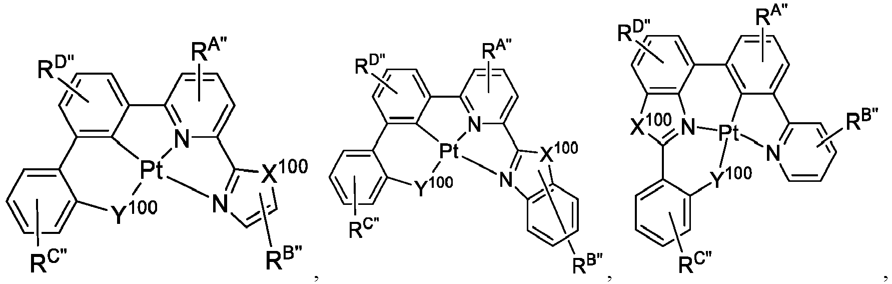 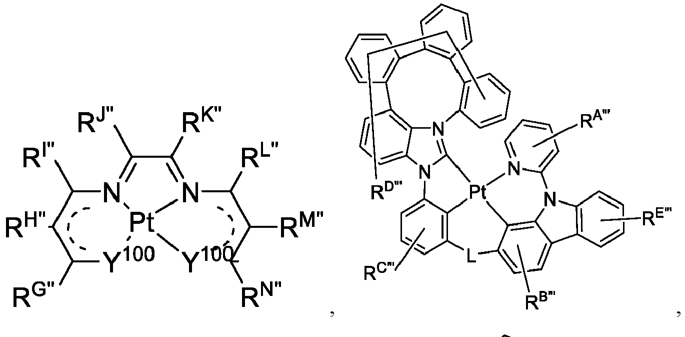 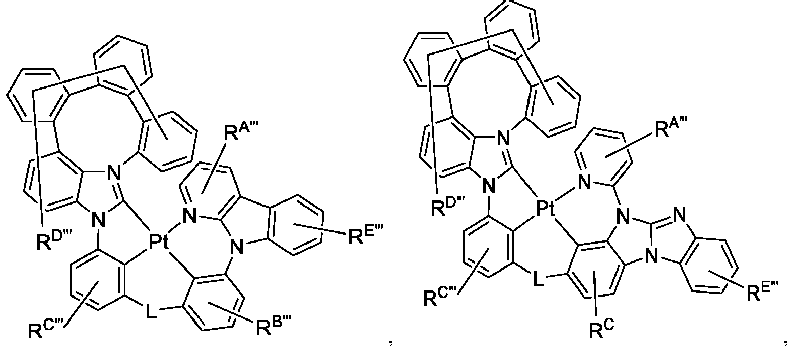 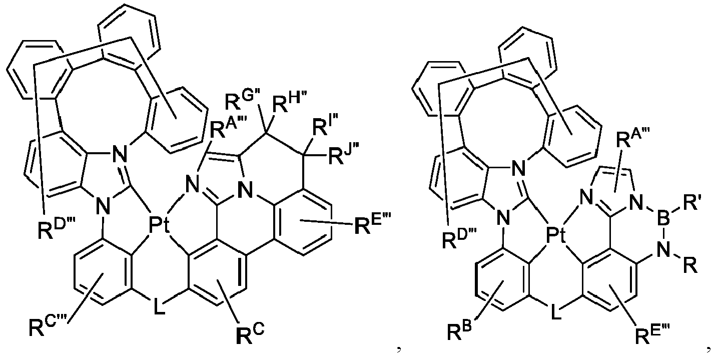 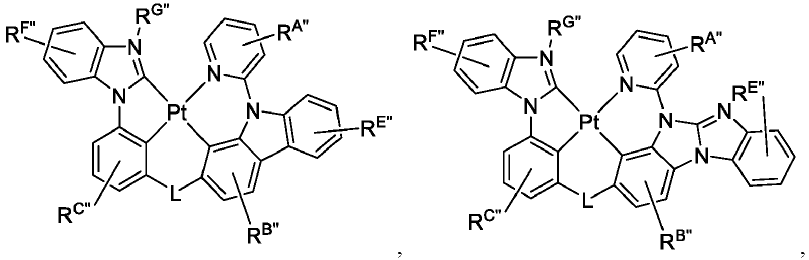 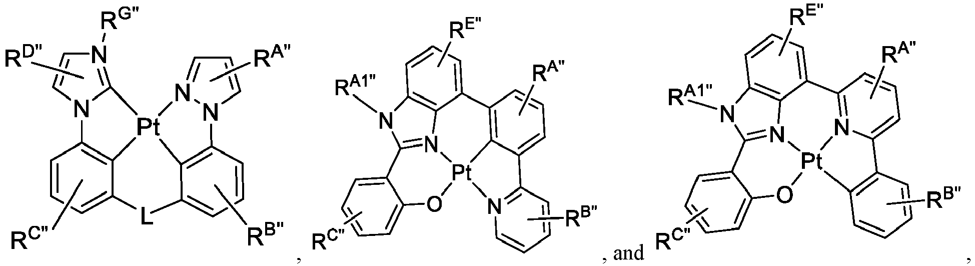 wherein:
each Y¹⁰⁰ is independently selected from the group consisting of a NR", O, S, and Se;
L is independently selected from the group consisting of a direct bond, BR", BR"R"', NR", PR", P(O)R", O, S, Se, C=O, C=S, C=Se, C=NR", C=CR"R"', S=O, SOz, CR", CR"R"', SiR"R"', GeR"R"', alkyl, cycloalkyl, aryl, heteroaryl, and combinations thereof;
X¹⁰⁰ for each occurrence is selected from the group consisting of O, S, Se, NR", and CR"R‴;
each R^{A"}, R^{B"}, R^{C}", R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.

12. An organic light emitting device comprising:
an anode;
a cathode; and
an organic layer disposed between the anode and the cathode, wherein the organic layer comprises a light emitting layer (EML);
wherein the EML has a minimum thickness of 350 Å;
wherein the EML comprises a first host;
wherein the first host is a boron-containing compound.

13. An organic light emitting device (OLED) comprising:
an anode;
a cathode; and
an organic layer disposed between the anode and the cathode, wherein the organic layer comprises a light emitting layer (EML);
wherein the EML has a minimum thickness of 350 Å;
wherein the EML comprises a first host and a second host;
wherein the first host is an electron transporting host comprising an electron transporting moiety, the second host is a hole transporting host comprising an hole transporting moiety.

14. The OLED of claim 13, wherein the charge mobility of any of the first host or the second host is higher than 1E⁻¹³ cm²V⁻¹s⁻¹; or
wherein the hole transporting moiety of the second host is selected from the group consisting of: 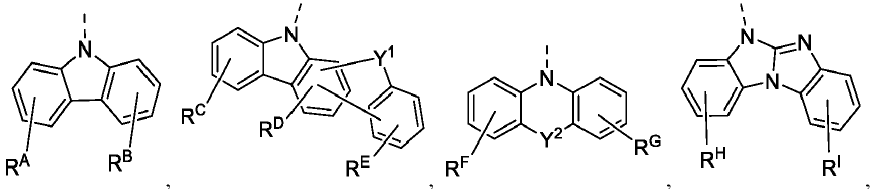 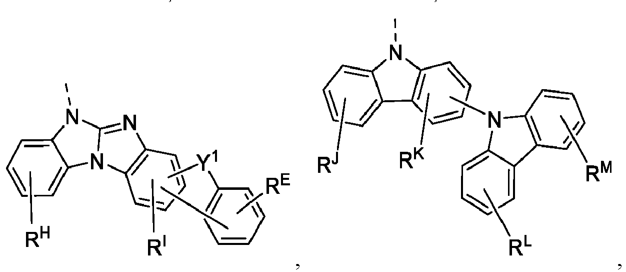 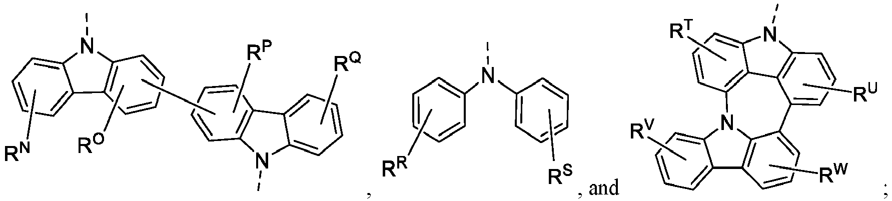 wherein:
each of Y¹ and Y² is independently selected from the group consisting of BR, BRR', NR, PR, P(O)R, O, S, Se, C=O, C=S, C=Se, C=NR, C=CRR', S=O, SOz, CRR', SiRR', and GeRR';
each of R^{A} to R^{W} is independently monosubstituted to the maximum allowable substitution, or no substitution;
each R, R', and R^{A} to R^{W} is independently hydrogen or a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
two adjacent of R, R', or R^{A} to R^{W} are optionally joined or fused to form a ring;
wherein the electron transporting moiety of the first host is selected from the group consisting of: 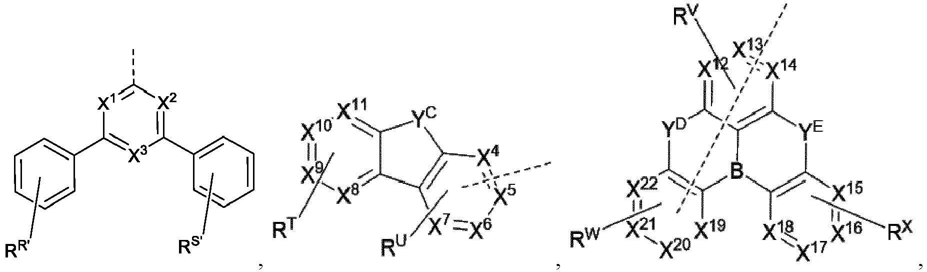 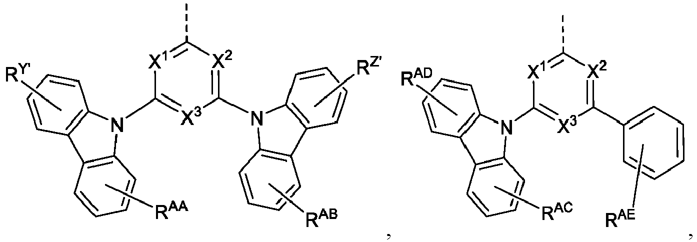 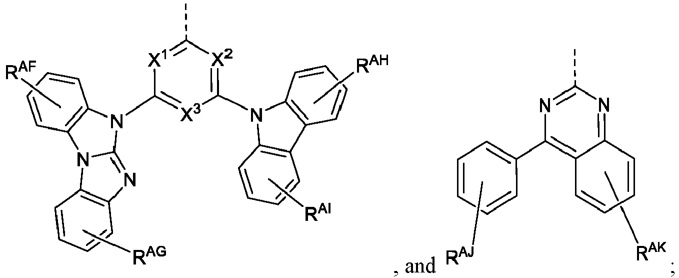 wherein:
each of X¹ to X²² is independently C or N;
at least one of X¹ to X³ is N;
at least one of X⁴ to X¹¹ is N;
each of Y^{C}, Y^{D}, and Y^{E} is independently selected from the group consisting of BR, BRR', NR, PR, P(O)R, O, S, Se, C=O, C=S, C=Se, C=NR, C=CRR', S=O, SOz, CRR', SiRR', and GeRR';
each of R^{R'} to R^{Z'} and R^{AA} to R^{AK} is independently monosubstituted to the maximum allowable substitution, or no substitution;
each R, R', R^{R'} to R^{Z'}, and R^{AA} to R^{AK} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, germyl, selenyl, and combinations thereof; and
two adjacent of R, R', R^{R'} to R^{Z'}, or R^{AA} to R^{AK} are optionally joined or fused to form a ring.

15. A consumer product comprising an organic light-emitting device according to any one of the previous claims.
